# EUROPEAN PATENT SPECIFICATION

(11) **EP 2 484 522 B1**
(45) Date of publication and mention of the grant of the patent: **20.08.2014**
(21) Application number: 12153616.3
(22) Date of filing: 02.02.2012
(51) Int. Cl.: B41C 1/10, G03F 7/11

(54) **Lithographic printing plate precursor and plate making method thereof**
Lithographiedruckplattenvorläufer und Plattenherstellungsverfahren dafür
Précurseur de plaque d'impression lithographique et procédé de fabrication de plaque correspondant

(30) Priority: 04.02.2011 JP 2011023413
(43) Date of publication of application: 08.08.2012
(73) Proprietor: FUJIFILM Corporation, Tokyo (JP)
(72) Inventor: Koyama, Ichiro, Shizuoka (JP); Oohashi, Hidekazu, Shizuoka (JP)
(74) Representative: HOFFMANN EITLE

(56) References cited:
- JP-A- 2007 249 036
- US-A- 3 690 880

## Description

### FIELD OF THE INVENTION

The present invention relates to a lithographic printing plate precursor and a plate making method using the same. More particularly, it relates to a lithographic printing plate precursor capable of undergoing a direct plate making by image exposure with laser and a plate making method comprising exposing and developing the lithographic printing plate precursor.

### BACKGROUND OF THE INVENTION

In general, a lithographic printing plate has a surface composed of an oleophilic image area and a hydrophilic non-image area. Lithographic printing is a printing method comprising supplying alternately dampening water and oily ink on the surface of lithographic printing plate, making the hydrophilic non-image area a dampening water-receptive area (ink unreceptive area) and depositing the oily ink only on the oleophilic image area by utilizing the nature of water and oil to repel with each other, and then transferring the ink to a printing material, for example, paper.

In order to produce the lithographic printing plate, a lithographic printing plate precursor (PS plate) comprising a hydrophilic support having provided thereon an oleophilic image-forming layer (image-recording layer) has heretofore been broadly used. Ordinarily, a lithographic printing plate is obtained by conducting plate making by a method of exposing the lithographic printing plate precursor through an original, for example, a lith film, and then treating the exposed lithographic printing plate precursor to remove the image-recording layer in the unnecessary non-image area by dissolving with a an alkaline developer or an organic solvent thereby revealing a surface of the hydrophilic support to form the non-image area while leaving the image-recording layer in the image area.

In the hitherto known plate making process of lithographic printing plate precursor, after the exposure, the step of removing the unnecessary image-recording layer by dissolving, for example, with a developer is required. However, it is one of the subjects to simplify such an additional wet treatment as described above. As one means for the simplification, it has been desired to conduct the development with a nearly neutral aqueous solution or simply with water.

On the other hand, digitalized technique of electronically processing, accumulating and outputting image information using a computer has been popularized in recent years, and various new image outputting systems responding to the digitalized technique have been put into practical use.

Correspondingly, attention has been drawn to a computer-to-plate technique of carrying the digitalized image information on highly converging radiation, for example, laser light and conducting scanning exposure of a lithographic printing plate precursor with the light thereby directly preparing a lithographic printing plate without using a lith film. Thus, it is one of the important technical subjects to obtain a lithographic printing plate precursor adaptable to the technique described above.

Based on the background described above, adaptation of plate making operation to both simplification and digitalization has been demanded strongly more and more than ever before.

However, since the development processing ordinarily comprises three steps of developing with an aqueous alkali solution having pH of 10 or more, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain. Therefore, the decrease in alkali concentration of developer and the simplification of processing step have been further strongly required from both aspects of the consideration for global environment and the adaptation for space saving and low running cost.

For instance, a developing method with an alkali solution having pH from 10 to 12.5 and containing a nonionic surfactant is proposed in JP-A-2002-91016 (the term "JP-A" as used herein means an "unexamined published Japanese patent applicalion"). However, since the photosensitive composition contains an alkali-soluble polymer, there is a problem in that the development can not be conducted with a developer having pH lower than the value defmed.

A method of preparing a lithographic printing plate comprising exposing with laser of 350 to 450 nm a lithographic printing plate precursor having an image-forming layer containing (A) a sensitizing dye having an absorption maximum at a wavelength range from 350 to 450 nm, (B) a hexaarylbiimidazole compound, (C) a polymerizable compound, (D) a hydrophobic binder polymer and (E) a chain transfer agent and a protective layer in this order and then removing the protective layer and the unexposed area of the image-forming layer by rubbing the surface of the lithographic printing plate precursor with a rubbing member in an automatic processor equipped with the rubbing member in the presence of a developer having pH from 2 to 10 is described in JP-A-2007-58170.

A plate making method of a lithographic printing plate comprising exposing imagewise a lithographic printing plate precursor having a photopolymerizable layer on support having a hydrophilic surface or having a hydrophilic layer provided thereon by a plate setter and then treating with a gum solution an image-forming layer of the lithographic printing plate precursor in a gumming unit of an automatic developing machine to remove the unexposed area of the image-forming layer is described in WO 2005/111727.

A lithographic printing plate precursor using a star polymer is described in JP-A-2004-317543. There is described that development property and printing durability are improved by using the star polymer.

In order to improve on-press development property of a lithographic printing plate precursor capable of undergoing on-press development and printing durability, use of a star polymer in an image-recording layer is described in JP-A-2007-249036. Although the lithographic printing plate precursor exhibits high on-press development property and printing durability, there is no description with respect to a lithographic printing plate precursor of an alkali development type.

A lithographic printing plate precursor containing a polymer having a repeating unit containing an ethylenically unsaturated bond and a repeating unit containing a functional group capable of interacting a surface of support is described in JP-A-2005-125749. However, the technique is insufficient in stain resistance and development property.

US 3690880 discloses photolithographic printing plate precursor comprising a support, an intermediate layer and an image-recording layer, wherein the intermediate layer contains a highly branched polyalkylenimine-urea-aldehyde polymer having no star shape. The highly branched polymer in the intermediate layer increases the durability of the exposed and developed printing plate.

### SUMMARY OF THE INVENTION

An object of the present invention is to provide a negative lithographic printing plate precursor which provides high printing durability and stain resistance and exhibits excellent development property and a plate making method of the negative lithographic printing plate precursor.

As a result of the intensive investigations for achieving the object described above, the inventors have found that a lithographic printing plate precursor excellent in all of printing durability, stain resistance and development property can be obtained by using a star polymer in an undercoat layer to complete the invention.

The present invention includes the following items.
(1) A negative lithographic printing plate precursor comprising a support and an image-recording layer, wherein a layer containing a star polymer is provided between the support and the image-recording layer.
(2) The negative lithographic printing plate precursor as described in (1) above, wherein the layer containing a star polymer is an undercoat layer.
(3) The negative lithographic printing plate precursor as described in (1) above, wherein the layer containing a star polymer is a layer formed by hydrophilizing treatment of a surface of the support.
(4) The negative lithographic printing plate precursor as described in any one of (1) to (3) above, wherein the image-recording layer is a layer containing a polymerization initiator and a polymerizable compound.
(5) The negative lithographic printing plate precursor as described in any one of (1) to (4) above, wherein the star polymer is a polymer in which from 3 to 10 polymer chains are branched from a central skeleton.
(6) The negative lithographic printing plate precursor as described in (5) above, wherein the star polymer is a polymer in which from 3 to 10 polymer chains are branched from a central skeleton via sulfide bonds respectively.
(7) The negative lithographic printing plate precursor as described in (6) above, wherein the star polymer is a polymer in which from 3 to 10 polymer chains are branched from a central skeleton via sulfide bonds respectively and which is obtained by polymerization of an ethylenically unsaturated monomer in the presence of a multifunctional thiol.
(8) The negative lithographic printing plate precursor as described in any one of (1) to (7) above, wherein the star polymer has a hydrophilic group in the polymer chain thereof.
(9) The negative lithographic printing plate precursor as described in any one of (1) to (8) above, wherein the star polymer has a group adsorbing to a surface of the support in the polymer chain thereof
(10) The negative lithographic printing plate precursor as described in (8) or (9) above, wherein the star polymer has a crosslinkable group in the polymer chain thereof.
(11) The negative lithographic printing plate precursor as described in any one of (1) to (10) above, wherein a protective layer is provided on the image-recording layer.
(12) The negative lithographic printing plate precursor as described in any one of (1) to (11) above, which is capable of printing, after image exposure with laser, by supplying at least any of printing ink and dampening water on a printing machine to remove an unexposed area of the image-recording layer.
(13) The negative lithographic printing plate precursor as described in any one of (1) to (11) above, which is capable of removing, after image exposure with laser, an unexposed area of the image-recording layer with a developer having pH from 2 to 14.
(14) The negative lithographic printing plate precursor as described in (11) above, which is capable of removing, after image exposure with laser, the protective layer and an unexposed area of the image-recording layer with one bath of a developer having pH from 2 to 14.
(15) A plate making method of a negative lithographic printing plate precursor comprising exposing imagewise the negative lithographic printing plate precursor as described in (12) above with laser, and then supplying at least any of printing ink and dampening water to the exposed negative lithographic printing plate precursor on a printing machine to remove an unexposed area of the image-recording layer.
(16) A plate making method of a negative lithographic printing plate precursor comprising exposing imagewise the negative lithographic printing plate precursor as described in (13) above with laser, and then removing an unexposed area of the image-recording layer with a developer having pH from 2 to 14.
(17) A plate making method of a negative lithographic printing plate precursor comprising exposing imagewise the negative lithographic printing plate precursor as described in (14) above with laser, and then removing the protective layer and an unexposed area of the image-recording layer with one bath of a developer having pH from 2 to 14.

According to the invention, the object described above can be achieved by using a star polymer in an undercoat layer. The functional mechanism of the invention is not quite clear but it is estimated as follows. It is believed that due to the star shape of polymer, adsorption power to the support and adhesion power to the image-recording layer are increased to improve the printing durability. It is also believed that since the support can be covered by not a line but a plane, hydrophilicity is increased so that the stain resistance after development is improved. It is further believed that permeation of developer into the whole lithographic printing plate precursor is accelerated so that the development property is improved.

According to the present invention, a negative lithographic printing plate precursor which provides high printing durability and stain resistance and exhibits excellent development property and a plate making method of the negative lithographic printing plate precursor can be provided.

### BRIEF DESCRIPTION OF THE DRAWINGS

Fig. 1 is a view schematically showing a star polymer according to the invention.
Fig. 2 is a view explaining a structure of an automatic development processor (A).
Fig. 3 is a view explaining a structure of an automatic development processor (B).

### [Description of reference numerals and signs]

- 61:: Rotating brush roller
- 62:: Backing roller
- 63:: Transport roller
- 64:: Transport guide plate
- 65:: Spray pipe
- 66:: Pipe line
- 67:: Filter
- 68:: Plate supply table
- 69:: Plate discharge table
- 70:: Developer tank
- 71:: Circulating pump
- 72:: Lithographic printing plate precursor
- 11:: Transporting path
- 100:: Automatic development processor
- 200:: Pre-heating unit
- 300:: Developing unit
- 400:: Drying unit
- 202:: Machine casing
- 204:: Heating unit
- 208:: Heating chamber
- 210:: Skewer roller
- 212:: Transporting inlet
- 214:: Heater
- 216:: Circulation fan
- 218:: Transporting outlet
- 302:: Insertion unit
- 304:: Insertion roller pair
- 306:: Processing tank
- 306a:: Processing tank margin
- 308:: Developing tank (filled with a developer)
- 310:: Outer panel
- 312:: Slit type insertion slot
- 316:: Submerged roller pair
- 318:: Carrying-out roller pair
- 322:: Brush roller pair
- 324:: Shielding cover
- 326:: Brush roller pair
- 330:: Spray pipe
(*which is constucted to supply a developer in the developing tank 308 sucked by a pump (not shown) and the developer is ejected from the spray pipe 330 in the developing tank 308)
- 334:: Slit type path-through slot
- 336:: Liquid temperature sensor
- 338:: Liquid level meter
- 332:: Partition board
- 342:: Guide member
- 344:: Guide roller
- 402:: Support roller
- 404:: Discharge slot
- 406:: Transport roller pair
- 408:: Transport roller pair
- 410, 412:: Duct
- 414:: Slit hole
- 50:: External tank (developer storage)
- 51:: Overflow apeture
- 52:: Upper limit liquid level meter
- 53:: Lower limit liquid level meter
- 54:: Filter unit
- 55:: Developer supply pump
- C 1:: First circulation pipeline
- C2:: Second circulation pipeline
- 71:: Water tank for replenishment (water storage)
- 72:: Water-replenishing pump
- C3:: Circulation pipeline for water replenishment

### DETAILED DESCRIPTION OF THE INVENTION

### (A) Star polymer

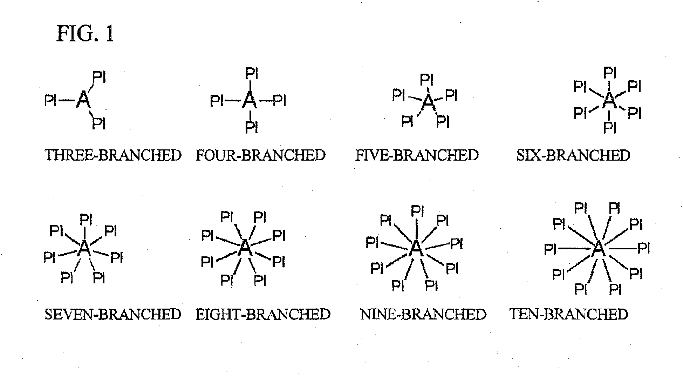

The star polymer for use in the invention is a polymer having a main chain structure as shown in the schematic view of Fig. 1. It has a structure in which one terminal of polymer chain P1 is connected to central skeleton A and is different from a graft polymer in which one terminal of a polymer chain is connected to a polymer chain.

The star polymer for use in the invention may be any star polymer as far as it has the structure described above. The star polymer includes a star polymer obtained by a coupling method or an anion growing method described in Shin Jikken Kagaku Koza, Kobunshi Kagaku I (New Experimental Chemistry Course, Polymer Chemistry I), pages 208 to 210, edited by The Chemical Society of Japan, a star polymer obtained by a synthesis method wherein a polymerization is conducted under light irradiation using a compound having a dithiocarbamate group and/or a compound having xanthate group as an initiator described in JP-A-10-279867, and a star polymer obtained by a conventional radical polymerization using a multifunctional thiol as a chain transfer agent.

The star polymer according to the invention is a polymer in which polymer chains are branched from a central skeleton via sulfide bonds and which is obtained by polymerization of an ethylenically unsaturated monomer in the presence of a multifunctional thiol from the standpoint of ease in synthesis and performances of the polymer obtained. Specifically, a polymer having a hub portion which is a residue of a three or higher functional thiol as a central structure is preferred. In the idealized structure, a main chain of an addition polymer extends from each thio part of the hub portion and thus, three or more main chains extend from the thio parts. Specifically, the central skeleton A has preferably a structure represented by formula (1) shown below.

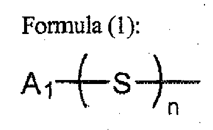

In formula (1), A₁ represents a trivalent or higher valent organic group, and n represents an integer of 3 or more. Specific examples of A₁ include trivalent or higher valent organic groups having structures shown below and trivalent or higher valent organic groups composed of combination of two or more of structures shown below. n is preferably an integer from 3 to 10, more preferably an integer from 3 to 8, and particularly preferably an integer from 3 to 6.

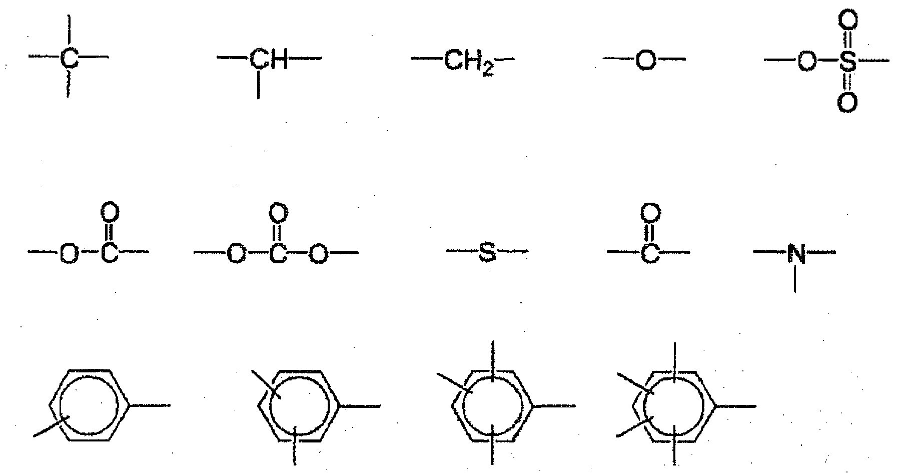

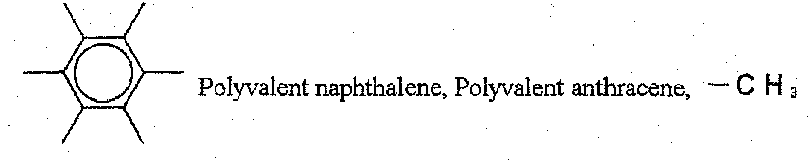

### [Central skeleton of polymer from which polymer chains are branched via sulfide bonds]

As the multifunctional thiol for use in the preparation of the star polymer according to the invention, any compound having three or more thiol groups in its molecule is suitably used. A multifunctional thiol having from 3 to 10 functional groups is preferred, a multifunctional thiol having from 3 to 8 functional groups is preferred, and multifunctional thiol having from 3 to 6 functional groups is particularly preferred. The multifunctional thiol includes Compound A to Compound F described below.

### (Compound A)

Compound A is a compound obtained by a method of reacting a sulfuration agent, for example, thiourea, potassium thiocyanate or thioacetic acid with an electrophilic agent, for example, a halide or a sulfonic acid ester of an alcohol, followed by various treatments. Specific examples of Compound A include compounds set forth below, but the invention should not be construed as being limited thereto.

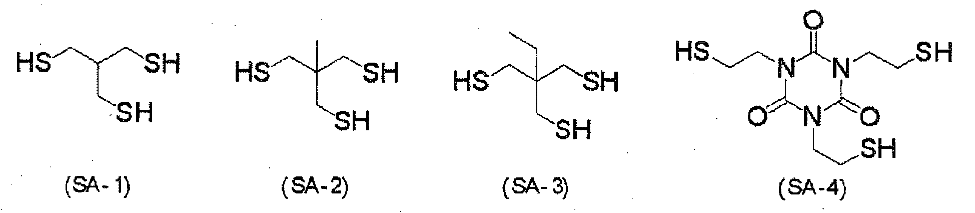

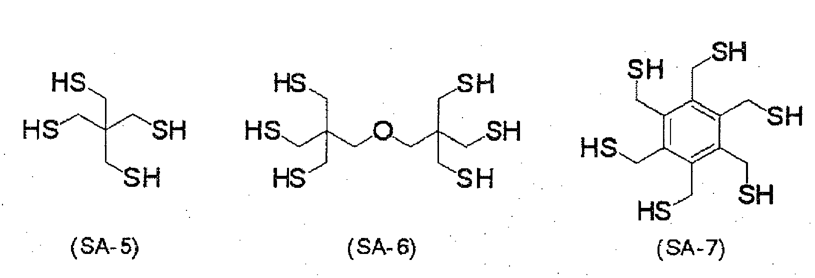

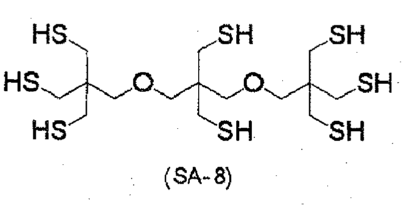

### (Compound B)

Compound B is a compound obtained by a dehydration condensation reaction between a multifunctional alcohol and a carboxylic acid having a thiol group. Among them, a compound obtained by a dehydration condensation reaction between a multifunctional alcohol having from 3 to 10 functional groups and a mono-carboxylic acid having one thiol group is preferred.

Specific examples of the multifunctional alcohol include cyclohexanetriol (3), glycerol (3), 2-hydroxymethyl-1,3-propanediol (3), 1,1,1-tris(hydroxymethyl)ethane (3), 1,2,4-butanetriol (3), trimethylolpropane (3), 1,2,3-trihydroxyhexane (3), 1,2,6-trihydroxyhexane (3), 1,2,3-heptanetriol (3), pyrogallol (3), 1,2,4-benzenetriol (3), phloroglucinol (3), 1,1,1-tris(4-hydroxyphenyl)ethane (3), 1,3,5-tris(2-hydroxyethyl)isocyanurate (3), pentaerythritol (4), threitol (4), erythritol (4), xylulose (4), ribulose (4), quebrachitol (5), adonitol (5), arabitol (5), xylitol (5), catechin (5), epicatechine (5), inositol (6), sorbitol (6), mannitol (6), iditol (6), dulcitol (6), dipentaerythritol (6) and tripentaerythritol (8). The number shown in parentheses above denotes a number of the functional groups.

Of the multifunctional alcohols, cyclohexanetriol (3), glycerol (3), 2-hydroxymethyl-1,3-propanediol (3), 1,1,1-tris(hydroxymethyl)ethane (3), trimethylolpropane (3), phloroglucinol (3), 1,1,1-tris(4-hydroxyphenyl)ethane (3), 1,3,5-tris(2-hydroxyethyl)isocyanurate (3), pentaerythritol (4), catechin (5), epicatechin (5), inositol (6), dipentaerythritol (6) and tripentaerythritol (8) are preferred, cyclohexanetriol (3), 2-hydroxymethyl-1,3-propanediol (3), 1,1,1-tris(hydroxymethyl)ethane (3), trimethylolpropane (3), phloroglucinol (3). 1,1,1-tris(4-hydroxyphenyl)ethane (3), 1,3,5-tris(2-hydroxyethyl)isocyanurate (3), pentaerythritol (4), catechin (5), epicatechin (5), inositol (6), dipentaerythritol (6) and tripentaerythritol (8) are more preferred, and 1,3,5-tris(2-hydroxyethyl)isocyanurate (3), pentaerythritol (4), catechin (5), epicatechin (5), inositol (6), dipentaerythritol (6) and tripentaerythritol (8) are particularly preferred.

Specific examples of the mono-carboxylic acid having one thiol group include mercaptoacetic acid, 3-mercaptopropionic acid, 2-mercaptopropionic acid, 3-mercaptoisobutyric acid, N-acetylcysteine, N-(2-mercaptopropionyl)glycine and thiosalicylic acid.

Of the compounds, mercaptoacetic acid, 3-mercaptopropionic acid, 2-mercaptopropionic acid, 3-mercaptoisobutyric acid, N-acetylcysteine and N-(2-mercaptopropionyl)glycine are preferred, 3-mercaptopropionic acid, 2-mercaptopropionic acid, 3-mercaptoisobutyric acid, N-acetyleysteine and N-(2-mercaptopropionyl)glycine are more preferred, and 3-mercaptopropionic acid, 3-mercaptoisobutyric acid, N-acetylcysteine and N-(2-mercaptopropionyl)glycine are particularly preferred.

Specific examples of Compound B include compounds set forth below, but the invention should not be construed as being limited thereto.

**TABLE 1**

| Multifunctional Alcohol | Carboxylic Acid Having Thiol Group | | | | | | |
|---|---|---|---|---|---|---|---|
| | Mercaptoacetic Acid | 3-Mercaptopropionic Acid | 2-Mercaptopropionic Acid | 3-Mercaptoisobutyric Acid | N-Acetylcysteine | N-(2-Mercaptoprotionyl)glycine | Thiosalicylic Acid |
| Cyclohexanetriol (3) | SB-1 | SB-2 | SB-3 | SB-4 | SB-5 | SB-6 | SB-7 |
| Glycerol (3) | SB-8 | SB-9 | SB-10 | SB-11 | SB-12 | SB-13 | SB-14 |
| 2-Hydroxymethyl-1,3-propanediol (3) | SB-15 | SB-16 | SB-17 | SB-18 | SB-19 | SB-20 | SB-21 |
| 1,1,1-Tris(hydroxymethyl)ethane (3) | SB-22 | SB-23 | SB-24 | SB-25 | SB-26 | SB-27 | SB-28 |
| 1,2,4Butanetriol (3) | SB-29 | SB-30 | SB-31 | SB-32 | SB-33 | SB-34 | SB-35 |
| Trimethylolpropane (3) | SB-36 | SB-37 | SB-38 | SB-39 | SB-40 | SB-41 | SB-42 |
| 1,2,3- Trihydroxyhexane (3) | SB-43 | SB-44 | SB-45 | SB-A6 | SB-47 | SB-48 | SB-49 |
| 1,2,6-Trihydroxyhexane (3) | SB-50 | SB-51 | SB-52 | SB-53 | SB-54 | SB-55 | SB-56 |
| 1,2,3-Heptanetiol (3) | SB-57 | SB-58 | SB-59 | SB-60 | SB-61 | SB-62 | SB-63 |
| Pyrogallol (3) | SB-64 | SB-65 | SB-66 | SB-67 | SB-68 | SB-69 | SB-70 |
| 1,2,4-Benzenetriol (3) | SB-71 | SB-72 | SB-73 | SB-74 | SB-75 | SB-76 | SB-77 |
| Phloroglucinol (3) | SB-78 | SB-79 | SB-80 | SB-81 | SB-82 | SB-83 | SB-84 |
| 1,1,1-Tris(4-hydroxyphenyl)ethane (3) | SB-85 | SB-86 | SB-87 | SB-88 | SB-89 | SB-90 | SB-91 |
| 1,3,5-Tris(2-hydroxyethyl)isocyanurate (3) | SB-92 | SB-93 | SB-94 | SB-95 | SB-96 | SB-97 | SB-98 |
| Pentaerythritol (4) | SB-99 | SB-100 | SB-101 | SB-102 | SB-103 | SB-104 | SB-105 |
| Threitol (4) | SB-106 | SB-107 | SB-108 | SB-109 | SB-110 | SB-111 | SB-112 |
| Erythritol (4) | SB-113 | SB-114 | SB-115 | SB-116 | SB-117 | SB-118 | SB-119 |
| Xylulose (4) | SB-120 | SB-121 | SB-122 | SB-123 | SB-124 | SB-125 | SB-126 |
| Quebrachitol(5) | SB-127 | SB-128 | SB-129 | SB-130 | SB-131 | SB-132 | SB-133 |
| Adonitol (5) | SB-134 | SB-135 | SB-136 | SB-137 | SB-138 | SB-139 | SB-140 |
| Arabitol (5) | SB-141 | SB-142 | SB-143 | SB-144 | SB-145 | SB-146 | SB-147 |
| Xylitol (5) | SB-148 | SB-149 | SB-150 | SB-151 | SB-152 | SB-153 | SB-154 |
| Catechin (5) | SB-155 | SB-156 | SB-157 | SB-158 | SB-159 | SB-160 | SB-161 |
| Epicatechine (5) | SB-162 | SB-163 | SB-164 | SB-165 | SB-166 | SB-167 | SB-168 |
| Inositol (6) | SB-169 | SB-170 | SB-171 | SB-172 | SB-173 | SB-174 | SB-175 |
| Sorbitol (6) | SB-176 | SB-177 | SB-178 | SB-179 | SB-180 | SB-181 | SB-182 |
| Mannitol (6) | SB-183 | SB-184 | SB-185 | SB-186 | SB-187 | SB-188 | SB-189 |
| Iditol (6) | SB-190 | SB-191 | SB-192 | SB-193 | SB-194 | SB-195 | SB-196 |
| Dulcifol (6) | SB-197 | SB-198 | SB-199 | SB-200 | SB-201 | SB-202 | SB-203 |
| Dipentaerythritol (6) | SB-204 | SB-205 | SB-206 | SB-207 | SB-208 | SB-209 | SB-210 |
| Tripenlaerythritol (8) | SB-211 | SB-212 | SB-213 | SB-214 | SB-215 | SB-216 | SB-217 |

Of the specific examples shown in Table 1, SB-1 to SB-34, SB-36 to SB-48, SB-50 to SB-55, SB-57 to SB-62, SB-64 to SB-69, SB-71 to SB-76, SB-78 to SB-111, SB-113 to SB-118, SB-120 to SB-125, SB-127 to SB-132, SB-134 to SB-139, SB-141 to SB-146, SB-148 to SB-153, SB-155 to SB-181, SB-183 to SB-188, SB-190 to SB-195, SB-197 to SB-202 and SB-204 to SB-217 are preferred, SB-1 to SB-6, SB-9 to SB-13, SB-15 to SB-20, SB-22 to SB-27, SB-36 to SB-41, SB-78 to SB-83, SB-85 to SB-90, SB-92 to SB-97, SB-99 to SB-104, SB-155 to SB-160, SB-162 to SB-167, SB-169 to SB-174, SB-204 to SB-209 and SB-211 to SB-216 are more preferred, and SB-2 to SB-6, SB-16 to SB-20, SB-23 to SB-27, SB-37 to SB-41, SB-79 to SB-83, SB-86 to SB-90, SB-93 to SB-97, SB-100 to SB-104, SB-156 to SB-160, SB-163 to SB-167, SB-170 to SB-174, SB-205 to SB-209 and SB-212 to SB-216 are particularly preferred.

Since the multifunctional thiols described above have a long distance between the thiol groups and a small steric hindrance, the desired star structure can be formed.

### (Compound C)

Compound C is a compound obtained by a dehydration condensation reaction between a multifunctional amine and a carboxylic acid having a thiol group. Among them, a compound obtained by a condensation reaction between a multifunctional amine having from 3 to 10 functional groups and a mono-carboxylic acid having one thiol group is preferred.

Specific examples of the multifunctional amine include diethylenetriamine (3), N-(2-aminoethyl)-1,3-propanediamine (3), N-(3-aminopropyl)-1,3-propanediamine (3), spermidine (3), bis(hexamethylene)triamine (3), 4-(aminomethyl)-1,8-octanediamine (3), triethylenetetramine (4),1,4,7,11-tetraazaundecane (4), N,N'-bis(3-aminopropyl)ethylenediamine (4), N,N'-bis(2-aminoethyl)-1,3-propanediamine (4), N,N'-bis(3-aminopropyl)-1,3-propanediamine (4), spermine (4), tris(2-aminoethyl)amine (3), tetraethylenepentamine (5), pentaethylenehexamine (6), 1,4,7-triazacyclononane (3), 1,5,9-triazacyclododecane (3), cyclene (4), 1,4,8,11-tetraazacyclotetradecane (4), 1,4,8,12-tetraazacyclopentadecane (4), hexacyclene (6), 3,3'-diaminobenzidine (4) and 1,2,4,5-benzenetetramine (4).

Of the multifunctional amines, 4-(aminomethyl)-1,8-octanediamine (3), triethylenetetramine (4), 1,4,7,11-tetraazaundecane (4), N,N'-bis(3-aminopropyl)ethylenediamine (4), N,N'-bis(2-ammoethyl)-1,3-propanediamine (4), N,N'-bis(3-aminopropyl)-1,3-propanedianine (4), spermine (4), tris(2-aminoethyl)amine (3), tetraethylenepentamine (5), pentaethylenehexamine (6), cyclene (4) and hexacyclene (6) are preferred, 4-(aminomethyl)-1,8-octanediamine (3), tris(2-aminoethyl)amine (3), tetraethylenepentamine (5), pentaethylenehexamine (6), cyclene (4) and hexacyclene (6) are more preferred, and tetraethylenepentamine (5), pentaethylenehexamine (6), cyclene (4) and hexacyclene (6) are particularly preferred.

Specific examples of the carboxylic acid having a thiol group include the carboxylic acids described for Compound B above. Specific examples of Compound C include compounds set forth below, but the invention should not be construed as being limited thereto.

**TABLE 2**

| Multifunctional Amine | Carboxylic Acid Having Thiol Group | | | | | | |
|---|---|---|---|---|---|---|---|
| | Mercaptoacetic Acid | 3-Mercaptopropionic Acid | 2-Mercaptopropionic Acid | 3-Mercaptoisobutyric Acid | N-Acetylcysteine | N-(2-Mercaptopropionyl)glycine | Thiosalicylic Acid |
| Diethylenetriamine (3) | SC-1 | SC-2 | SC-3 | SC-4 | SC-5 | SC-6 | SC-7 |
| N-(2-Aminoethyl)-1,3-propanediamine(3) | SC-8 | SC-9 | SC-10 | SC-11 | SC-12 | SC-13 | SC-14 |
| N-(3-Aminopropyl)-1,3-propanediamine (3) | SC-15 | SC-16 | SC-17 | SC-18 | SC-19 | SC-20 | SC-21 |
| Spermidine (3) | SC-22 | SC-23 | SC-24 | SC-25 | SC-26 | SC-27 | SC-28 |
| Bis(hexamethylene)triamine (3) | SC-29 | SC-30 | SC-31 | SC-32 | SC-33 | SC-34 | SC-35 |
| 4-(Aminomethyl)-1,8-octanediamine (3) | SC-36 | SC-37 | SC-38 | SC-39 | SC-40 | SC-41 | SC-42 |
| Triethylenetetramine (4) | SC43 | SC-44 | SC-45 | SC-46 | SC-47 | SC-48 | SC-49 |
| 1,4,7,11-Tetraazaundecane (4) | SC-50 | SC-51 | SC-52 | SC-53 | SC-54 | SC-55 | SC-56 |
| N,N'-Bis(3-aminopropyl)ethylenediamine (4) | SC-57 | SC-58 | SC-59 | SC-60 | SC-61 | SC-62 | SC-63 |
| N,N'-Bis(2-aminoethyl)-1,3-propanediamine (4) | SC-64 | SC-65 | SC-66 | SC-67 | SC-68 | SC-69 | SC-70 |
| N,N'-Bis(3-aminopropyl)-1,3-propanediamine (4) | SC-71 | SC-72 | SC-73 | SC-74 | SC-75 | SC-76 | SC-77 |
| Spermine (4) | SC-78 | SC-79 | SC-80 | SC-81 | SC-82 | SC-83 | SC-84 |
| Tris(2-ammoethyl)amine (3) | SC-85 | SC-86 | SC-87 | SC-88 | SC-89 | SC-90 | SC-91 |
| Tetraethylenepentamine (5) | SC-92 | SC-93 | SC-94 | SC-95 | SC-96 | SC-97 | SC-98 |
| Pentaethylenehexamine (6) | SC-99 | SC-100 | SC-101 | SC-102 | SC-103 | SC-104 | SC-105 |
| 1,4,7-Triazacyclononane(3) | SC-106 | SC-107 | SC-108 | SC-109 | SC-110 | SC-111 | SC-112 |
| 1,5,9-Triazacyclododecane (3) | SC-113 | SC-114 | SC-115 | SC-116 | SC-117 | SC-118 | SC-119 |
| Cyclene (4) | SC-120 | SC-121 | SC-122 | SC-123 | SC-124 | SC-125 | SC-126 |
| 1,4,8,11-Tetraazacyclotetradecane (4) | SC-127 | SC-128 | SC-129 | SC-130 | SC-131 | SC-132 | SC-133 |
| 1,4,8,12-Tetraazacyclopentadecane (4) | SC-134 | SC-135 | SC-136 | SC-137 | SC-138 | SC-139 | SC-140 |
| Hexacyclene (6) | SC-141 | SC-142 | SC-143 | SC-144 | SC-145 | SC-146 | SC-147 |

Of the compounds shown in Table 2, SC-1 to SC-6, SC-8 to SC-13, SC-15 to SC-20, SC-22 to SC-27, SC-29 to SC-34, SC-36 to SC-111, SC-113 to SC-118, SC-120 to SC-132, SC-134 to SC-139 and SC-141 to SC-147 are preferred, SC-37 to SC-41, SC-44 to SC-48, SC-51 to SC-55, SC-58 to SC-62, SC-65 to SC-69, SC-72 to SC-76, SC-79 to SC-83, SC-86 to SC-90, SC-93 to SC-97, SC-100 to SC-104, SC-121 to SC-125 and SC-142 to SC-146 are more preferred, and SC-37 to SC-41, SC-86 to SC-90, SC-93 to SC-97, SC-100 to SC-104, SC-121 to SC-125 and SC-142 to SC-146 are particularly preferred.

Since the multifunctional thiols described above have a long distance between the thiol groups and a small steric hindrance, the desired star structure can be formed.

### (Compound D)

Compound D is a compound obtained by a dehydration condensation reaction between a compound having a hydroxy group and an amino group and a carboxylic acid having a thiol group, and preferably a compound obtained by a dehydration condensation reaction between a multifunctional alcoholamine having from 3 to 10 functional groups of hydroxy group and amino group and a mono-carboxylic acid having one thiol group is preferred.

Specific examples of the multifunctional alcoholamine include diethanolamine (3), serinol (3), diisopropanolamine (3), 2-amino-2-ethyl-1,3-propanediol (3), 2-amino-2-methyl-1,3-propanediol (3), tris(hydroxymethyl)aminomethane (4), bishomotris (4), 1,3-diamino-2-hydroxypropane (3), 2-(2-aminoethylamino)ethanol (3), N,N'-bis(2-hydroxyethyl)ethylenediamine (4), 1,3-bis[tris(hydroxymethyl)methylamino]propane (8), 1-amino-1-deoxy-D-sorbitol (6), N-methyl-D-glucamine (6), 2,3-diaminophenol (3), 4-aminoresorcinol (3), norphenylephrine (3), octopamine (3), synephrine (3), 3,4-dihydroxybenzylamine (3), 3-hydroxytyramine (3), norepinephrine (4), 5-hydroxydopamine (4) and 6-hydroxydopamine (4).

Of the multifunctional alcoholamines, serinol (3), 2-amino-2-methyl-1,3-propanediol (3), tris(hydroxymethyl)aminomethane (4), bishomotris (4), 1,3-diamino-2-hydroxypropane (3), N,N'-bis(2-hydroxyethyl)ethylenediamine (4), 1,3-bis[tris(hydroxymethyl)methylamino]propane (8), 1-amino-1-deoxy-D-sorbitol (6), N-methyl-D-glucamine (6), norepinephrine (4), 5-hydroxydopamine (4) and 6-hydroxydopamine (4) are preferred, and tris(hydroxymethyl)aminomethane (4), bishomotris (4), N,N'-bis(2-hydroxyethyl)ethylenediamine (4), 1,3-bis[tris(hydroxymethyl)methylamino]propane (8), 1-amino-1-deoxy-D-sorbitol (6), N-metbyl-D-glucamine (6), norepinephrine (4), 5-hydroxydopamine (4) and 6-hydroxydopamine (4) are particularly preferred.

Specific examples of the carboxylic acid having a thiol group include the carboxylic acids described for Compound B above. Specific examples of Compound D include compounds set forth below, but the invention should not be construed as being limited thereto.

**TABLE 3**

| Multifunctional Alcoholamine | Carboxylic Acid Having Thiol Group | | | | | | |
|---|---|---|---|---|---|---|---|
| | Mercaptoacetic Acid | 3-Mercaptopropionic Acid | 2-Mercaptopropionic Acid | 3-Mercaptoisobutyric Acid | N-Acetylcysteine | N-(2- Mercaptopropionyl) glycine | Thiosalicylic Acid |
| Diethanolamine (3) | SD-1 | SD-2 | SD-3 | SD-4 | SD-5 | SD-6 | SD-7 |
| Serinol (3) | SD-8 | SD-9 | SD-10 | SD-11 | SD-12 | SD-13 | SD-14 |
| Diisopropanolamine (3) | SD-15 | SD-16 | SD-17 | SD-18 | SD-19 | SD-20 | SD-21 |
| 2-Amino-2-ethyl-1,3-propanediol (3) | SD-22 | SD-23 | SD-24 | SD-25 | SD-26 | SD-27 | SD-28 |
| 2-Amino-2-methyl-1,3-propanediol (3) | SD-29 | SD-30 | SD-31 | SD-32 | SD-33 | SD-34 | SD-35 |
| Tris(hydroxymethyl)aminomethane (4) | SD-36 | SD-37 | SD-38 | SD-39 | SD-40 | SD-41 | SD-42 |
| Bishomotris (4) | SD-43 | SD-44 | SD-45 | SD-46 | SD-47 | SD-48 | SD-49 |
| 1,3-Diamino-2-hydroxypropane (3) | SD-50 | SD-51 | SD-52 | SD-53 | SD-54 | SD-55 | SD-56 |
| 2-(2-Aminoethylamino)ethanol (3) | SD-57 | SD-58 | SD-59 | SD-60 | SD-61 | SD-62 | SD-63 |
| N,N'-Bis(2-hydroxyethyl)ethylenediamine (4) | SD-64 | SD-65 | SD-66 | SD-67 | Sd-68 | SD-69 | SD-70 |
| 1,3-Bis[tris-(hydroxymethyl)methylamino]propane (8) | SD-71 | SD-72 | SD-73 | SD-74 | SD-75 | SD-76 | SD-77 |
| 1-Amino-1-deoxy-D-sorbitol (6) | SD-78 | SD-79 | SD-80 | SD-81 | SD-82 | SD-83 | SD-84 |
| N-Methyl-D-glucamine (6) | SD-85 | SD-86 | SD-87 | SD-88 | SD-89 | SD-90 | SD-91 |
| 2,3-Diaminophenol (3) | SD-92 | SD-93 | SD-94 | SD-95 | SD-96 | SD-97 | SD-98 |
| 4-Aminoresorcinol (3) | SD-99 | SD-100 | SD-101 | SD-102 | SD-103 | SD-104 | SD-105 |
| Norphenylephrine (3) | SD-106 | SD-107 | SD-108 | SD-109 | SD-110 | SD-111 | SD-112 |
| Octopamine (3) | SD-113 | SD-114 | SD-115 | SD-116 | SD-117 | SD-118 | SD-119 |
| Synephrine (3) | SD-120 | SD-121 | SD-122 | SD-123 | SD-124 | SD-125 | SD-126 |
| 3,4-Dihydroxybenzylamine (3) | SD-127 | SD-128 | SD-129 | SD-130 | SD-131 | SD-132 | SD-133 |
| 3-Hydroxytyramine (3) | SD-134 | SD-135 | SD-136 | SD-137 | SD-138 | SD-139 | SD-140 |
| Norepinephrine (4) | SD-141 | SD-142 | SD-143 | SD-144 | SD-145 | SD-146 | SD-147 |
| 5-Hydroxydopamine (4) | SD-148 | SD-149 | SD-150 | SD-151 | SD-152 | SD-153 | SD-154 |
| 6-Hydroxydopamine (4) | SD-155 | SD-156 | SD-157 | SD-158 | SD-159 | SD-160 | SD-161 |

Of the compounds shown in Table 3, SD-1 to SD-6, SD-8 to SD-20, SD-22 to SD-27, SD-29 to SD-62, SD-64 to SD-97, SD-99 to SD-104, SD-106 to SD-111, SD-113 to SD-118, SD-120 to SD-125, SD-127 to SCD-132, SD-134 to SD-139 and SD-141 to SD-161 are preferred, SD-9 to SD-13, SD-30 to SD-34, SD-37 to SD-41, SD-44 to SD-48, SD-51 to SD-55, SD-65 to SD-69, SD-72 to SD-76, SD-79 to SD-83, SD-86 to SD-90, SD-142 to SD-146, SD-149 to SD-153 and SD-156 to SD-160 are more preferred, and SD-37 to SD-41, SD-44 to SD-48, SD-65 to SD-69, SD-72 to SD-76, SD-79 to SD-83, SD-86 to SD-90, SD-142 to SD-146, SD-149 to SD-153 and SD-156 to SD-160 are particularly preferred.

Since the multifunctional thiols described above have a long distance between the thiol groups and a small steric hindrance, the desired star structure can be formed.

### (Compound E)

Compound E is a compound obtained by a dehydration condensation reaction between a multifunctional carboxylic acid and an alcohol having a thiol group. Among them, a compound obtained by a dehydration condensation reaction between a multifunctional carboxylic acid having from 2 to 10 functional groups and an alcohol having one or more thiol groups is preferred.

Specific examples of the multifunctional carboxylic acid include oxalic acid (2), malonic acid (2), methylmalonic acid (2), succinic acid (2), methylsuccinic acid (2), glutaric acid (2), adipic acid (2), pimelic acid (2), suberic acid (2), azelaic acid (2), sebacic acid (2), tricarballylic acid (3), 1,2,3,4-butanetetracarboxylic acid (4), aconitic acid (3), hexafluoroglutaric acid (2), malic acid (2), tartaric acid (2), citric acid (3), diglycolic acid (2), 3,6-dioxaoctanedicarboxylic acid (2), tetrahydrofuran-2,3,4,5-tetracarboxylic acid (4), mercaptosuccinic acid (2), thioglycolic acid (2), 2,2',2",2"'-[1,2-ethanediylidenetetrakis(thio)]tetrakisacetic acid (4), 1,3,5-cyclohexanetricarboxylic acid (3), 1,2,3,4-cyclobutanetetracarboxylic acid (4), 1,2,3,4,5,6-cyclohexanehexacarboxylic acid (6), 1,2-phenylenediacetic acid (2), 1,2-phenylenedioxydiacetic acid (2), homophthalic acid (2), 1,3-phenylenediacetic acid (2), 4-carboxyphenoxyacetic acid (2), 1,4-phenylenediacetic acid (2), 1,4-phenylenedipropionic acid (2), phthalic acid (2), isophthalic acid (2), terephthalic acid (2), 1,2,3-benzenetricarboxylic acid (3), 1,2,4-benzenetricarboxylic acid (3), 1,3,5-benzenetricarboxylic acid (3), 1,2,4,5-benzenetetracarboxylic acid (4), mellitic acid (6) and 1,4,5,8-naphthalenetetracarboxylic acid (4).

Of the multifunctional carboxylic acids, tricarballylic acid (3), 1,2,3,4-butanetetracarboxylic acid (4), aconitic acid (3), citric acid (3), tetrahydrofuran-2,3,4,5-tetracarboxylic acid (4), mercaptosuccinic acid (2), 2,2',2",2"'-[1,2-ethanediylidenetetrakis(thio)]tetrakisacetic acid (4), 1,3,5-cyclohexanetricarboxylic acid (3), 1,2,3,4-cyclobutanetetracarboxylic acid (4), 1,2,3,4,5,6-cyclohexanehexacarboxylic acid (6), 1,2-phenylenediacetic acid (2), 1,2-phenylenedioxydiacetic acid (2), 1,3-phenylenediacetic acid (2), 1,4-phenylenediacetic acid (2), 1,4-phenylenedipropionic acid (2), phthalic acid (2), isophthalic acid (2), terephthalic acid (2), 1,3,5-benzenetricarboxylic acid (3), 1,2,4,5-benzenetetracarboxylic acid (4), mellitic acid (6) and 1,4,5,8-naphthalenetetracarboxylic acid (4) are preferred, and tricarballylic acid (3), 1,2,3,4-butanetetracarboxylic acid (4), tetrahydrofuran-2,3,4,5-tetracarboxylic acid (4), mercaptosuccinic acid (2), 2,2,2",2"'-[1,2-ethandiylidenetetrakis(thio)]tetrakisacetic acid (4), 1,3,5-cyclohexanetricarboxylic acid (3), 1,2,3,4-cyclobutanetetracarboxylic acid (4), 1,2,3,4,5,6-cyclohexanehexacarboxylic acid (6), 1,3,5-benzenetricarboxylic acid (3), 1,2,4,5-benzenetetracarboxylic acid (4), mellitic acid (6) and 1,4,5,-naphthalenetetracarboxylic acid (4) are particularly preferred.

Specific examples of the alcohol having a thiol group include 2-mercaptoethanol (1), 1-mercapto-2-propanol (1), 3-mercapto-1-propanol (1), 3-mercapto-2-butanol (1), 2,3-dimercapto-1-propanol (2) and 4-hydroxythiophenol (1). Of the alcohols having a thiol group, 2-mercaptoethanol (1), 3-mercapto-1-propanol (1) and 2,3-dimercapto-1-propanol (2) are preferred, 2-mercaptoethanol (1) and 3-mercapto-1-propanol (1) are more preferred, and 3-mercapto-1-propanol (1) is particularly preferred.

Specific examples of Compound E include compounds shown in Tables 4 and 5 below, but the invention should not be construed as being limited thereto.

**TABLE 4**

| Multifunctional Carboxylic Acid | Alcohol Having Thiol Group | | | | | |
|---|---|---|---|---|---|---|
| | 2-Mercaptoethanol | 1-Mereapto-2-propanol | 3-Mercapto-1-propanol | 3-Mercapto-2-butanol | 2,3-Dimercapto-1-propanol | 4-Hydroxythiophenol |
| Oxalic acid (2) | - | - | - | - | SE-1 | - |
| Malonic acid (2) | - | - | - | - | SE-2 | - |
| Methylmalonic acid (2) | - | - | - | - | SE-3 | - |
| Succinic acid (2) | - | - | - | - | SE-4 | - |
| Methylsuccinic acid (2) | - | - | - | - | SE-5 | - |
| Glutaric acid (2) | - | - | - | - | SE-6 | - |
| Adipic acid (2) | - | - | - | - | SE-7 | - |
| Pimelic acid (2) | - | - | - | - | SE-8 | - |
| Suberic acid (2) | - | - | - | - | SE-9 | - |
| Azelaic acid (2) | - | - | - | - | SE-10 | - |
| Sebacic acid (2) | - | - | - | - | SE-11 | - |
| Tricarballylic acid (3) | SE-12 | SE-13 | SE-14 | SE-15 | SE-16 | SE-17 |
| 1,2,3,4-Butanetetracarboxylicacid (4) | SE-18 | SE-19 | SE-20 | SE-21 | SE-22 | SE-23 |
| Aconitic acid (3) | SE-24 | SE-25 | SE-26 | SE-27 | SE-28 | SE-29 |
| Hexafluoroglutaric acid (2) | - | - | - | - | SE-30 | - |
| Malic acid (2) | - | - | - | - | SE-31 | - |
| Tartaric acid (2) | - | - | - | - | SE-32 | - |
| Citric acid (3) | SE-33 | SE-34 | SE-35 | SE-36 | SE-37 | SE-38 |
| Digiycolic acid (2) | - | - | - | - | SE-39 | - |
| 3,6-Dioxaoctanedicarboxylicacid (2) | - | - | - | - | SE-40 | - |
| Tetrahydrofuran-2,3,4,5-tetracarboxylic acid (4) | SE-41 | SE-42 | SE-43 | SE-44 | SE-45 | SE-46 |
| Mercaptosuccinic acid (2) | SE-119 | SE-120 | SE-121 | SE-122 | SE-47 | SE-123 |
| Thioglycolic acid (2) | - | - | - | - | SE-48 | - |
| 2,2',2",2"'-[1,2-Ethanediylidenetetrakis(thio)]tetrakisacetic acid (4) | SE-49 | SE-50 | SE-51 | SE-52 | SE-53 | SE-54 |

**TABLE 5**

| Multifunctional Carboxylic Acid | Alcohol Having Thiol Group | | | | | |
|---|---|---|---|---|---|---|
| | 2-Mercaptoethanol | 1-Mercapto-2-propanol | 3-Mercapto-1-propanol | 3-Mercapto-2-butanol | 2,3-Dimercapto-1-propanol | 4-Hydroxythiophenol |
| 1,3,5-Cyclohexanetricarboxylic acid (3) | SE-55 | SE-56 | SE-57 | SE-58 | SE-59 | SE-60 |
| 1,2,3,4-Cyclobutanetetracarboxylic acid (4) | SE-61 | SE-62 | SE-63 | SE-64 | SE-65 | SE-66 |
| 1,2,3,4,5,6-Cyclohexanehexacarboxylic acid (6) | SE-67 | SE-68 | SE-69 | SE-70 | SE-71 | SE-72 |
| 1,2-Phenylenediacetic acid (2) | - | - | - | - | SE-73 | - |
| 1,2-Phenylenedioxydiacetic acid (2) | - | - | - | - | SE-74 | - |
| Homophthalic acid (2) | - | - | - | - | SE-75 | - |
| 1,3-Phenylenediacetic acid (2) | - | - | - | - | SE-76 | - |
| 4-Carboxyphenoxyacetic acid (2) | - | - | - | - | SE-77 | - |
| 1,4-Phenylenediacetic acid (2) | - | - | - | - | SE-78 | - |
| 1,4-Phenylenedipropionic acid (2) | - | - | - | - | SE-79 | - |
| Phthalic acid (2) | - | - | - | - | SE-80 | - |
| Isophthalic acid (2) | - | - | - | - | SE-81 | - |
| Terephthalic acid (2) | - | - | - | - | SE-82 | - |
| 1,2,3-Benzenetricarboxylic acid (3) | SE-83 | SE-84 | SE-85 | SE-86 | SE-87 | SE-88 |
| 1,2,4-Benzenetricarboxylic acid (3) | SE-89 | SE-90 | SE-91 | SE-92 | SE-93 | SE-94 |
| 1,3,5-Benzenetricarboxylic acid (3) | SE-95 | SE-96 | SE-97 | SE-98 | SE-99 | SE-100 |
| 1,2,4,5-benzenetetracarboxylic acid (4) | SE-101 | SE-102 | SE-103 | SE-104 | SE-105 | SE-106 |
| Mellitic acid (6) | SE-107 | SE-108 | SE-109 | SE-110 | SE-111 | SE-112 |
| 1,4,5,8-Naphthalenetetracarboxylic acid (4) | SE-113 | SE-114 | SE-115 | SE-116 | SE-117 | SE-118 |

Of the compounds shown in Tables 4 and 5, SE-12, SE-14, SE-16, SE-18, SE-20, SE-22, SE-24, SE-26, SE-33, SE-35, SE-41, SE-43, SE-45, SE-119, SE-121, SE-47, SE-49, SE-51, SE-53, SE-55, SE-57, SE-59, SE-61, SE-63, SE-65, SE-67, SE-69, SE-71, SE-83, SE-85, SE-89, SE-91, SE-95, SE-97, SE-99, SE-101, SE-103, SE-105, SE-107, SE-109, SE-111, SE-113, SE-115 and SE-117 are preferred, and SE-12, SE-14, SE-18, SE-20, SE-41, SE-43, SE-119, SE-121, SE-49, SE-51, SE-55, SE-57, SE-61, SE-63, SE-67, SE-69, SE-95, SE-97, SE-101, SE-103, SE-107, SE-109, SE-113 and SE-115 are more preferred.

Since the multifunctional thiols described above have a long distance between the thiol groups and a small steric hindrance, the desired star structure can be formed.

### (Compound F)

Compound F is a compound obtained by a dehydration condensation reaction between a multifunctional carboxylic acid and an amine having a thiol group. Among them, a compound obtained by a dehydration condensation reaction between a multifunctional carboxylic acid having from 2 to 10 functional groups and an amine having one or more thiol groups is preferred.

Specific examples of the multifunctional carboxylic acid include the multifunctional carboxylic acids described above. Specific examples of the amine having one or more thiol groups include 2-aminoethanethiol, 2-aminothiophenol, 3-aminothiophenol and 4-aminothiophenol, and 2-aminoethanethiol and 4-aminothiophenol are preferred, and 2-aminoethanethiol is more preferred.

Specific examples of Compound F include compounds set forth below, but the invention should not be construed as being limited thereto.

**TABLE 6**

| Multifunctional Carboxylic Acid | Amine Having Thiol Group | | | |
|---|---|---|---|---|
| | 2-Aminoetyhanetial | 2-Aminothiophenol | 3-Aminothiophenol | 4-Aminothiophenol |
| Tricarballylic acid (3) | SF-1 | SF-2 | SF-3 | SF-4 |
| 1,2,3,4-Butanetetracarboxylic acid (4) | SF-5 | SF-6 | SF-7 | SF-8 |
| Aconitic acid (3) | SF-9 | SF-10 | SF-11 | SF-12 |
| Citric acid (3) | SF-13 | SF-14 | SF-15 | SF-16 |
| Tetrahydrofuran-2,3,4,5-tetracarboxylic acid (4) | SF-17 | SF-18 | SF-19 | SF-20 |
| Mercaptosuccinic acid (2) | SF-21 | SF-22 | SF-23 | SF-24 |
| 2,2',2",2"'-[1,2-Ethanediylidenetetrakis(thio)]tetrakisacetic acid (4) | SF-25 | SF-26 | SF-27 | SF-28 |
| 1,3,5-Cyclohexanetricarboxylic acid (3) | SF-29 | SF-30 | SF-31 | SF-32 |
| 1,2,3,4-Cyclobutanetetracarboxylic acid (4) | SF-33 | SF-34 | SF-35 | SF-36 |
| 1,2,3,4,5,6-Cyclohexanehexacarboxylic acid (6) | SF-37 | SF-38 | SF-39 | SF-40 |
| 1,2,3-Benzenetricarboxylic acid (3) | SF-41 | SF-42 | SF-43 | SF-44 |
| 1,2,4-Benzenetricarboxyiic acid (3) | SF-45 | SF-46 | SF-47 | SF-48 |
| 1,3,5-Benzenetricarboxylic acid (3) | SF-49 | SF-50 | SF-51 | SF-52 |
| 1,2,4,5-benzenetetracarboxylic acid (4) | SF-53 | SF-54 | SF-55 | SF-56 |
| Mellitic acid (6) | SF-57 | SF-58 | SF-59 | SF-60 |
| 1,4,5,8-Naphthalenetetracarboxylic acid (4) | SF-61 | SF-62 | SF-53 | SF-64 |

Of the compounds shown in Table 6, SF-1, SF-4, SF-5, SF-8, SF-9, SF-13, SF-17, SF-20, SF-21, SF-24, SF-25, SF-28, SF-29, SF-32, SF-33, SF-36, SF-37, SF-40, SF-41, SF-45, SF-49, SF-52, SF-53, SF-56, SF-57, SF-60, SF-61 and SF-64 are preferred, and SF-1, SF-5, SF-17, SF-21, SF-25, SF-29, SF-33, SF-37, SF-49, SF-53, SF-57 and SF-61 are more preferred.

Since the multifunctional thiols described above have a long distance between the thiol groups and a small steric hindrance, the desired star structure can be formed.

Of the multifunctional thiols described above, Compounds A to E are preferred, Compounds A, B, C and E are more preferred, and Compounds A, B and C are particularly preferred, from the standpoint of the printing durability and development property.

### [Polymer chain]

The polymer chain of the star polymer according to the invention includes a polymer chain of a known vinyl-based polymer, (meth)acrylic acid-based polymer or styrene-based polymer, which can be produced by radical polymerization, and a polymer chain of a(meth)acrylic acid-based polymer is particularly preferred.

### [Hydrophilic group]

The polymer chain of the star polymer according to the invention may contain a repeating unit having a hydrophilic group as a copolymerization component in order to increase hydrophilicity of the surface of support and improve the development property. Specific examples of the hydrophilic group are set forth below.

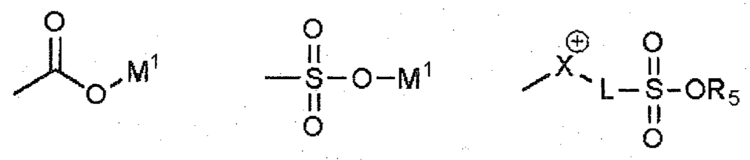

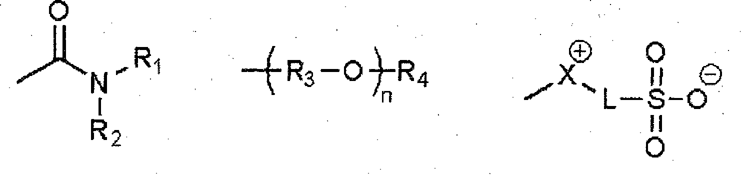

In the formulae above, M¹ represents a hydrogen atom, a metal atom or an ammonium group. X⁺ denotes a group represented by -NR⁺R¹R²-, -S⁺R¹-, -I⁺- or -P⁺R¹R²-. R¹ and R² each independently represents a hydrogen atom or a straight-chain or branched alkyl group having from 1 to 6 carbon atoms, or R¹ and R² may be combined with each other to forms ring. R³ represents a straight-chain or branched alkylene group having from 1 to 6 carbon atoms and is preferably an ethylene group. R⁴ represents a hydrogen atom or an alkyl group having from 1 to 12 carbon atoms. n represents an integer from 1 to 100 and is preferably from 1 to 30. R⁵ represents a hydrogen atom or an alkyl group having from 1 to 12 carbon atoms. L represents a single bond or a divalent connecting group comprising from 1 to 60 carbon atoms, from 0 to 10 nitrogen atoms, from 0 to 50 oxygen atoms, from 1 to 100 hydrogen atoms and from 0 to 20 sulfur atoms. More specifically, the divalent connecting group includes those formed by a combination of structural units shown below.

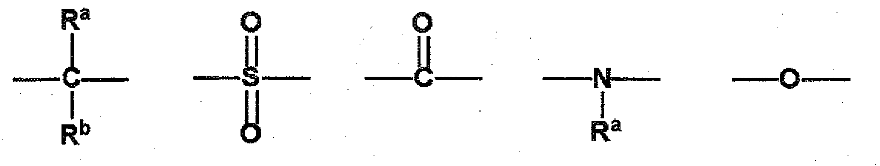

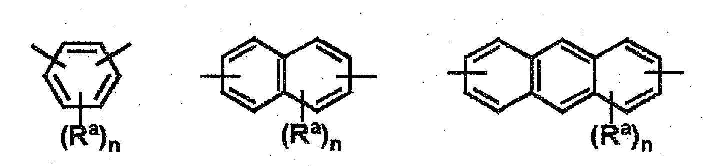

In the structures above, R^{a} and R^{b} each represents a hydrogen atom, an alkyl group having from 1 to 20 carbon atoms, an aryl group having from 6 to 20 carbon atoms or a halogen atom. n represents an integer from 1 to 4.

According to the invention, specifically, the repeating unit having a hydrophilic group is preferably represented by formula (B1) shown below.

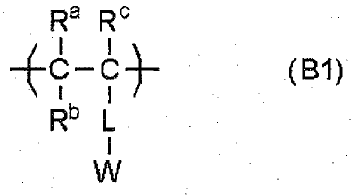

In formula (B1), R^{a} to R^{c} each independently represents a hydrogen atom, an alkyl group having from 1 to 6 carbon atoms or a halogen atom. L has the same meaning as defined above. W represents a hydrophilic group and its preferred embodiment is the same as described above. W is preferably a group containing a polyalkylene oxy group, and particularly preferably a group containing a polyethylene oxy group.

Specific examples of the repeating unit having a hydrophilic group for use in the invention are set forth below, but the invention should not be construed as being limited thereto.

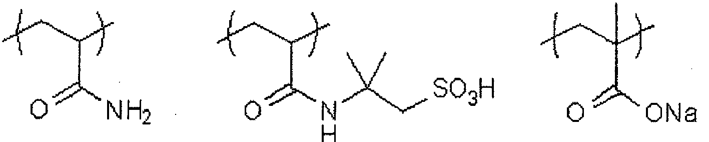

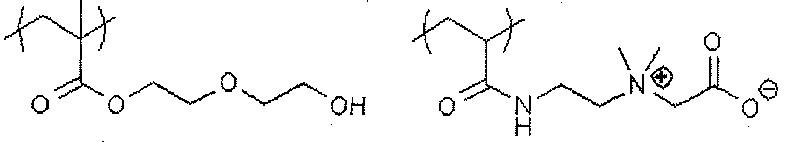

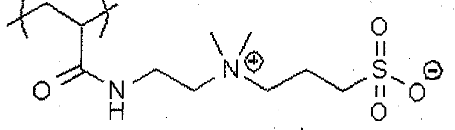

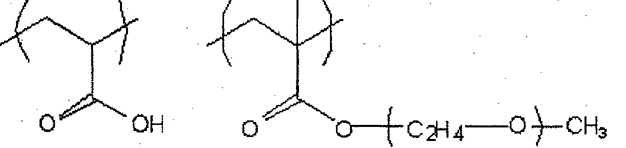

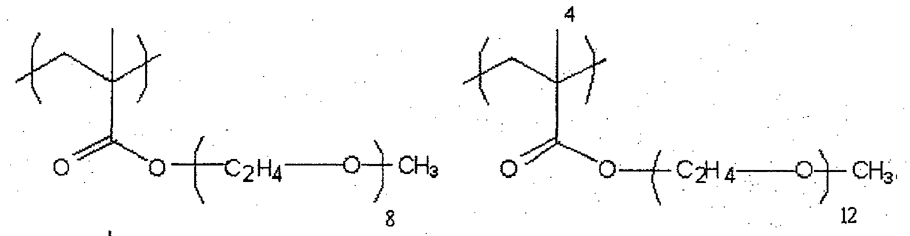

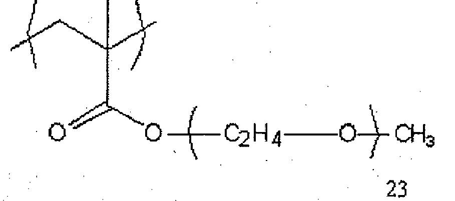

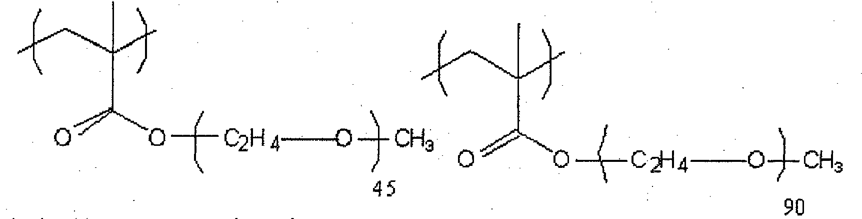

### [Adsorbing group to surface of support]

According to a preferred example of the polymer chain for use in the invention, the polymer chain contains a repeating unit having at least one functional group capable of interacting with a surface of the support as a copolymerization component in order to increase an adhesion property to the support. The functional group capable of interacting with a surface of the support includes, for example, a group capable of undergoing interaction, for example, forming an ionic bond or a hydrogen bond or undergoing polar interaction, with metal, a metal oxide, a hydroxy group or the like present on the support subjected to anodizing treatment or hydrophilizing treatment is exemplified. Specific examples of the functional group capable of interacting with a surface of the support are set forth below.

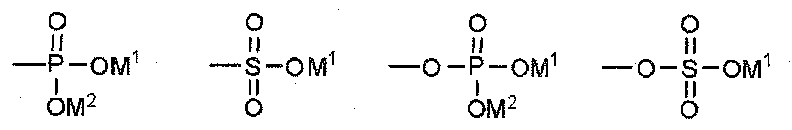

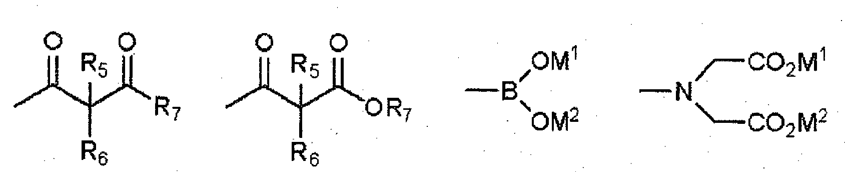

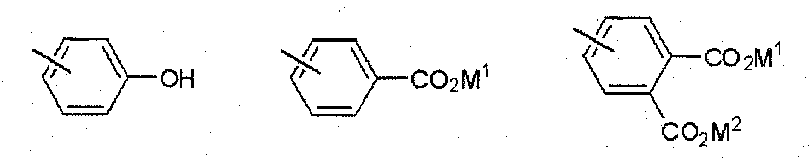

In the formulae above, R⁵ to R⁷ each independently represents a hydrogen atom, an alkyl group having from 1 to 10 carbon atoms, an alkynyl group having from 2 to 10 carbon atoms, an alkenyl group having from 2 to 10 carbon atoms or an aryl group having from 6 to 15 carbon atoms, and M¹ and M² each independently represents a hydrogen atom, a metal atom included in alkali metal or alkaline earth metal or an ammonium group. From the standpoint of the stain resistance and printing durability, the functional group capable of interacting with a surface of the support is preferably a carboxylic acid group, a sulfonic acid group, a phosphoric acid ester group or a salt thereof or a phosphonic acid group or a salt thereof. In view of further improvement in the stain resistance, a phosphoric acid ester group or a salt thereof or a phosphonic acid group or a salt thereof is more preferred, and a phosphonic acid group or a salt thereof is most preferred.

According to the invention, specifically, the repeating unit having at least one functional group capable of interacting with a surface of the support is preferably represented by formula (B2) shown below.

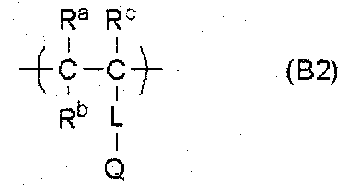

In formula (B2), R^{a} to R^{c} and L have the same meanings as those defined in formulae (B1) respectively. Q represents a functional group capable of interacting with a surface of the support and its preferred embodiment is the same as described above.

Specific examples of the repeating unit having at least one functional group capable of interacting with a surface of the support for use in the invention are set forth below, but the invention should not be construed as being limited thereto.

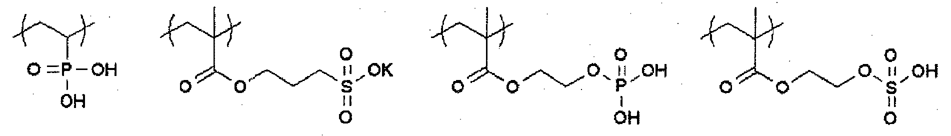

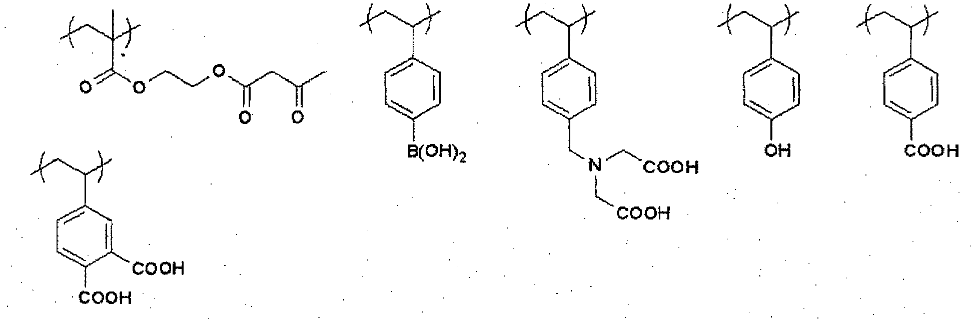

### [Crosslinkable group]

The polymer chain of the star polymer for use in the invention preferably further contains a repeating unit having a crosslinkable group as a copolymerization component The crosslinkable group as used herein means a group capable of crosslinking the polymer chain in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable functional group includes, for example, a thiol group and a halogen atom. Among them, the ethylenically unsaturated bond group is preferred. Of the ethylenically unsaturated bond groups, a (meth)acryloyl group or an allyl group is preferred, and a (meth)acryloyl group is particularly preferred.

In the polymer chain according to the invention, for example, a free radical (a polymerization initiating radical or a propagating radical in the process of polymerization of the polymerizable compound) is added to the crosslinkable functional group to cause an addition-polymerization between the polymer chains directly or through a polymerization chain of the polymerizable compound, as a result, crosslinkage is formed between the polymer chains to effect curing. Alternatively, an atom (for example, a hydrogen atom on the carbon atom adjacent to the crosslinkable functional group) in the polymer chain is withdrawn by a free radical to produce a polymer radical and the polymer radicals combine with each other to form crosslinkage between the polymer chains to effect curing.

The content of the crosslinkable group (content of the radical polymerizable unsaturated double bond determined by iodine titration) in the polymer chain for use in the invention is preferably from 0.01 to 10.0 mmol, more preferably from 0.05 to 9.0 mmol, most preferably from 0.1 to 8.0 mmol, based on 1 g of the star polymer.

According to the invention, specifically, the repeating unit having at least one crosslinkable group is preferably represented by formula (B3) shown below.

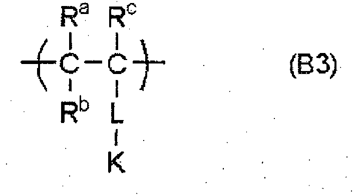

In formula (B3), R^{a} to R^{c} and L have the same meanings as those defined in formula (B1) respectively. K represents a crosslinkable group and its preferred embodiment is the same as described above. Specific examples of the repeating unit having a crosslinkable group for use in the invention are set forth below, but the invention should not be construed as being limited thereto.

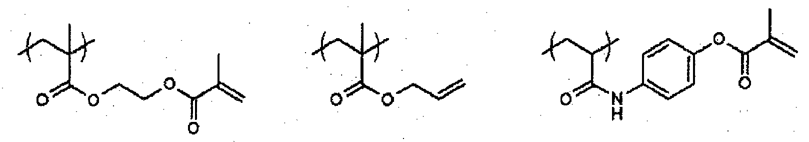

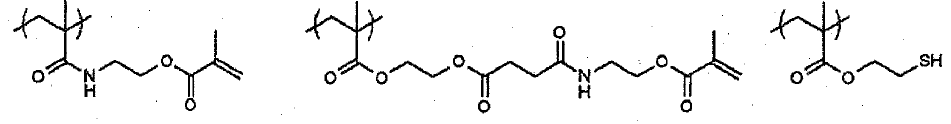

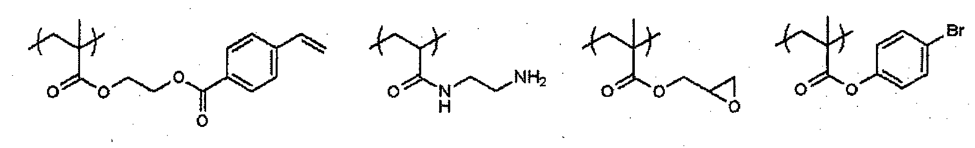

### (Other repeating unit)

The polymer chain of the star polymer for use in the invention may be a polymer chain of a copolymer containing a repeating unit (hereinafter, simply referred to as an "other repeating unit" in some cases) other than the repeating units described above. As the other repeating unit, repeating units derived from conventionally known various monomers are exemplified.

The polymer chain for use in the invention may contain a polymerization unit of an alkyl or aryl ester of (meth)acrylic acid, a polymerization unit of a (meth)acrylamide or a derivative thereof, a polymerization unit of an α-hydroxymethylacrylate or a polymerization unit of a styrene derivative in addition to the polymerization unit having an acid group and the polymerization unit having a crosslinkable group described above.

The alkyl group of the alkyl ester of (meth)acrylic acid is preferably an alkyl group having from 1 to 5 carbon atoms or an alkyl group having from 2 to 8 carbon atoms and the substituent described above, and more preferably a methyl group. The aralkyl ester of (meth)acrylic acid includes, for example, benzyl (meth)acrylate.

The (meth)acrylamide derivative includes, for example, N-isopropylacrylamide, N-phenylmethacrylamide, N-(4-methoxycarbonylphenyl)methacrylamide, N,N-dimethylacrylamide and morpholinoacrylamide.

The α-hydroxymethylacrylate includes, for example, ethyl α-hydroxymethylacrylate and cyclohexyl α-hydroxymethylacrylate. The styrene derivative includes, for example, styrene and 4-tert-butylstyrene.

Specific examples of the star polymer for use in the invention are set forth below, but the invention should not be construed as being limited thereto.

Polymer chains used in the specific examples are shown below.

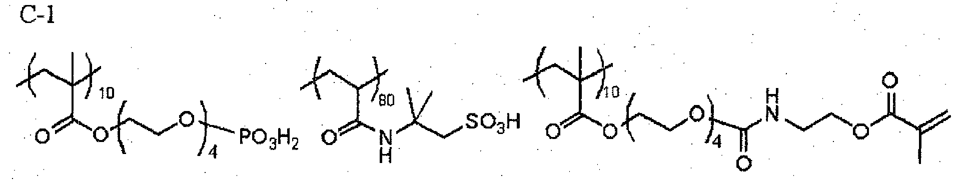

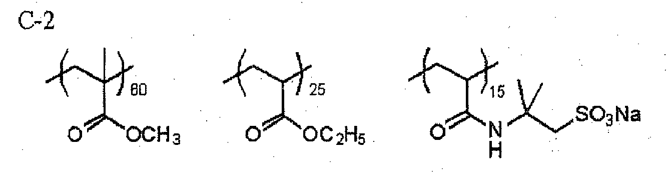

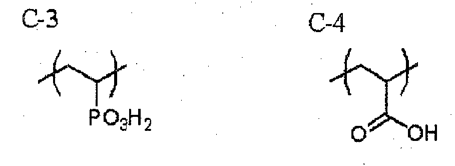

**TABLE 7: P-1 to P-50**

| Polymer No. | Central Skeleton | | Polymer Chain | Mw (x 10⁴) |
|---|---|---|---|---|
| | No. | % by Mole*¹ | | |
| P-1 | SA-3 | 0.5 | C-1 | 10 |
| P-2 | SA-4 | 0.5 | C-1 | 9.5 |
| P-3 | SA-5 | 0.5 | C-1 | 9.2 |
| P-4 | SA-6 | 0.5 | C-1 | 8.9 |
| P-5 | SA-7 | 0.5 | C-1 | 8.8 |
| P-6 | SA-8 | 0.5 | C-1 | 8.7 |
| P-7 | SB-030 | 0.5 | C-1 | 10.6 |
| P-8 | SB-065 | 0.5 | C-1 | 10.6 |
| P-9 | SB-210 | 0.5 | C-1 | 7.9 |
| P-10 | SB-009 | 0.5 | C-1 | 10.6 |
| P-11 | SB-036 | 0.5 | C-1 | 9.3 |
| P-12 | SB-099 | 0.5 | C-1 | 9.1 |
| P-13 | SB-204 | 0.5 | C-1 | 8.1 |
| P-14 | SB-002 | 0.5 | C-1 | 10.6 |
| P-15 | SB-007 | 0.5 | C-1 | 9.1 |
| P-16 | SB-079 | 0.5 | C-1 | 10.6 |
| P-17 | SB-093 | 0.5 | C-1 | 9.4 |
| P-18 | SB-094 | 0.5 | C-1 | 9.3 |
| P-19 | SB-100 | 0.5 | C-1 | 9.0 |
| P-20 | SB-101 | 0.5 | C-1 | 9.1 |
| P-21 | SB-156 | 0.5 | C-1 | 10.6 |
| P-22 | SB-170 | 0.5 | C-1 | 10.6 |
| P-23 | SB-205 | 0.5 | C-1 | 9.4 |
| P-24 | SB-206 | 0.5 | C-1 | 8.0 |
| P-25 | SB-207 | 0.5 | C-1 | 8.4 |
| P-26 | SB-208 | 0.5 | C-1 | 8.3 |
| P-27 | SB-209 | 0.5 | C-1 | 8.4 |
| P-28 | SB-212 | 0.5 | C-1 | 10.6 |
| P-29 | SC-002 | 0.5 | C-1 | 11.0 |
| P-30 | SC-044 | 0.5 | C-1 | 11.2 |
| P-31 | SC-037 | 0.5 | C-1 | 10.9 |
| P-32 | SC-086 | 0.5 | C-1 | 11.3 |
| P-33 | SC-093 | 0.5 | C-1 | 10.8 |
| P-34 | SC-100 | 0.5 | C-1 | 10.7 |
| P-35 | SE-056 | 0.5 | C-1 | 8.0 |
| P-36 | SE-058 | 0.5 | C-1 | 8.3 |
| P-37 | SE-059 | 0.5 | C-1 | 7.8 |
| P-38 | SE-085 | 0.5 | C-1 | 8.1 |
| P-39 | SE-014 | 0.5 | C-1 | 8.0 |
| P-40 | SE-020 | 0.5 | C-1 | 8.1 |
| P-41 | SE-243 | 0.5 | C-1 | 8.3 |
| P-42 | SE-051 | 0.5 | C-1 | 8.5 |
| P-43 | SE-055 | 0.5 | C-1 | 7.9 |
| P-44 | SE-057 | 0.5 | C-1 | 7.9 |
| P-45 | SE-063 | 0.5 | C-1 | 7.8 |
| P-46 | SE-069 | 0.5 | C-1 | 8.0 |
| P-47 | SE-097 | 0.5 | C-1 | 8.2 |
| P-48 | SE-103 | 0.5 | C-1 | 8.0 |
| P-49 | SE-109 | 0.5 | C-1 | 8.1 |
| P-50 | SE-115 | 0.5 | C-1 | 8.1 |

| | | | | |
|---|---|---|---|---|
| *1: Equivalent of SH group when the monomer is taken as 100. | | | | |

**TABLE 8: P-51 to P-63**

| Polymer No. | Central Skeleton | | Polymer Chain | Mw (x 10⁴) |
|---|---|---|---|---|
| | No. | % by Mole^{*1} | | |
| P-51 | SF-025 | 0.5 | C-1 | 8.4 |
| P-52 | SF-033 | 0.5 | C-1 | 8.5 |
| P-53 | SF-037 | 0.5 | C-1 | 8.4 |
| P-54 | SF-049 | 0.5 | C-1 | 8.6 |
| P-55 | SF-053 | 0.5 | C-1 | 8.7 |
| P-56 | SF-057 | 0.5 | C-1 | 8.1 |
| P-57 | SF-061 | 0.5 | C-1 | 8.4 |
| P-58 | SD-002 | 0.5 | C-1 | 8.4 |
| P-59 | SD-030 | 0.5 | C-1 | 8.5 |
| P-60 | SD-037 | 0.5 | C-1 | 8.4 |
| P-61 | SA-8 | 0.5 | C-2 | 8.4 |
| P-62 | SA-8 | 0.5 | C-3 | 8.5 |
| P-63 | SA-8 | 0.5 | C-4 | 8.4 |

**TABLE 9: P-64 to P-76**

| Polymer No. | Central Skeleton | | Polymer Chain | | | | Mw (x 10⁴) |
|---|---|---|---|---|---|---|---|
| | No. | % by Mole^{*1} | Hydrophilic Repeating Unit (A) | Adsorbing Repeating Unit (B) | Crosslinkable Repeating Unit (C) | Molar Ratio of (A)/(B)/(C) | |
| P-64 | SA-8 | 0.25 | 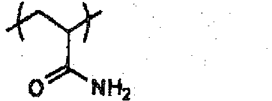 | - | - | 100/0/0 | 15.0 |
| P-65 | SA-8 | 0.5 | 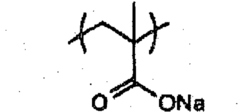 | - | - | 100/0/0 | 8.0 |
| P-66 | SA-8 | 1 | 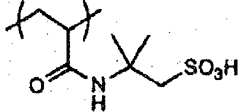 | - | - | 100/0/0 | 4.0 |
| P-67 | SA-8 | 0.25 | 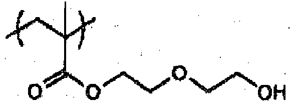 | - | - | 100/0/0 | 13.0 |
| P-68 | SA-8 | 0.5 | 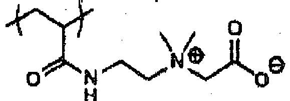 | - | - | 100/0/0 | 7.0 |
| P-69 | SA-8 | 1 | 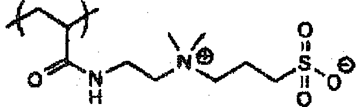 | - | - | 100/0/0 | 3.5 |
| P-70 | SA-8 | 0.25 | - | 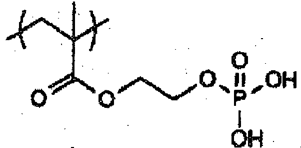 | - | 0/100/0 | 15.0 |
| P-71 | SA-8 | 0.5 | - | 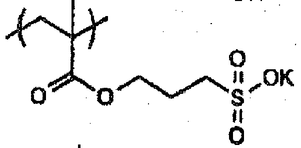 | - | 0/100/0 | 7.0 |
| P-72 | SA-8 | 1 | - | 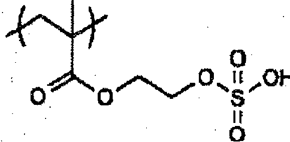 | - | 0/100/0 | 3.6 |
| P-73 | SA-8 | 0.25 | 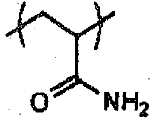 | 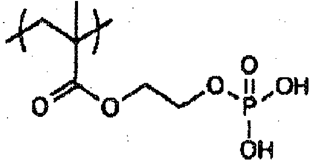 | - | 90/10/0 | 16.0 |
| P-74 | SA-8 | 0.5 | 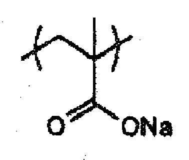 | 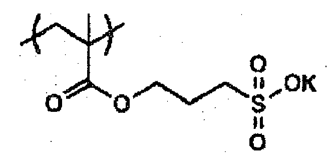 | - | 80/20/0 | 8.0 |
| P-75 | SA-8 | 1 | 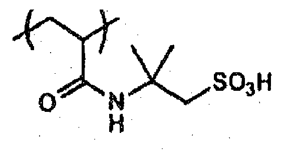 | 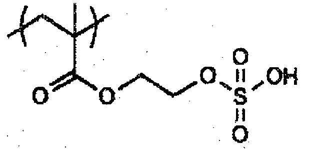 | - | 70/30/0 | 4.2 |
| P-76 | SA-8 | 0.25 | 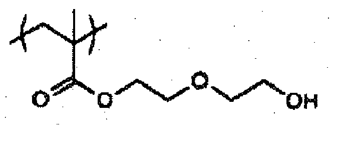 | 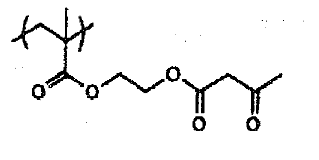 | - | 65/35/0 | 12.0 |

**TABLE 10: P-77 to P-89**

| Polymer No. | Central Skeleton | | Polymer Chain | | | | Mw (x 10⁴) |
|---|---|---|---|---|---|---|---|
| | No. | % by Mole^{*1} | Hydrophilic Repeating Unit (A) | Adsorbing Repeating Unit (B) | Crosslinkable Repeating Unit (C) | Molar Ratio of (A)/(B)/(C) | |
| P-77 | SA-8 | 0.5 | 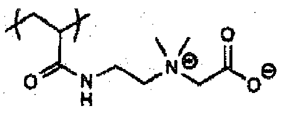 | 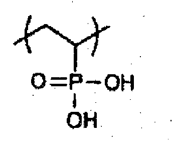 | - | 60/40/0 | 7.9 |
| P-78 | SA-8 | 1 | 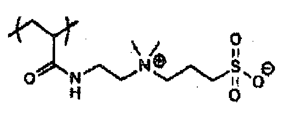 | 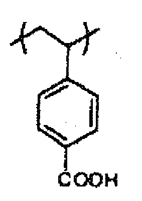 | - | 55/45/0 | 3.6 |
| P-79 | SA-8 | 0.25 | 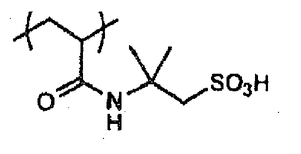 | 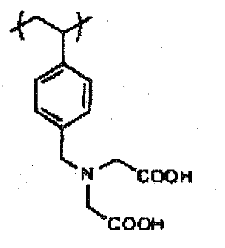 | - | 80/20/0 | 14.5 |
| P-80 | SA-8 | 0.5 | 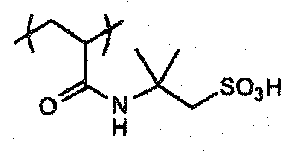 | 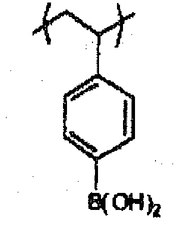 | - | 80/20/0 | 8.6 |
| P-81 | SA-8 | 1 | 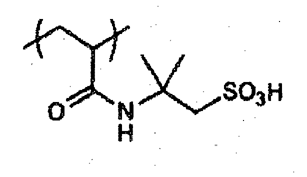 | 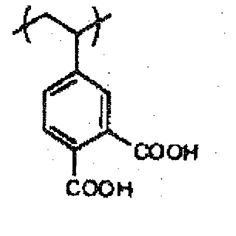 | - | 80/20/0 | 3.8 |
| P-82 | SA-8 | 0.25 | 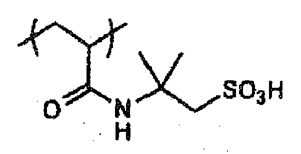 | 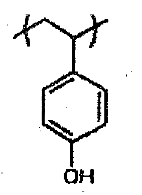 | - | 80/20/0 | 13.5 |
| P-83 | SA-8 | 0.5 | 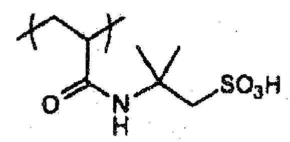 | 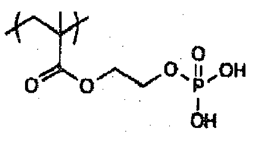 | 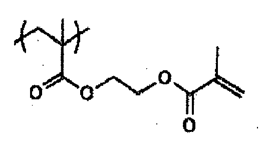 | 80/10/10 | 7.5 |
| P-84 | SA-8 | 1 | 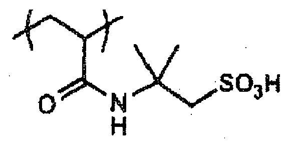 | 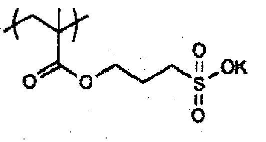 | 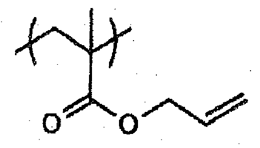 | 80/10/10 | 3.6 |
| P-85 | SA-8 | 0.25 | 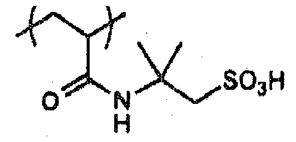 | 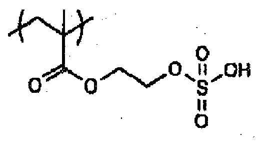 | 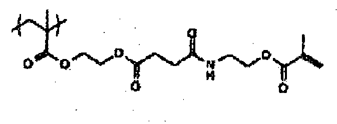 | 80/10/10 | 17.3 |
| P-86 | SA-8 | 0.5 | 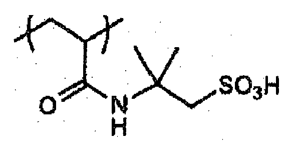 | 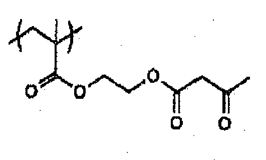 | 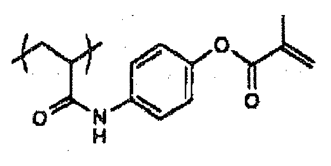 | 80/10/10 | 6.5 |
| P-87 | SA-8 | 1.5 | 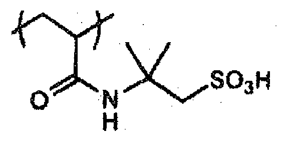 | 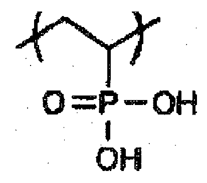 | 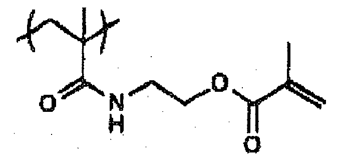 | 80/10/10 | 4.2 |
| P-88 | SA-8 | 0.25 | 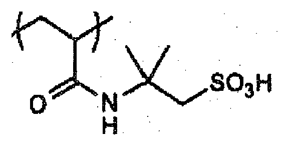 | 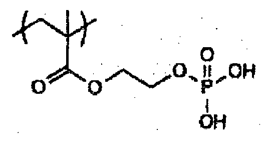 | 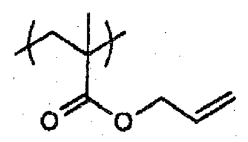 | 80/10/10 | 14.0 |
| P-89 | SA-8 | 0.5 | 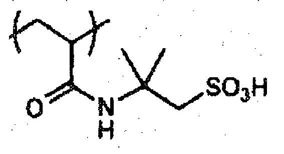 | 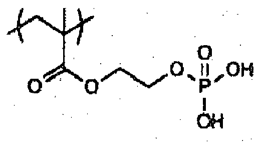 | 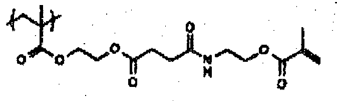 | 80/10/10 | 7.0 |

**TABLE 11: P-90 to P-96**

| Polymer No. | Central Skeleton | | Polymer Chain | | | | Mw (x 10⁴) |
|---|---|---|---|---|---|---|---|
| | No. | % by Mole ^{*1} | Hydrophilic Repeating Unit (A) | Adsorbing Repeating Unit (B) | Crosslinkable Repeating Unit (C) | Molar Ratio of (A)/(B)/(C) | |
| P-90 | SA-8 | 1.5 | 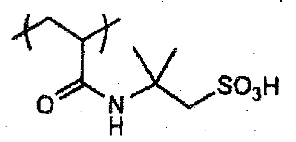 | - | 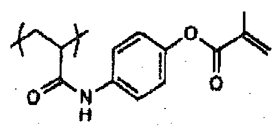 | 80/0/20 | 3.0 |
| P-91 | SA-8 | 0.25 | 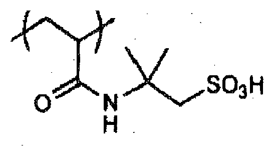 | 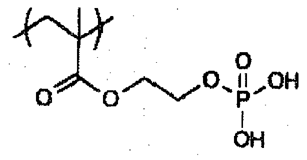 | 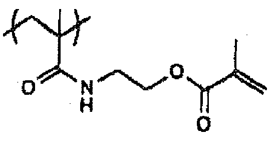 | 80/5/15 | 15 |
| P-92 | SA-8 | 0.5 | 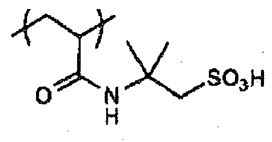 | 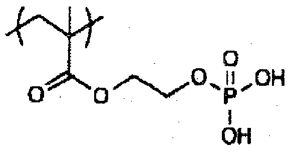 | 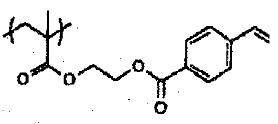 | 80/7/13 | 7.8 |
| P-93 | SA-8 | 1.5 | 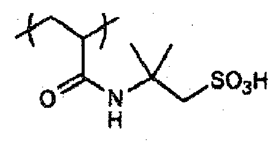 | 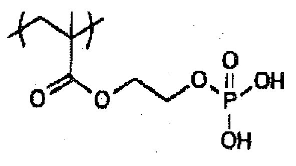 | 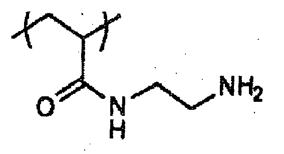 | 80/9/11 | 4.5 |
| P-94 | SA-8 | 0.25 | 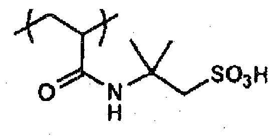 | 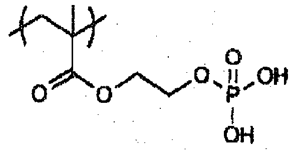 | 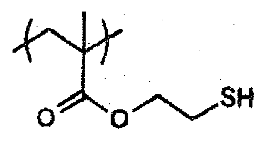 | 80/11/9 | 15 |
| P-95 | SA-8 | 0.5 | 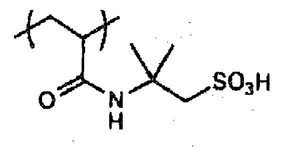 | 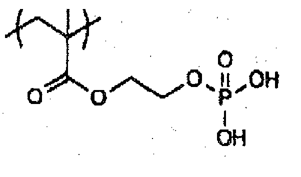 | 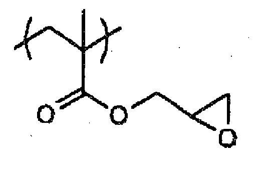 | 80/13/7 | 8.0 |
| P-96 | SA-8 | 1.5 | 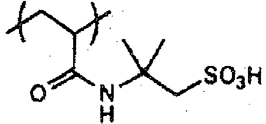 | 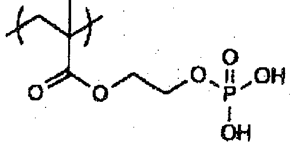 | 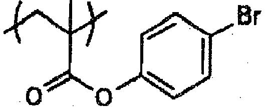 | 80/15/5 | 3.7 |

**TABLE 12: P-97 to P-100**

| Polymer No. | Central Skeleton | | Polymer Chain | Mw (x 10⁴) |
|---|---|---|---|---|
| | No.^{*3} | % by Mole^{*2} | | |
| P-97 | SG-1 | 0.5 | C-1 | 7.0 |
| P-98 | SG-2 | 0.5 | C-1 | 9.0 |
| P-99 | SG-3 | 0.5 | C-1 | 9.0 |
| P-100 | SG-4 | 0.5 | C-1 | 6.0 |

| | | | | |
|---|---|---|---|---|
| *2: (Equivalent of central skeleton x number of branched chain) when the monomer is taken as 100. *3: Structures of SG-1 to SG-4 are shown below. | | | | |

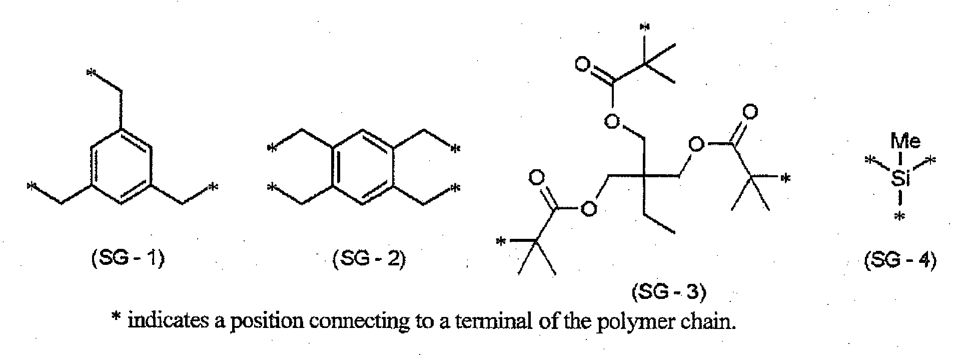

The star polymer according to the invention can be synthesized by radical polymerization using a multifunctional thiol, living radical polymerization using a multivalent dithiocarbamate compound, radical polymerization using a multivalent radical initiator or anion polymerization using an anion polymerization initiator having plural anion-generating sites.

The weight average molecular weight (Mw) of the star polymer according to the invention is preferably from 5,000 to 500,000, more preferably from 10,000 to 250,000, and particularly preferably from 20,000 to 150,000. In the range described above, the development property and printing durability are improved.

The star polymers according to the invention may be used only one kind or two or more kinds in combination. Also, it can be used together with a conventional straight-chain type binder.

### [Undercoat layer]

The undercoat layer according to the invention means a layer provided between the support and the image-recording layer of the lithographic printing plate precursor.

In the case of using the star polymer in the undercoat layer according to the invention, the star polymer is ordinarily used by diluted it with a solvent. The solvent includes water and an organic solvent, for example, methanol, ethanol, propanol, isopropanol, ethylene glycol, hexylene glycol, THF, DMF, 1-methoxy-2-propanol, dimethylacetamide or dimethylsulfoxide, and is particularly preferably water or an alcohol. The solvents may be used as a mixture.

The concentration of a coating solution for undercoat layer is preferably from 0.001 to 10% by weight, more preferably from 0.01 to 5% by weight, and still more preferably from 0.05 to 1% by weight. The undercoat layer may contain a surfactant described hereinafter, if desired.

The coating amount (solid content) of the undercoat layer is preferably from 0.1 to 100 mg/m², and more preferably from 3 to 30 mg/m².

Various methods can be used for the coating of the undercoat layer. Examples of the method include bar coater coating, spin coating, spray coating, curtain coating, dip coating, air knife coating, blade coating and roll coating.

The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazabicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethylimmodiacetic acid) in addition to the star polymer described above in order to prevent the occurrence of stain due to the lapse of time.

The content of the star polymer according to the invention in the undercoat layer is preferably from 5 to 100% by weight, more preferably from 10 to 100% by weight, particularly preferably from 15 to 100% by weight, based on the total solid content of the undercoat layer.

### [Support]

A support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the surface treatments, methods described in Paragraph Nos. [0241] to [0245] of JP-2007-206217 are preferably used.

The support subjected to the roughening treatment and anodizing treatment may be subjected to a hydrophilizing treatment in order to increase hydrophilicity of the surface of support. According to the invention, the support is subjected to a hydrophilizing treatment with a solution containing the star polymer described above to provide a layer containing the star polymer between the support and the image-recording layer. In this case, the undercoat layer may not be necessarily provided.

In the case of conducting the hydrophilizing treatment of the support with a solution containing the star polymer, the support is treated by immersing it in a solution formed by diluting the star polymer with a solvent. The solvent includes water and an organic solvent, for example, methanol, ethanol, propanol, isopropanol, ethylene glycol, hexylene glycol, THF, DMF, 1-methoxy-2-propanol, dimethylacetamide or dimethylsulfoxide, and is particularly preferably water or an alcohol. The solvents may be used as a mixture. The content of the star polymer in the solution used in the immersion treatment is preferably from 0.001 to 10% by weight, and more preferably from 0.01 to 3% by weight. The immersion time is preferably from 5 seconds to 10 minutes, and more preferably from 60 seconds to 2 minutes. The solution temperature at the immersion treatment is preferably from 20 to 100°C, and more preferably from 50 to 90°C.

The attachment amount (solid content) of the star polymer onto the surface of support is preferably from 0.1 to 100 mg/m², and more preferably from 3 to 30 mg/m².

The hydrophilizing treatment without using the star polymer includes, for example, an alkali metal silicate treatment method wherein the support is subjected to an immersion treatment or an electrolytic treatment in an aqueous solution, for example, of sodium silicate, a method of treating with potassium fluorozirconate, a method of treating with polyvinylphosphonic acid and a method of treating with polyacrylic acid. A method of immersion treatment in an aqueous solution, for example, of sodium silicate or a method of immersion treatment in an aqueous polyvinylphosphonic acid solution is preferably used.

The center line average roughness of the support is preferably from 0.10 to 1.2 µm. In the range described above, good adhesion property to the image-recording layer and good printing durability and good resistance to stain are achieved.

The color density of the support is preferably from 0.15 to 0.65 in terms of the reflection density value. In the range described above, good image-forming property due to prevention of halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

### [Image-recording layer]

The image-recording layer according to the invention is a negative image-recording layer wherein the imagewise exposed area remains after development to from an image area at printing. In particular, an image-recording layer of polymerization type containing (B) a polymerization initiator and (C) a polymerizable compound is preferred. (B) Polymerization initiator

The image-recording layer contains a polymerization initiator (hereinafter, also referred to as an initiator compound). In the invention, a radical polymerization initiator is preferably used.

As the initiator compound in the invention, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, opium salt compound, trihalomethyl compound and metallocene compound is preferred, and the hexaarylbiimidazole compound or the onium salt compound is particularly preferred. Two or more kinds of the polymerization initiators may be appropriately used in combination.

The hexaarylbiimidazole compound includes, for example, lophine dimers described in European Patents 24,629 and 107,792 and U.S. Patent 4,410,621, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphonyl)-4,4',5,5'-tetraphenylbiimidazole.

The hexaarylbiimidazole compound is particularly preferably used together with a sensitizing dye having an absorption maximum in a wavelength range from 300 to 450 nm.

The onium salt compound preferably used in the invention includes a sulfonium salt, an iodonium salt and a diazonium salt. Particularly, a diaryliodonium salt or a triarylsulfonium salt is preferably used. The onium salt compound is particularly preferably used together with an infrared absorbing agent having an absorption maximum in a wavelength range from 750 to 1,400 nm.

In addition, polymerization initiators described in Paragraph Nos. [0071] to [0129] of JP-A-2007-206217 are preferably used.

The polymerization initiators are preferably used individually or in combination of two or more thereof according to the invention.

The amount of the polymerization initiator used in the image-recording layer according to the invention is preferably from 0.01 to 20% by weight, more preferably from 0.1 to 15% by weight, still more preferably from 1.0 to 10% by weight, based on the total solid content of the image-recording layer. (C) Polymerizable compound

The polymerizable compound for use in the image-recording layer according to the invention is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group, with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphoric acid, styrene, vinyl ether or the like can also be used. These compounds are described in references including JP-T-2006-508380 (the term "JP-T" as used herein means a published Japanese translation of a PCT patent application), JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708 (the term "JP-B" as used herein means an "examined Japanese patent publication").

CH₂=C(R⁴)COOCH₂CH(R⁵)OH (A)

wherein R⁴ and R⁵ each independently represents H or CH₃.

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Details of the method of using the polymerizable compound, for example, selection of the structure, individual or combination use or an amount added, can be appropriately determined in accordance with the characteristic design of the final lithographic printing plate precursor. The polymerizable compound is used preferably in a range from 5 to 75% by weight, more preferably in a range from 25 to 70% by weight, particularly preferably in a range from 30 to 60% by weight, based on the total solid content of the image-recording layer.

### (D) Binder polymer

In the image-recording layer according to the invention, a binder polymer can be used for the purpose of improving film strength of the image-recording layer. The binder polymer which can be used in the invention can be selected from those heretofore known without restriction, and a polymer having a film-forming property is preferred. Among them, an acrylic resin, a polyvinyl acetal resin and a polyurethane resin are preferred.

As the binder polymer preferable for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group, an allyl group or a styryl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the development property to the image-recording layer. In particular, coexistence of the crosslinkable group and the hydrophilic group makes it possible to maintain good balance between the printing durability and the development property.

The hydrophilic group includes, for example, a hydroxy group, a carboxyl group, an alkylene oxide structure, an amino group, an ammonium group, an amido group, a sulfo group and a phosphoric acid group. Among them, an alkylene oxide structure containing from 1 to 9 alkylene oxide units each having 2 or 3 carbon atoms is preferred. In order to introduce a hydrophilic group into the binder polymer, a monomer having the hydrophilic group may be copolymerized.

According to the invention, for example, in the case of development with an aqueous alkaline solution, the hydrophilic group is particularly preferably an acid group, for example, a carboxylic acid group or a sulfonic acid group. In the case of conducting the development with dampening water and/or printing ink on a printing machine, the hydrophilic group is particularly preferably that having a polyoxyethylene structure.

In order to control the ink receptivity, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate may be copolymerized.

The weight average molecular weight (Mw) of the binder polymer according to the invention is preferably 2,000 or more, more preferably 5,000 or more, and still more preferably from 10,000 to 300,000.

According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.

The content of the binder polymer is preferably from 5 to 90% by weight, more preferably from 5 to 80% by weight, still more preferably from 10 to 70% by weight, based on the total solid content of the image-recording layer.

Specific examples of the binder polymer (for the image-recording layer of on-press development type and for the image-recording layer to be developed with an aqueous alkaline solution) used in the invention are set forth below, but the invention should not be construed as being limited thereto.

As the binder polymer for the image-recording layer of on-press development type, (1) to (11) shown below are exemplified.

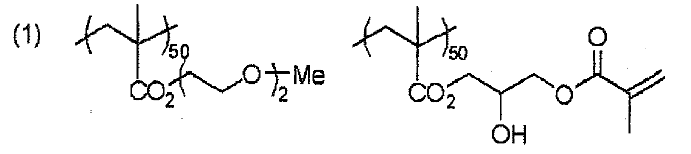

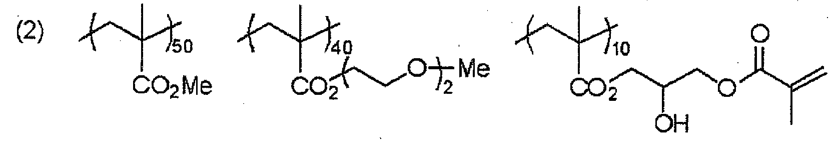

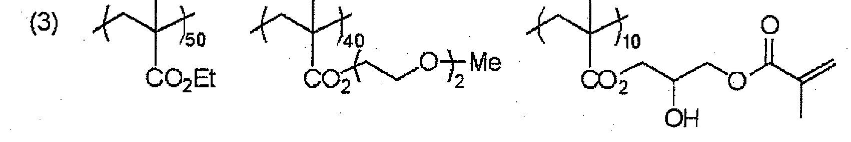

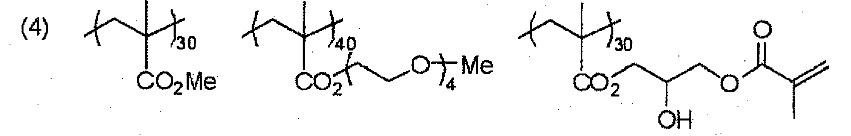

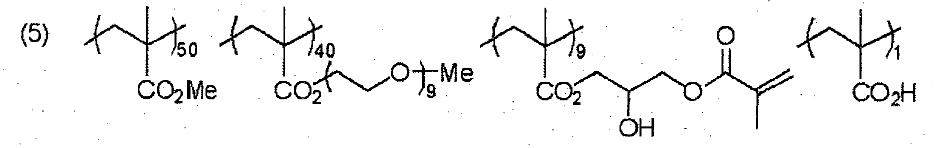

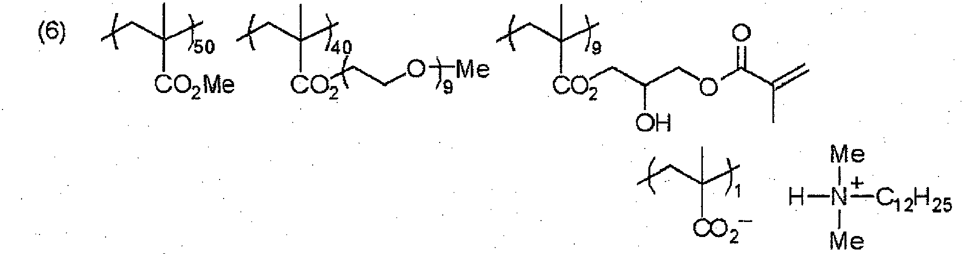

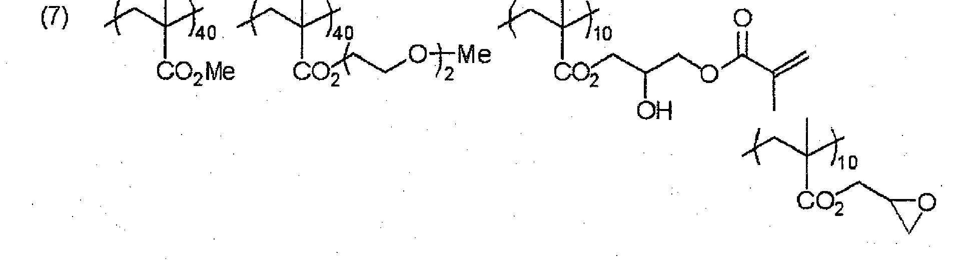

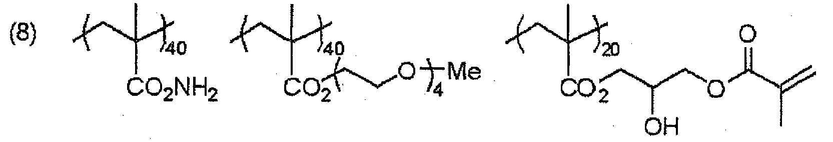

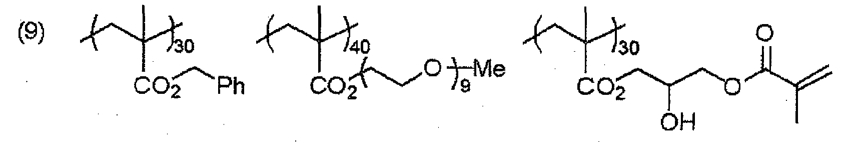

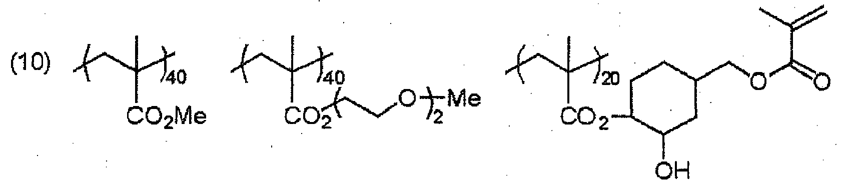

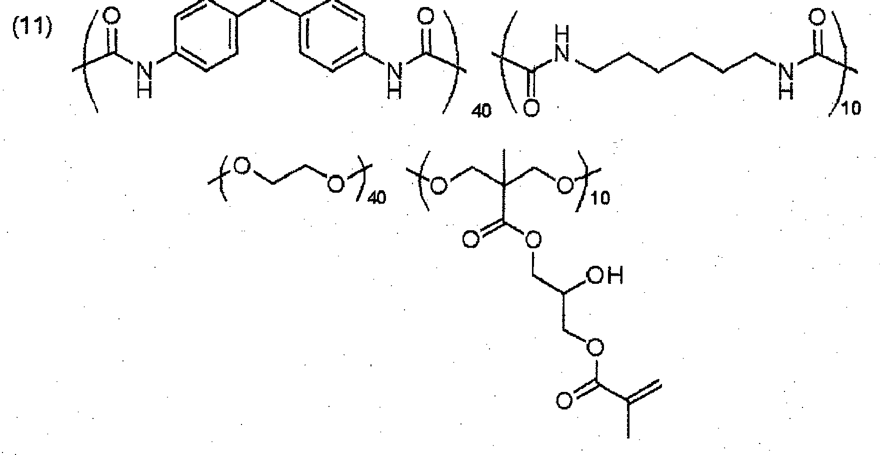

As the binder polymer for the image-recording layer to be developed with an aqueous alkaline solution, for example, alkali-soluble binders described in Paragraph Nos. [0119] to [0123] of JP-A-2008-64786 are used.

### (Sensitizing dye)

The image-recording layer according to the invention preferably contains a sensitizing dye. The sensitizing dye can be used without particular limitation as far as it absorbs light at the image exposure to form the excited state and provides energy to the polymerization initiator described above with electron transfer, energy transfer or heat generation thereby improving the polymerization initiation function. Particularly, a sensitizing dye having an absorption maximum in a wavelength range from 300 to 450 mn or from 750 to 1,400 nm is preferably used.

Examples of the sensitizing dye having an absorption maximum in a wavelength range from 300 to 450 nm include merocyanine dyes, benzopyranes, coumarins, aromatic ketones, anthracenes, styryls and oxazoles.

Of the sensitizing dyes having an absorption maximum in a wavelength range from 300 to 450 nm, a dye represented by formula (2) shown below is more preferable in view of high sensitivity.

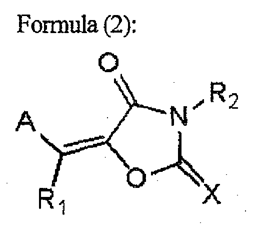

In formula (2), A represents an aryl group which may have a substituent or a heteroaryl group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (2) will be described in more detail below. R₁, R₂ and R₃ each independently represents a monovalent non-metallic atomic group, preferably a hydrogen atom, a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group or a halogen atom.

Specific examples of such a sensitizing dye preferably used include compounds described in Paragraph Nos. [0047] to [0053] of JP-A-2007-58170, Paragraph Nos. [0036] to [0037] of JP-A-2007-93866 and Paragraph Nos. [0042] to [0047] of JP-A-2007-72816.

Further, sensitizing dyes described in JP-A-2006-189604, JP-A-2007-171406, JP-A-2007-206216, JP-A-2007-206217, JP-A-2007-225701, JP-A-2007-225702, JP-A-2007-316582 and JP-A-2007-328243 are also preferably used.

The sensitizing dyes may be used only one kind or in combination of two or more kinds thereof.

Next, the sensitizing dye having an absorption maximum in a wavelength range from 750 to 1,400 (hereinafter, also referred to as an "infrared absorbing agent") preferably used in the invention is described in detail below. The infrared absorbing agent used is preferably a dye or a pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formulae (a) shown below are exemplified.

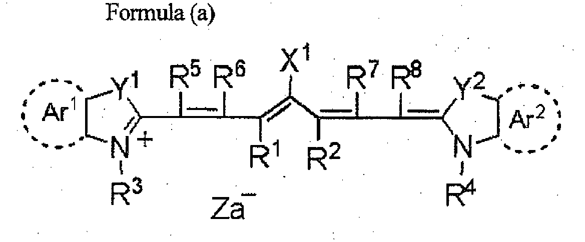

In formula (a), X¹ represents a hydrogen atom, a halogen atom, -N(R⁹)(R¹⁰), -X²-L¹ or a group shown below. R⁹ and R¹⁰, which may be the same or different, each represents an aromatic hydrocarbon group having from 6 to 10 carbon atoms, which may have a substituent, an alkyl group having from 1 to 8 carbon atoms or a hydrogen atom or R⁹ and R¹⁰ may be combined with each other to from a ring, and preferably represents a phenyl group. X² represents an oxygen atom or a sulfur atom, L¹ represents a hydrocarbon group having from 1 to 12 carbon atoms, an aromatic cyclic group containing a hetero atom or a hydrocarbon group having from 1 to 12 carbon atoms and containing a hetero atom. The hetero atom as used herein means a nitrogen atom, a sulfur atom, an oxygen atom, a halogen atom or a selenium atom. In the group shown below, Xa- has the same meaning as Za⁻ defined hereinafter. R^{a} represents a hydrogen atom or a substituent selected from an alkyl group, an aryl group, a substituted or unsubstituted amino group and a halogen atom.

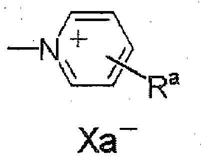

R¹ and R² each independently represents a hydrocarbon group having from 1 to 12 carbon atoms. In view of the reservation stability of a coating solution for image-recording layer, it is preferred that R¹ and R² each represents a hydrocarbon group having two or more carbon atoms. Also, R¹ and R² may be combined with each other to form a ring and in case of forming the ring, to form a 5-membered or 6-membered ring is particularly preferred.

Ar¹ and Ar², which may be the same or different, each represents an aryl group which may have a substituent Preferable examples of the aryl group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (a) has an anionic substituent in the structure thereof and the neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for image-recording layer.

Specific examples of the cyanine dye represented by formula (a) preferably used in the invention include compounds described in Paragraph Nos. [0017] to [0019] of JP-A-2001-133969, Paragraph Nos. [0012] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and particularly preferably compounds described in Paragraph Nos. [0035] to [0043] of JP-A-2007-90850.

Further, compounds described in Paragraph Nos. [0008] to [0009] of JP-A-5-5005 and Paragraph Nos. [0022] to [0025] of JP-A-2001-222101 are also preferably used.

The infrared absorbing dyes may be used only one kind or in combination of two or more kinds thereof and may be used together with an infrared absorbing agent other than the infrared absorbing dye, for example, a pigment. As the pigment, compounds described in Paragraph Nos. [0072] to [0076] of JP-A-2008-195018 are preferred.

The amount of the sensitizing dye added is preferably from 0.05 to 30% by weight, more preferably from 0.1 to 20% by weight, most preferably from 0.2 to 10% by weight, based on the total solid content of the image-recording layer.

### (F) Other components of image-recording layer

Into the image-recording layer according to the invention, various additives can be further incorporated, if desired. Examples of the additive include a surfactant for progressing the development property and improving the surface state of coated layer, a microcapsule for providing good compatibility between the development property and printing durability, a hydrophilic polymer for improving the development property and dispersion stability of microcapsule, a coloring agent or print-out agent for visually distinguishing the image area from the non-image area, a polymerization inhibitor for preventing undesirable thermal polymerization of the radical polymerizable compound during the production or preservation of the image-recording layer, a hydrophobic low molecular weight compound, for example, a higher fatty acid derivative for avoiding polymerization inhibition due to oxygen, a fine inorganic particle for increasing strength of the cured layer in the image area, a fine organic particle, a hydrophilic low molecular weight compound for improving the development property, a co-sensitizer or chain transfer agent for increasing sensitivity, and a plasticizer for improving plasticity. As the additives, known compounds are used and, for example, compounds described in Paragraph Nos. [0161] to [0215] of JP-A-2007-206217, Paragraph No. [0067] of JP-T-2005-509192, Paragraph Nos. [0023] to [0026] and [0059] to [0066] of JP-A-2004-310000 are used. With respect to the surfactant, surfactants which may be added to a developer described hereinafter may be used.

The image-recording layer preferably contains a chain transfer agent. The chain transfer agent is defined, for example, in Kobunshi Jiten (Polymer Dictionary), Third Edition, pages 683 to 684, edited by The Society of Polymer Science, Japan (2005). As the chain transfer agent, for example, compounds having SH, PH, SiH or GeH in their molecules are used. The compound donates a hydrogen to a low active radical species to generate a radical or is oxidized and then deprotonized to generate a radical.

In the image-recording layer according to the invention, a thiol compound (for example, a 2-mercaptobenzimidazole, a 2-mercaptobenzothiazole, a 2-mereaptobenzoxazole, a 3-mercaptotriazole or a 5-mercaptotetrazole) is preferably used.

The content of the chain transfer agent is preferably from 0.01 to 20 parts by weight, more preferably from 1 to 10 parts by weight, most preferably from 1 to 5 parts by weight, per 100 parts by weight of the total solid content of the image-recording layer.

The image-recording layer according to the invention may contain a hydrophilic low molecular weight compound in order to improve the on-press development property. As the hydrophilic low molecular weight compound, a polyol compound, an organic sulfate compound, an organic sulfonate compound and a betaine compound are preferred.

Specific examples of the organic sulfonate compound include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphthalenedisulfonate or trisodium 1,3,6-naphthalenetrisulfonate. The salt may also be a potassium salt or a lithium salt.

The organic sulfate compound includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt.

As the betaine compound, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

The amount of the hydrophilic low molecular weight compound added to the image-recording layer is preferably from 0.5 to 20% by weight, more preferably from 1 to 10% by weight, based on the total solid content of the image-recording layer.

In order to improve the ink receptivity, an oil-sensitizing agent, for example, a phosphonium compound, a nitrogen-containing low molecular weight compound or an ammonium group-containing polymer can be used in the image-recording layer according to the invention. The oil-sensitizing agent is effective in case of the image-recording layer capable of undergoing on-press development.
In particular, in the case where an inorganic stratiform compound is incorporated into a protective layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetraphenylphosphonium bromide and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used.

Specific examples the nitrogen-containing low molecular weight compound include tetrabutylammonium hexafluorophosphate, dodecyltrimethylammonium p-toluenesulfonate, benzyltriethylammonium hexafluorophosphate, benzyldimethyloctylammonium hexafluorophosphate and benzyldimethyldodecylammonium hexafluorophosphate.

As the ammonium group-containing polymer, polymers described in JP-A-2009-208458, for example, 2-(trimethylammonio)ethyl methacrylate p-toluenesulfonate/3,6-dioxaheptyl methacrylate copolymer, 2-(trimethylammonio)ethyl methacrylate hexafluorophosphate /2-ethylhexyl methacrylate copolymer or 2-(butyldimethylammonio)ethyl methacrylate hexafluorophosphate/3,6-dioxaheptyl methacrylate copolymer are exemplified.

The content of the oil-sensitizing agent is preferably from 0.01 to 30.0% by weight, more preferably from 0.1 to 15.0% by weight, still more preferably from 1 to 10% by weight, based on the total solid content of the image-recording layer.

### (Formation of image-recording layer)

The image-recording layer according to the invention is formed by dispersing or dissolving each of the necessary components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ -butyrolactone, but the invention should not be construed as being limited thereto. The solvents may be used individually or as a mixture. The solid content concentration of the coating solution is preferably from 1 to 50% by weight.

The coating amount (solid content) of the image-recording layer on the support after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### [Protective layer]

In the lithographic printing plate precursor according to the invention, a protective layer (oxygen-blocking layer) is preferably provided on the image-recording layer in order to prevent diffusion and penetration of oxygen which inhibits the polymerization reaction at the time of exposure. As a material for use in the protective layer, any water-soluble polymer and water-insoluble polymer can be appropriately selected to use. The polymers may be used in combination of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified. Among them, a water-soluble polymer compound relatively excellent in crystallizability is preferably used. Specifically, when polyvinyl alcohol is used as a main component, the particularly preferred results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. Examples of the polyvinyl alcohol include those having a hydrolysis degree of 69.0 to 100% by mole and a polymerization repeating unit number of 300 to 2,400. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and L-8 (produced by Kuraray Co., Ltd.). The polyvinyl alcohols can be used individually or as a mixture. According to a preferred embodiment, the content of polyvinyl alcohol in the protective layer is from 20 to 95% by weight, and more preferably from 30 to 90% by weight.

Also, known modified polyvinyl alcohol can be preferably used. Particularly, an acid-modified polyvinyl alcohol having a carboxylic acid group or a sulfonic acid group is preferably used. Specifically, modified polyvinyl alcohols described in JP-A-2005-250216 and JP-A-2006-259137 are preferably exemplified.

When the polyvinyl alcohol is used as a mixture with other material, as the other material mixed, a modified polyvinyl alcohol, polyvinyl pyrrolidone or a modified product thereof is preferred from the viewpoint of the oxygen-blocking property and removability by development. The content thereof in the protective layer is ordinarily from 3.5 to 80% by weight, preferably from 10 to 60% by weight, and more preferably from 15 to 30% by weight.

As other component of the protective layer, glycerin, dipropylene glycol or the like can be added in an amount corresponding to several % by weight of the material for the protective layer to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount of several % by weight of the material for the protective layer.

Further, it is also preferred to incorporate an inorganic stratiform compound into the protective layer of the lithographic printing plate precursor according to the invention for the purpose of improving the oxygen-blocking property and property for protecting the surface of image-recording layer. Of the inorganic stratiform compounds, fluorine-based swellable synthetic mica, which is a synthetic inorganic stratiform compound, is particularly useful. Specifically, inorganic stratiform compounds described in JP-A-2005-119273 are preferably exemplified.

Further, protective layers described in U.S. Patent 3,458,311, JP-B-55-49729, JP-A-2008-15503, JP-A-2008-89916 and Paragraph Nos. [0211] to [0261] of JP-2008-139813 are preferably used.

The coating amount of the protective layer is preferably in a range from 0.05 to 10 g/m² in terms of the coating amount after drying. When the protective layer contains the inorganic stratiform compound, it is more preferably in a range from 0.1 to 5 g/m², and when the protective layer does not contain the inorganic stratiform compound, it is more preferably in a range from 0.5 to 5 g/m².

### [Backcoat layer]

A backcoat layer can be provided on the back surface of the support after conducting the surface treatment to the surface of support or forming the undercoat layer on the surface of support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting materials are inexpensive and easily available.

### [Plate making method]

The plate making method of the lithographic printing plate precursor according to the invention is preferably a method including at least a step of imagewise exposing the lithographic printing plate precursor (hereinafter, also referred to as a "exposure step") and a step of development processing of the lithographic printing plate precursor with a processing solution (hereinafter, also referred to as a "development step").

### <Exposure step>

Although the lithographic printing plate precursor for use in the invention can be subjected to image recording by a method of scanning exposure of digital data by laser, for example, visible laser or infrared laser or a method of exposing through a transparent original having an image recorded using a light source, for example, a halogen lamp or a high pressure mercury lamp, the method of scanning exposure of digital data by laser, for example, visible laser or infrared laser is preferred.

The wavelength of the exposure light source is preferably from 300 to 450 nm or from 750 to 1,400 nm. In case of exposing with light of 300 to 450 nm, the lithographic printing plate precursor having an image-recording layer containing a sensitizing dye having an absorption maximum in such a wavelength range is used. In case of exposing with light of 750 to 1,400 nm, the lithographic printing plate precursor containing an infrared absorbing agent which is a sensitizing dye having an absorption maximum in such a wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

### <Development step>

After the exposure, the lithographic printing plate precursor for use in the invention is developed with water or an aqueous solution having pH from 2 to 14 (processing with developer) or developed with dampening water and ink on a printing machine (on-press development).

### (Processing with developer)

The processing with developer is ordinarily practiced according to the following steps: (1) removing the non-image area with a developer, (2) conducting gumming solution treatment and (3) drying in a drying step. Although the lithographic printing plate precursor for use in the invention can be developed according to the conventional steps described above (conventional development), it is preferred to conduct steps (1) and (2) simultaneously (simple development). In any of the development methods, a water washing step for removing a protective layer may be provided before step (1). The development of step (1) is conducted according to a conventional manner at temperature approximately from 0 to 60°C, preferably from 15 to 40°C, using, for example, a method wherein the imagewise exposed lithographic printing plate precursor is immersed in a developer and rubbed with a brush or a method wherein a developer is sprayed to the imagewise exposed lithographic printing plate precursor by a spray and the lithographic printing plate precursor is rubbed with a brush.

In case of the conventional development, a water washing step for removing an excess developer may be provided between step (1) and step (2). The developer used in step (1) is preferably a known alkali developer.

In case of the simple development, it is preferred that after the development and gumming treatment, an excess developer is removed using a squeeze roller and then drying is conducted.

The developer for use in the simple development is an aqueous solution having pH from 2 to 11. An aqueous solution containing water as the main component (containing 60% by weight or more of water) is preferred. In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is preferably from 5 to 10.7, more preferably from 6 to 10.5, and most preferably from 7.5 to 10.3.

The anionic surfactant for use in the developer for the simple development is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylalkylsulfonic acid salts, polyoxyethylene alkylsulfophenyl ether salts, N-methylalkyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer for the simple development is not particularly limited and conventionally known cationic surfactants can be used. Examples of the cationic surfactant include alkylamine salts, quaternary ammonium salts, alkylimidazolinium salts, polyoxyethylene alkyl amine salts and polyethylene polyamine derivatives.

The nonionic surfactant for use in the developer for the simple development is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred and alkyl-substituted or unsubstituted phenol ethylene oxide adducts and alkyl-substituted or unsubstituted naphthol ethylene oxide adducts are more preferred.

The amphoteric surfactant for use in the developer for the simple development is not particularly limited and includes, for example, amine oxide type, for example, alkyldimethylamine oxide, betaine type, for example, alkyl betaine, and amino acid type, for example, sodium salt of alkylamino fatty acid. In particular, alkyldimethylamine oxide which may have a substituent, alkyl carboxy betaine which may have a substituent and alkyl sulfo betaine which may have a substituent are preferably used. Specific examples of the amphoteric surfactant include compounds described in Paragraph Nos. [0255] to [0278] and compounds represented by formula (2) in Paragraph No. [0256] of JP-A-2008-203359, compounds described in Paragraph Nos. [0028] to [0052] and compounds represented by formulae (I), (II) and (VI) in Paragraph No. [0028] of JP-A-2008-276166 and compounds described in Paragraph Nos. [0022] to [0029] of JP-A-2009-47927.

Two or more of the surfactants may be used in combination. The content of the surfactant in the developer is preferably from 0.01 to 20% by weight, and more preferably from 0.1 to 10% by weight.

The water-soluble polymer compound for use in the developer for the simple development includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer, polyvinylsulfonic acid or a salt thereof and polystyrenesulfonic acid or a salt thereof.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

Into the developer for use in the simple development, a pH buffer agent may further be incorporated.

As the pH buffer agent according to the invention, any pH buffer agent exhibiting a pH buffer function at pH from 2 to 11 can be preferably used. In the invention, a weak alkaline buffer agent is preferably used and includes, for example, (a) a carbonate ion and a hydrogen carbonate ion, (b) a borate ion, (c) a water-soluble amine compound and an ion of the water-soluble amine compound, and combinations thereof. Specifically, for example, (a) a combination of a carbonate ion and a hydrogen carbonate ion, (b) a borate ion, or (c) a combination of a water-soluble amine compound and an ion of the water-soluble amine compound exhibits a pH buffer function in the developer to prevent fluctuation of the pH even when the developer is used for a long period of time. As a result, for example, the deterioration of development property resulting from the fluctuation of pH and the occurrence of development scum are restrained. The combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.

When the combination of (a) a carbonate ion and a hydrogen carbonate ion is adopted as the pH buffer agent, the total amount of the carbonate ion and hydrogen carbonate ion is preferably from 0.05 to 5 mole/l, more preferably from 0.1 to 2 mole/l, particularly preferably from 0.2 to 1 mole/l, in the developer.

The developer for use in the simple development may contain an organic solvent. As the organic solvent to be contained, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethyoxyethanol, diethylene glycol monoethyl ether, diethylene glycol monohexyl ether, triethylene glycol monoethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide or N-methylpyrrolidone). Two or more organic solvents may be used in combination.

Further, when the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer described above can be used as a developer and a development replenisher for the exposed negative lithographic printing plate precursor and it is preferably applied to an automatic processor described hereinafter. In the case of conducting the development processing using an automatic processor, the processing solution becomes fatigued in accordance with the processing amount, and hence the processing ability may be restored using a replenisher or a fresh developer.

The development processing using the developer having pH from 2 to 11 according to the invention is preferably performed by an automatic processor equipped with a supplying means for the developer and a rubbing member. An automatic processor using a rotating brush roll as the rubbing member is particularly preferred. Further, the automatic processor is preferably provided with a means for removing the excess developer, for example, a squeeze roller or a drying means, for example, a hot air apparatus, subsequently to the development processing means.

Further, in the plate making process of preparing a lithographic printing plate from the lithographic printing plate precursor according to the invention, the lithographic printing plate precursor may be heated its entire surface before or during the exposure or between the exposure and the development, if desired. By the heating, the image-forming reaction in the image-recording layer is accelerated and advantages, for example, improvement in the sensitivity and printing durability and stabilisation of the sensitivity are achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions. Ordinarily, the heat treatment is carried out in a temperature range from 100 to 500°C. When the temperature is too low, a sufficient effect of strengthening the image may not be obtained, whereas when it is excessively high, problems of deterioration of the support and thermal decomposition of the image area may occur sometimes.

### (On-press development method)

The lithographic printing plate precursor according to the invention can also be subjected to the plate making by an on-press development method. The on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is carried out. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

### EXAMPLES

The present invention will be described in more detail with reference to the following examples, but the invention should not be construed as being limited thereto. With respect to the polymer compounds used in the examples, unless otherwise particularly defmed, a molecular weight means a weight average molecular weight (Mw) and a ratio of repeating units is indicated in mole percent.

### Examples 1 to 6 and Comparative Example 1

### I. Preparation of Lithographic printing plate precursors (1) to (7)

### (1) Preparation of Support 1

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in a 25% by weight aqueous sodium hydroxide solution of 45°C for 9 seconds, washed with water, then immersed in a 20% by weight aqueous nitric acid solution at 60°C for 20 seconds, and washed with water. The etching amount of the grained surface was about 3 g/m².

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying.

The plate was then subjected to an anodizing treatment using as an electrolytic solution, a 15% by weight aqueous sulfuric acid solution (containing 0.5% by weight of aluminum ion) at a current density of 15 A/dm² to form a direct current anodized film of 2.5 g/m², washed with water and dried to prepare Support 1.

The center line average roughness (Ra) of the support thus obtained was measured using a stylus having a diameter of 2 µm and found to be 0.51 µm.

### (2) Formation of Undercoat layer

Coating solution (1) for undercoat layer shown below was coated on Support 1 by a bar and dried in an oven at 80°C for 10 seconds to prepare a support having an undercoat layer having a dry coating amount of 10 mg/m².

**<Coating solution (1) for undercoat layer>**

| | |
|---|---|
| Star polymer shown in Table 13 | 0.017 g |
| Methanol | 9.00 g |
| Water | 1.00 g |

### (3) Formation of Image-recording layer and Protective layer

Coating solution (1) for image-recording layer having the composition shown below was coated on the support having an undercoat layer described above by a bar and dried in an oven at 70°C for 60 seconds to form an image-recording layer having a dry coating amount of 1.1 g/m². Coating solution (1) for protective layer having the composition shown below was coated on the image-recording layer using a bar so as to have a dry coating amount of 0.75 g/m² and dried at 125°C for 70 seconds to form Lithographic printing plate precursors (1) to (7), respectively.

**<Coating solution (1) for image-recording layer>**

| | | |
|---|---|---|
| Binder (1) shown below (weight average molecular weight: 60,000) | | 0.54 g |
| Polymerizable compound (1) shown below | | 0.48 g |
| | (PLEX 6661-O, produced by Degussa Japan Co., Ltd.) | |
| Sensitizing dye (1) shown below | | 0.06 g |
| Polymerization initiator (1) shown below | | 0.18 g |
| Co-sensitizer (1) shown below | | 0.07 g |
| Dispersion of ε-phthalocyanine pigment (1) | | 0.40 g |
| | [pigment: 15 parts by weight; dispersing agent (allyl methacrylate/methacrylic acid (80/20) copolymer, Mw: 50,000): 10 parts by weight; solvent (cyclohexanone/methoxypropyl acetate/1-methoxy-2-propanol =15 parts by weight/20 parts by weight/40 parts by weight)] | |
| Thermal polymerization inhibitor | | 0.01 g |
| | N-Nitrosophenylhydroxylamine aluminum salt | |
| Fluorine-based surfactant (1) shown below (Mw: 13,000) | | 0.001 g |
| Polyoxyethylene-polyoxypropylene condensate | | 0.04 g |
| | (PLURONIC L44, produced by ADEKA Corp.) | |
| 1-Methoxy-2-propanol | | 3.5 g |
| Methyl ethyl ketone | | 8.0 g |

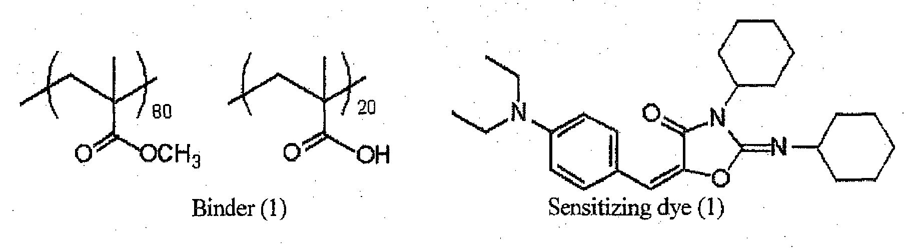

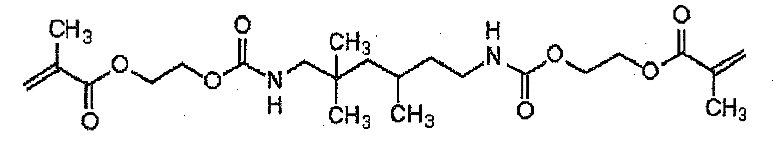

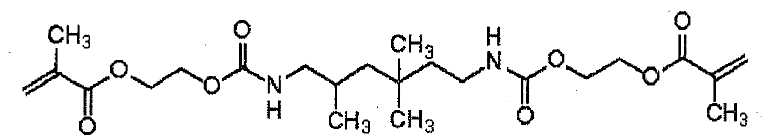

Mixture of the isomers described above

### Polymerizable compound (1)

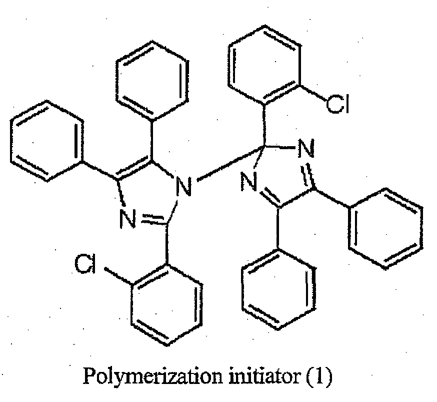

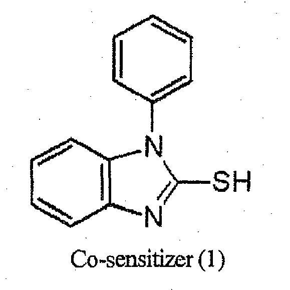

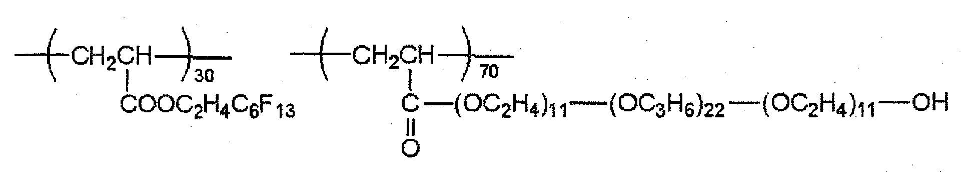

### Fluorine-based surfactant (1)

**<Coating solution (1) for protective layer>**

| | |
|---|---|
| Dispersion of mica (1) shown below | 13.0 g |
| Polyvinyl alcohol (saponification degree: 98% by mole; | 1.3 g |
| polymerization degree: 500) | |
| Sodium 2-ethylhexylsulfosuccinate | 0.2 g |
| Vinyl pyrrolidone/vinyl acetate (1/1) copolymer (Mw: 70,000) | 0.05 g |
| Surfactant (EMALEX 710, produced by Nihon-Emulsion Co., Ltd.) | 0.05 g |
| Water | 133 g |

### (Preparation of Dispersion of mica (1))

To 368 g of water was added 32 g of synthetic mica (SOMASIF ME-100, produced by CO-OP Chemical Co., Ltd., aspect ratio: 1,000 or more) and the mixture was dispersed using a homogenizer until an average particle size (according to a laser scattering method) became 0.5 µm to prepare Dispersion of mica (1). II. Evaluation of Lithographic printing plate precursor

### <Conditions of exposure and development>

### (1) Condition of preparing standard lithographic printing plate

Each of Lithographic printing plate precursors (1) to (7) was subjected to imagewise exposure using a semiconductor laser of 405 nm having output of 100 mW in an exposure amount of 300 µJ/cm².

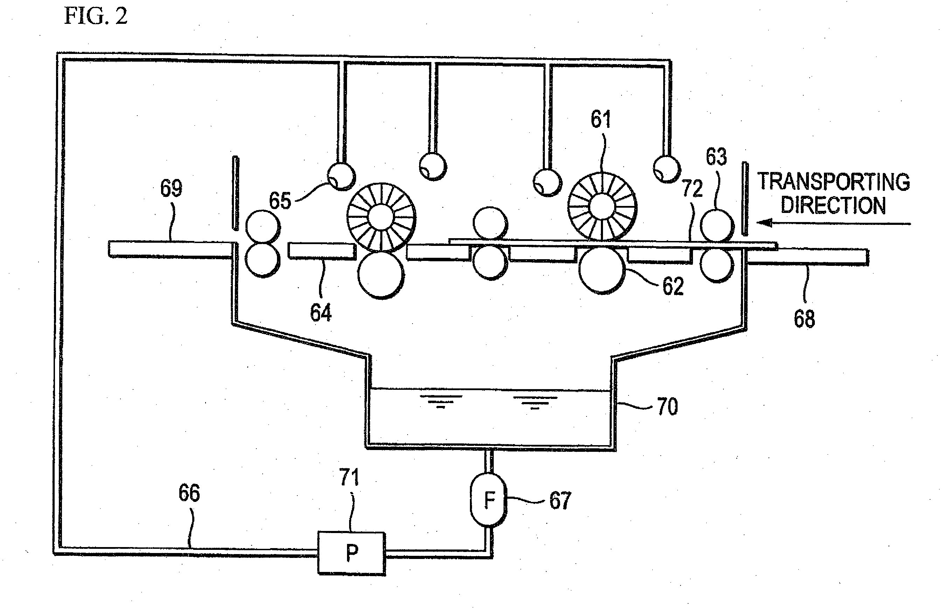

Then, the exposed lithographic printing plate precursor was subjected to development processing in Automatic development processor (A) having a structure shown in Fig. 2 using Developer (1) having the composition shown below. Automatic development processor (A) was an automatic processor having two rotating brush rollers. The first brush roller was a brush roller having an outer diameter of 90 mm and being implanted with fiber of polybutylene terephthalate (bristle diameter: 200 µm, bristle length: 17 mm), and the brush roller was rotated at 200 rpm (peripheral velocity at the tip of brush: 0.94 m/sec) in the same direction as the transporting direction of the lithographic printing plate precursor. The second brush roller was a brush roller having an outer diameter of 60 mm and being implanted with fiber of polybutylene terephthalate (bristle diameter: 200µm, bristle length: 17 mm), and the brush roller was rotated at 200 rpm (peripheral velocity at the tip of brush: 0.63 m/sec) in the opposite direction to the transporting direction of the lithographic printing plate precursor. The transportation of the lithographic printing plate precursor was conducted at a transporting speed of 100 cm/min.

The developer was supplied on the surface of the lithographic printing plate precursor by showering from a spray pipe using a circulation pump. The tank volume for the developer was 10 liters. Thus, Standard lithographic printing plates (1) to (7) were prepared.

### (2) Condition of preparing lithographic printing plate for evaluating development property

Each of Lithographic printing plate precursors (1) to (7) was subjected to the imagewise exposure in the same manner as in Condition of preparing standard lithographic printing plate and then subjected to the development processing in the same manner as in Condition of preparing standard lithographic printing plate except for variously changing the transporting speed of the lithographic printing plate precursor to prepare a lithographic printing plate for evaluating development property.

**Developer (1)**

| | |
|---|---|
| Water | 100.00 g |
| Benzyl alcohol | 1.00 g |
| Polyoxyethylene naphthyl ether (average number of oxyethylene: n = 13) | 1.00 g |
| Sodium salt of dioctylsulfosuccinate | 0.50 g |
| Gum arabic | 1.00 g |
| Ethylene glycol | 0.50 g |
| Ammonium primary phosphate | 0.05 g |
| Citric acid | 0.05 g |
| Sodium carbonate | 1.40 g |
| Sodium hydrogen carbonate | 0.59 g |

| | |
|---|---|
| (pH of the developer was adjusted to 9.8 using phosphoric acid and sodium hydroxide) | |

### <Condition of printing>

The lithographic printing plate obtained was mounted on a printing machine (SOR-M, produced by Heidelberg) and printing was conducted at a printing speed of 6,000 sheets per hour using dampening water (EU-3 (etching solution, produced by FUJIFILM Corp.))/water/isopropyl alcohol = 1/89/10 (by volume ratio)) and TRANS-G (N) Black Ink (produced by Dainippon Ink & Chemicals, Inc.).

### <Evaluation>

The development property, stain resistance and printing durability were evaluated in the manner described below. The results obtained are shown in Table 13.

### (1) Stain resistance

Using the standard lithographic printing plate, the printing of 500 sheets was conducted under the condition described above. On the 500th sheet of the printed material, ink satin generated in the non-image area was visually observed to evaluate the stain resistance on a 1 to 10 bases, 1 being a case where due to adhesion of ink the non-image area was almost stained and 10 being a case where the non-image area did not stained at all. In case this evaluation point is less than 9, it cannot be practically used as a lithographic printing plate.

### (2) Printing durability

The printing was continued under the condition described above using the standard lithographic printing plate and a number of printed materials obtained until the ink density (reflection density) on the printing paper decreased by 0.1 from that at the initiation of printing was determined to evaluate the printing durability.

### (3) Development property

With the lithographic printing plate for evaluating development property, cyan density of the non-image area was measured by a Macbeth densitometer. The transporting speed (cm/min) at which the cyan density of the non-image area became equivalent to cyan density of the aluminum support was determined to evaluate the development property.

**TABLE 13**

| | Lithographic Printing Plate Precursor | Star Polymer | Printing Durability (sheets) | Development Property (cm/min) | Stain Resistance |
|---|---|---|---|---|---|
| Example 1 | (1) | P-1 | 8x10⁴ | 105 | 10 |
| Example 2 | (2) | P-2 | 9x10⁴ | 105 | 10 |
| Example 3 | (3) | P-3 | 9x10⁴ | 115 | 10 |
| Example 4 | (4) | P-4 | 9x10⁴ | 120 | 10 |
| Example 5 | (5) | P-5 | 10x10⁴ | 150 | 10 |
| Example 6 | (6) | P-6 | 10x10⁴ | 145 | 10 |
| Comparative Example 1 | (7) | Comparative Polymer C-1 | 7x10⁴ | 100 | 7 |

Comparative polymer C-1 (Mw:60,000)

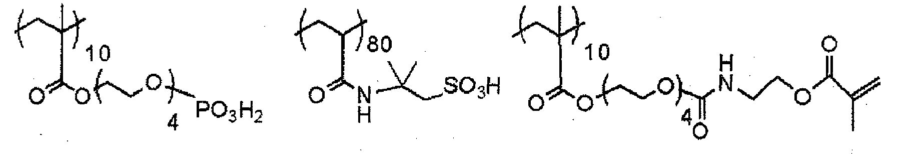

### Example 7 and Comparative Example 2

### I. Preparation of Lithographic printing plate precursors (8) and (9)

### (1) Preparation of Support 2

An aluminum plate of JIS A1050 having a thickness of 0.30 mm and a width of 1,030 mm was continuously subjected to surface treatment according to various processes (a) to (f) shown below. After each process and water washing, removal of liquid was conducted with a nip roller.
(a) Alkali etching treatment of the aluminum plate was conducted by spraying an aqueous solution having sodium hydroxide concentration of 26% by weight, aluminum ion concentration of 6.5% by weight and temperature of 70°C to dissolve the aluminum plate in an amount of 5 g/m². Subsequently, the plate was washed with water.
(b) Desmut treatment of the aluminum plate was conducted by spraying an aqueous 1% by weight nitric acid solution (containing 0.5% by weight of aluminum ion) having temperature of 30°C. Subsequently, the plate was washed with water.
(c) Electrochemical surface roughening treatment of the aluminum plate was continuously conducted by applying 60 Hz alternating current voltage. The electrolytic solution used was an aqueous 1% by weight nitric acid solution (containing 0.5% by weight of aluminum ion and 0.007% by weight of ammonium ion) and the solution temperature was 30°C. The electrochemical surface roughening treatment was conducted using a trapezoidal rectangular wave alternating current where time (TP) for reaching the current to its peak from zero was 0.8 msec and a duty ratio was 1:1 as an alternating current source, and using a carbon electrode as a counter electrode. A ferrite was used as an auxiliary anode. The current density was 25 A/dm² at the peak current, and the electric quantity was 250 C/dm² in terms of the total electric quantity during the aluminum plate functioning as an anode. To the auxiliary anode, 5% of the current flowing from the electric source was divided. Subsequently, the plate was washed with water.
(d) Alkali etching treatment of the aluminum plate was conducted at 35°C by spraying an aqueous solution having a sodium hydroxide concentration of 26% by weight and an aluminum ion concentration of 6.5% by weight to dissolve the aluminum plate in an amount of 0.2 g/m². Thus, the smut component mainly comprising aluminum hydroxide formed in the precedent process of electrochemical surface roughening treatment using alternating current was removed and an edge portion of the pit formed was dissolved to smoothen the edge portion. Subsequently, the plate was washed with water.
(e) Desmut treatment of the aluminum plate was conducted by spraying an aqueous 25% by weight sulfuric acid solution (containing 0.5% by weight of aluminum ion) having temperature of 60°C. Subsequently, the plate was washed with water by spraying.
(f) Anodizing treatment of the aluminum plate was conducted in an aqueous solution having sulfuric acid concentration of 170 g/liter (containing 0.5% by weight of aluminum ion) at temperature of 33°C and an electric density of 5 A/dm² for 50 seconds. Subsequently, the plate was washed with water. The amount of the anodic oxide film was 2.7 g/m².

The surface roughness (Ra) of Support 2 thus-obtained was 0.27 (measuring instrument: SURFCOM having a stylus with a tip diameter of 2 µm, produced by Tokyo Seimitsu Co. Ltd.,).

### (2) Formation of Undercoat layer

Coating solution (2) for undercoat layer shown below was coated on Support 2 by a wire bar and dried at 90°C for 30 seconds. The coating amount of the undercoat layer was 10 mg/m².

**<Coating solution (2) for undercoat layer>**

| | |
|---|---|
| Star polymer shown in Table 14 | 0.05 g |
| Methanol | 27 g |
| Ion-exchanged water | 3 g |

### (3) Formation of Image-recording layer

Coating solution (2) for image-recording layer shown below was prepared and coated on the support having an undercoat layer described above by a wire bar. Drying was conducted in a hot air drying apparatus at 115°C for 34 seconds to form an image-recording layer. The coverage of the image-recording layer after drying was 1.4 g/m².

**<Coating solution (2) for image-recording layer>**

| | | |
|---|---|---|
| Phosphonium compound (A-6) | | 0.077 g |
| Infrared absorbing agent (IR-1) | | 0.074 g |
| Polymerization initiator (OS-12) | | 0.280 g |
| Additive (PM-1) | | 0.151 g |
| Polymerizable compound (AM-1) | | 1.00 g |
| Binder (BT-1) (Mw: 45,000) | | 1.00 g |
| Ethyl violet (C-1) | | 0.04 g |
| Fluorine-based surfactant | | 0.015 g |
| | (MEGAFAC F-780-F, 30% by weight methyl isobutyl ketone (MIBK) solution, produced by Dainippon Ink & Chemicals, Inc.) | |
| Methyl ethyl ketone | | 10.4 g |
| Methanol | | 4.83 g |
| 1-Methoxy-2-propanol | | 10.4 g |

The structure of Phosphonium compound (A-6), Polymerization initiator (OS-12), Infrared absorbing agent (IR-1), Additive (PM-1), Polymerizable compound (AM-1), Binder (BT-1) and Ethyl violet (C-1) are shown below.

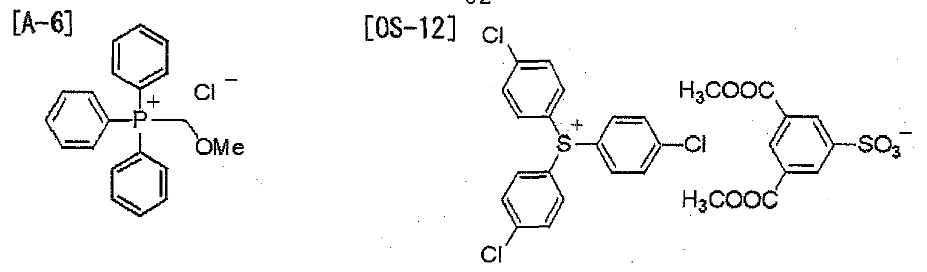

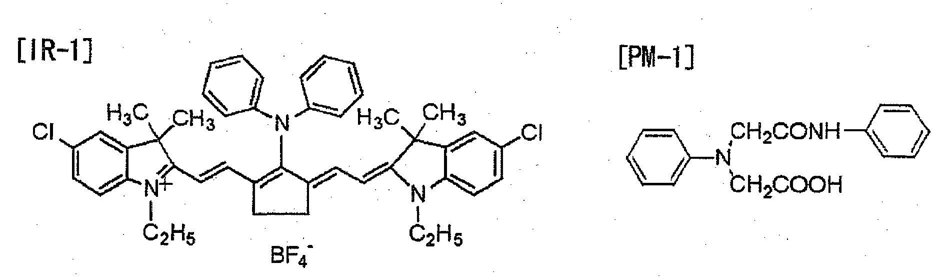

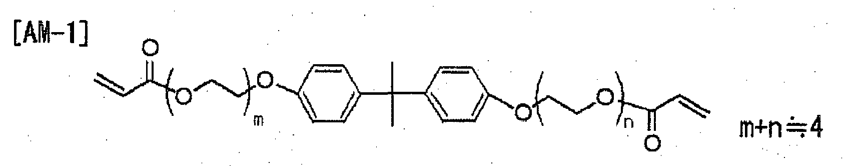

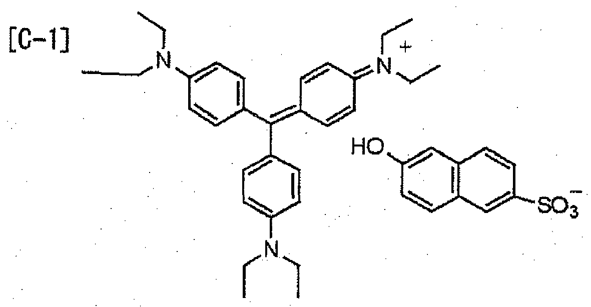

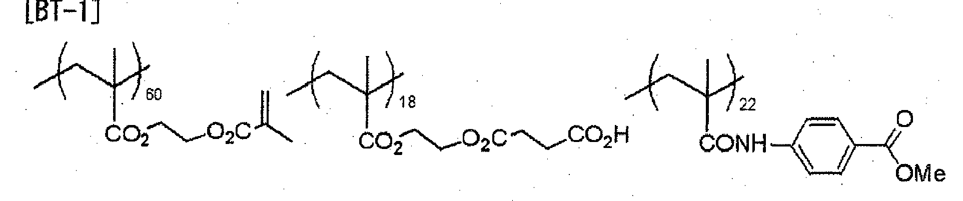

### (4) Formation of protective layer

An aqueous mixed solution (Coating solution (2) for protective layer) comprising synthetic mica (SOMASIF ME-100, 8% by weight aqueous dispersion, produced by CO-OP Chemical Co., Ltd.), polyvinyl alcohol (PVA-205, produced by Kuraray Co., Ltd.) and a surfactant (EMALEX 710, produced by Nihon-Emulsion Co., Ltd.) was coated on the image-recording layer described above by a wire bar and dried in a hot air drying apparatus at 125°C for 75 seconds.

The content ratio of mica (solid content)/polyvinyl alcohol/surfactant in Coating solution (2) for protective layer was 16/82/2 (% by weight), and the coating amount (coverage after drying) of the protective layer was 1.6 g/m². Thus, Lithographic printing plate precursors (8) and (9) were prepared. II. Evaluation of Lithographic printing plate precursor

The lithographic printing plate precursor obtained was exposed by TRENDSETTER 800II QUANTUM (produced by Creo Co.) at resolution of 2,400 dpi and a rotational number of an external drum of 200 rpm and output of 7 W. The exposure was conducted under conditions of 25°C and 50% RH. After the exposure, without conducting heat treatment and water washing, the exposed lithographic printing plate precursor was subjected to development processing using an automatic developing machine (LP-1310HII, produced by FUJIFILM Corp.) at a transporting speed (line speed) of 2 m/min and at development temperature of 30°C. The developer used was a solution prepared by diluting DH-N (produced by FUJIFILM Corp.) with water in a ratio of 1:4. The development replenisher used was a solution prepared by diluting FCT-421 (produced by FUJIFILM Corp.) with water in a ratio of 1:1.4. The finisher used was a solution prepared by diluting GN-2K (produced by FUJIFILM Corp.) with water in a ratio of 1:1.

### <Printing durability>

Using the lithographic printing plate obtained by the plate making described above, the printing was conducted in the same manner as in Example 1 and a number of printed materials obtained until the ink density (reflection density) on the printing paper decreased by 0.1 from that at the initiation of printing was determined to evaluate the printing durability. The results obtained are shown in Table 14.

### <Stain resistance>

Using the lithographic printing plate obtained by the plate making described above, the stain resistance was also evaluated in the same manner as in Example 1. The results obtained are shown in Table 14.

### <Development property>

With the lithographic printing plates obtained by changing the transporting speed (line speed) of the lithographic printing plate precursor in the automatic developing machine LP-1310HII, cyan density of the non-image area was measured by a Macbeth densitometer in the same manner as in Example 1. The transporting speed (cm/min) at which the cyan density of the non-image area became equivalent to cyan density of the aluminum support was determined to evaluate the development property. The results obtained are shown in Table 14.

**TABLE 14**

| | Lithographic Printing Plate Precursor | Star Polymer | Printing Durability (sheets) | Development Property (cm/min) | Stain Resistance |
|---|---|---|---|---|---|
| Example 7 | (8) | P-61 | 2.5 x 10⁴ | 150 | 10 |
| Comparative Example 2 | (9) | Comparative Polymer C-2 | 1.5x10⁴ | 100 | 8 |

Comparative polymer C-2 (Mw: 5 5,000)

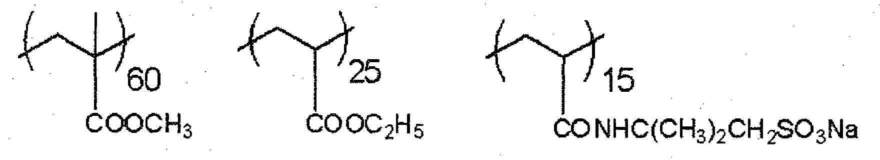

### Example 8 and Comparative Example 3

### I. Preparation of Lithographic printing plate precursors (10) and (11)

### (1) Preparation of Support 3

An aluminum plate (material: JIS A 1050, refining: H16) having a thickness of 0.24 mm was immersed in an aqueous 5% by weight sodium hydroxide solution maintained at 65°C to conduct a degreasing treatment for one minute, followed by washed with water. The degreased aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The surface-roughened and desmuted aluminum plate was subjected to an anodizing treatment under condition of current density of 10 A/dm² and voltage of 15 V in an aqueous 15% by weight sulfuric acid solution at 25°C for one minute and then subjected to a hydrophilizing treatment using an aqueous 1% by weight solution of the star polymer shown in Table 15 at 75°C to prepare Support 3. The surface roughness of the support was measured and found to be 0.44 µm (Ra indication according to JIS B0601).

### (2) Formation of Image-recording layer

Coating solution (3) for image-recording layer having the composition shown below was coated on Support 3 described above using a bar and dried in an oven at 90°C for 60 seconds to form an image-recording layer having a dry coating amount of 1.3 g/m².

**<Coating solution (3) for image-recording layer>**

| | | |
|---|---|---|
| Binder (2) (Mw: 50,000) shown below | | 0.04 g |
| Binder (3) (Mw: 80,000) shown below | | 0.30 g |
| Polymerizable compound (1) shown above | | 0.17 g |
| Polymerizable compound (2) shown below | | 0.51 g |
| Sensitizing dye (2) shown below | | 0.03 g |
| Sensitizing dye (3) shown below | | 0.015 g |
| Sensitizing dye (4) shown below | | 0.015 g |
| Polymerization initiator (1) shown above | | 0.13 g |
| Chain transfer agent | | 0.01 g |
| | Mercaptobenzothiazole | |
| Dispersion (2) of ε-phthalocyanine pigment | | 0.40 g |
| | (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | |
| Thermal polymerization inhibitor | | 0.01 g |
| | N-Nitrosophenylhydroxylamine aluminum salt | |
| Fluorine-based surfactant (1) shown above | | 0.001 g |
| 1-Methoxy-2-propanol | | 3.5 g |
| Methyl ethyl ketone | | 8.0 g |

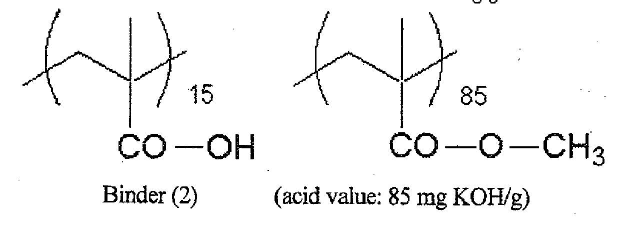

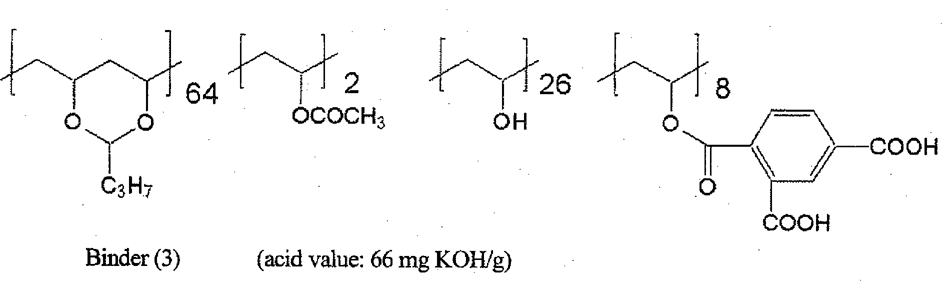

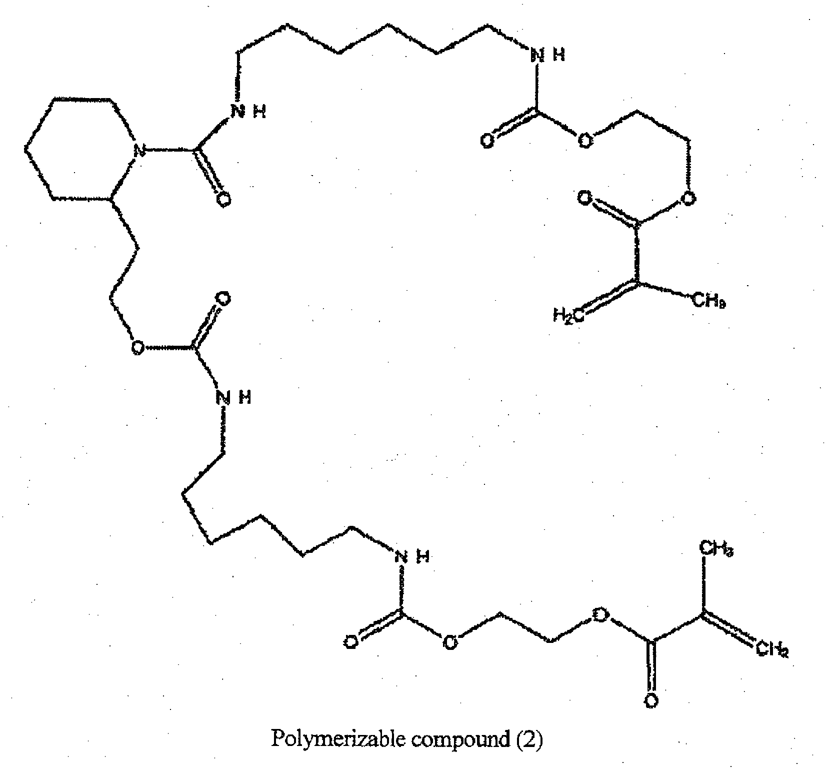

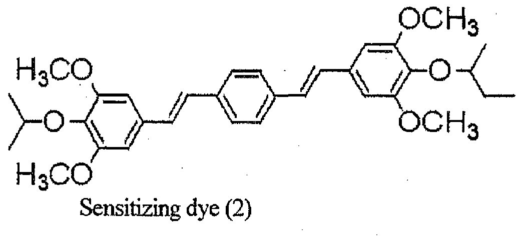

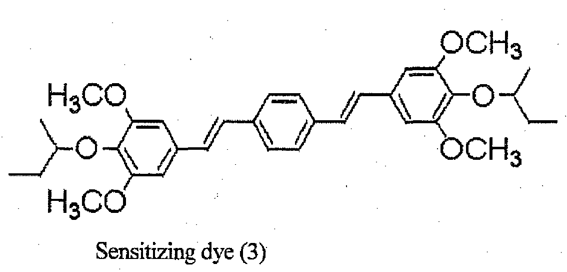

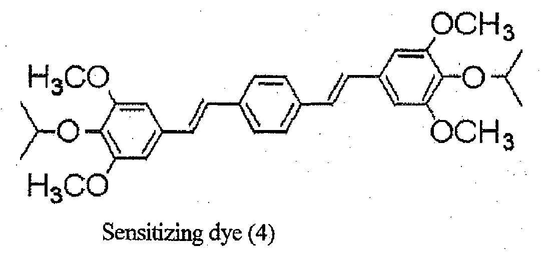

### (3) Formation of Protective layer

Coating solution (3) for protective layer having the composition shown below was coated on the image-recording layer described above using a bar so as to have a dry coating amount of 1.2 g/m² and dried at 125°C for 70 seconds to form a protective layer, thereby preparing Lithographic printing plate precursors (10) and (11).

**<Coating solution (3) for protective layer>**

| | |
|---|---|
| PVA-205 (partially hydrolyzed polyvinyl alcohol, produced by Kuraray Co., Ltd. (saponification degree: 86.5 to 89.5% by mole; viscosity: 4.6 to 5.4 mPa·s in a 4% by weight aqueous solution at 20°C)) | 0.658 g |
| PVA-105 (fully hydrolyzed polyvinyl alcohol, produced by Kuraray Co., Ltd. (saponification degree: 98.0 to 99.0% by mole; | 0.142 g |
| viscosity: 5.2 to 6.0 mPa·s in a 4% by weight aqueous solution at 20°C)] | |
| Vinyl pyrrolidone/vinyl acetate (1/1) copolymer (weight average molecular weight: 70,000) | 0.001 g |
| Surfactant (EMALEX 710, produced by Nihon Emulsion Co., Ltd.) | 0.002 g |
| Water | 13 g |

### (4) Exposure, Development and Printing

The lithographic printing plate precursor was subjected to image exposure by Violet semiconductor laser plate setter Vx9600 (equipped with InGaN semiconductor laser; emission: 405 nm ± 10 nm/output: 30 mW) produced by FUJIFILM Electronic Imaging, Ltd. The image drawing was conducted at a resolution of 2,438 dpi with halftone dots of 50% using an FM screen (TAFFETA 20, produced by FUJIFILM Corp.) under condition of a plate surface exposure amount of 0.05 mJ/cm².

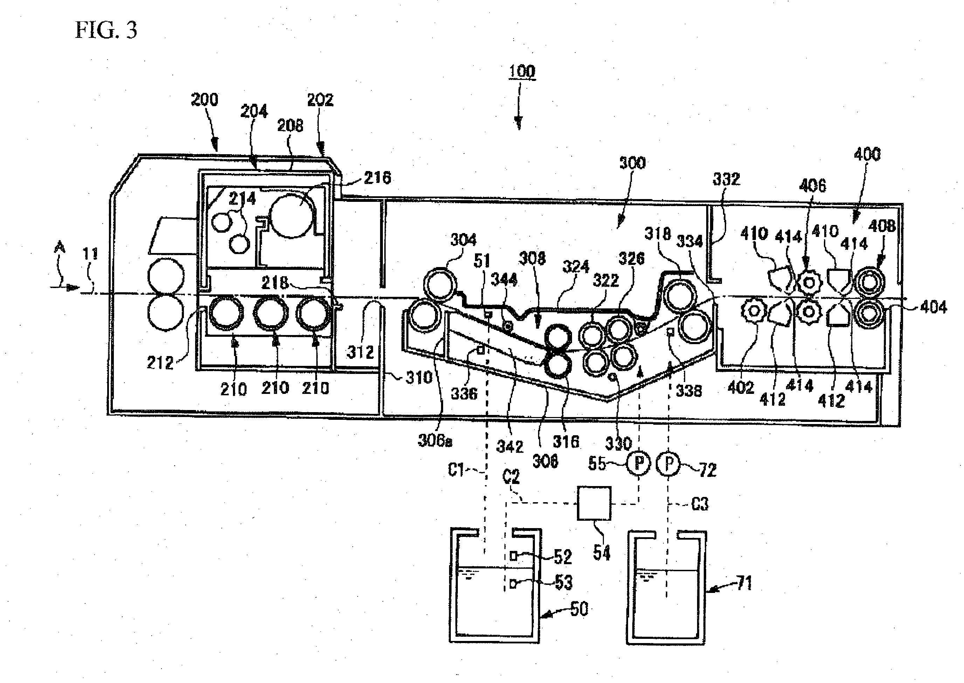

Then, the exposed lithographic printing plate precursor was subjected to development processing by Automatic development processor (B) having a structure shown in Fig. 3 using Developer (2) having the composition shown below at a transporting speed so as to regulate preheating time at 100°C of 10 seconds and immersion time (developing time) in the developer of 20 seconds. Also, for the purpose of evaluating the development property, the development was conducted with variously changing the immersion time.

The lithographic printing plate thus-obtained was mounted on a printing machine (SOR-M, produced by Heidelberg) and printing was conducted at a printing speed of 6,000 sheets per hour using dampening water (EU-3 (etching solution, produced by FUJIFILM Corp.))/water/isopropyl alcohol = 1/89/10 (by volume ratio)) and TRANS-G (N) Black Ink (produced by Dainippon Ink & Chemicals, Inc.).

**<Developer (2)>**

| | |
|---|---|
| Water | 88.6g |
| Nonionic surfactant (W-1) having structure shown below | 2.4 g |
| Nonionic surfactant (W-2) having structure shown below | 2.4 g |
| Nonionic surfactant (EMALEX 710, produced by Nihon Emulsion Co., Ltd.) | 1.0 g |
| Phenoxypropanol | 1.0 g |
| Octanol | 0.6 g |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediammetetraacetate | 0.05 g |
| Polystyrenesulfonic acid (VERSA TL77 (30% solution) produced by Alco Chemical Inc.) | 1.0 g |

(pH was adjusted to 7.0 by adding phosphoric acid)

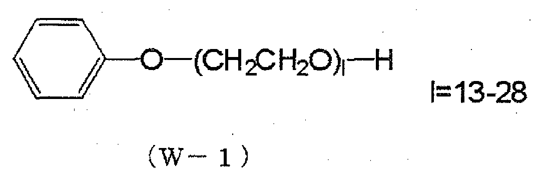

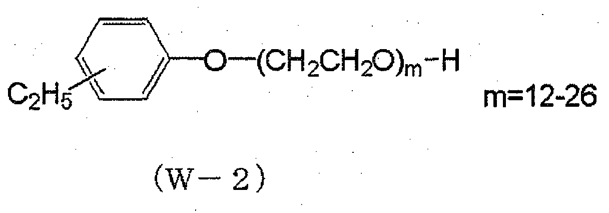

### II. Evaluation of Lithographic printing plate precursor

### <Development property>

The lithographic printing plate precursor was subjected to the image exposure and development processing as described above. After the development processing, the non-image area of the lithographic printing plate obtained was visually observed and the immersion time in the developer for which the image-recording layer did not remain to obtain good development property was determined to evaluate the development property.

### <Printing durability>

As increase in the number of printed materials, the image of the image-recording layer formed on the lithographic printing plate was gradually abraded to cause decrease in the ink receptivity, resulting in decrease in ink density of the image on a printing paper. A number of printed materials obtained until the ink density (reflection density) decreased by 0.1 from that at the initiation of printing was determined to evaluate the printing durability.

### <Stain resistance>

The printing was conducted as described above and on the 3,000th sheet of the printed material, the stain resistance was evaluated according to the following criteria:
A: Ink stain was not observed in the non-image area.
B: Slight ink stain was observed in the non-image area.

**TABLE 15**

| | Lithographic Printing Plate Precursor | Star Polymer | Printing Durability (sheets) | Development Property (sec) | Stain Resistance |
|---|---|---|---|---|---|
| Example 8 | (10) | P-62 | 9 x 10⁴ | 20 | A |
| Comparative Example 3 | (11) | Comparative Polymer C-2 | 7 x 10⁴ | 30 | B |

### Examples 9 to 68 and Comparative Example 4

### I. Preparation of Lithographic printing plate precursors (12) and (72)

### (1) Preparation of Support 4

In order to ensure the hydrophilicity of the non-image area, Support 1 described above was subjected to silicate treatment using a 2.5% by weight aqueous sodium silicate No. 3 solution at 60°C for 10 seconds and subsequently washed with water to obtain Support 4. The adhesion amount of Si was 10 mg/m². The center line average roughness (Ra) of the support was measured using a stylus having a diameter of 2 µm and found to be 0.51 µm.

### (2) Formation of Undercoat layer

Coating solution (3) for undercoat layer shown below was coated on Support 4 described above so as to have a dry coating amount of 20 mg/m² to prepare a support having an undercoat layer.

**<Coating solution (3) for undercoat layer>**

| | |
|---|---|
| Star polymer shown in Table 16 | 0.18 g |
| Hydroxyethyliminodiacetic acid | 0.10 g |
| Methanol | 55.24 g |
| Water | 6.15 g |

### (3) Formation of Image-recording layer

Coating solution (4) for image-recording layer having the composition shown below was coated on the undercoat layer formed as described above by a bar and dried in an oven at 100°C for 60 seconds to form an image-recording layer having a dry coating amount of 1.0 glm².

Coating solution (4) for image-recording layer was prepared by mixing Photosensitive solution (1) shown below with Microgel solution (1) shown below just before the coating, followed by stirring.

**<Photosensitive solution (1)>**

| | |
|---|---|
| Binder (4) shown below | 0.240 g |
| Infrared absorbing dye (1) having structure shown above | 0.030 g |
| Radical polymerization initiator (2) having structure shown above | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Oil-sensitizing agent (Phosphonium compound (1) having structure shown below) | 0.055 g |
| Oil-sensitizing agent (Benzyl dimethyl octyl ammonium PF₆ salt) | 0.018 g |
| Oil-sensitizing agent (Ammonium group-containing polymer having structure shown below (reduced specific viscosity: 44 ml/g) | 0.035 g |
| Fluorine-based surfactant (1) described above | 0.008 g |
| Methyl ethyl ketone | 1.091 g |
| 1-Methoxy-2-propanol | 8.609 g |

**<Microgel solution (1)>**

| | |
|---|---|
| Microgel (1) shown below | 2.640 g |
| Distilled water | 2.425 g |

The structures of Binder (4), Infrared absorbing dye (1), Radical polymerization initiator (2), Phosphonium compound (1), Hydrophilic low molecular weight compound (1) and Oil-sensitizing agent (ammonium group-containing polymer) are shown below.

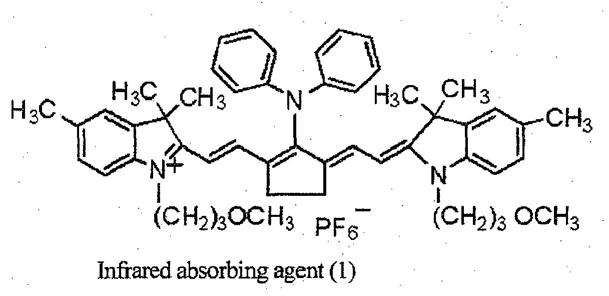

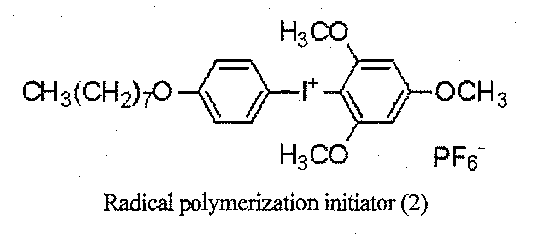

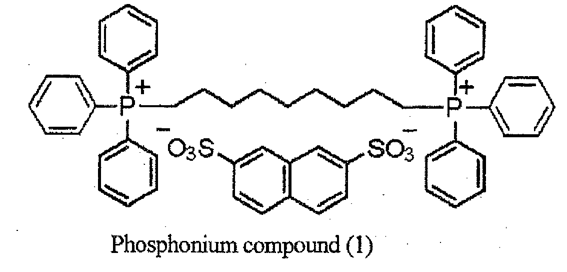

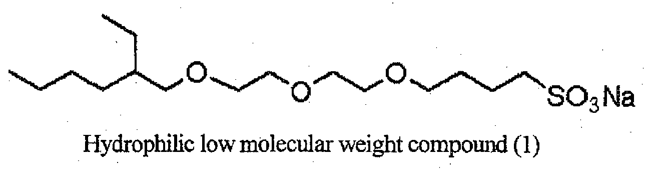

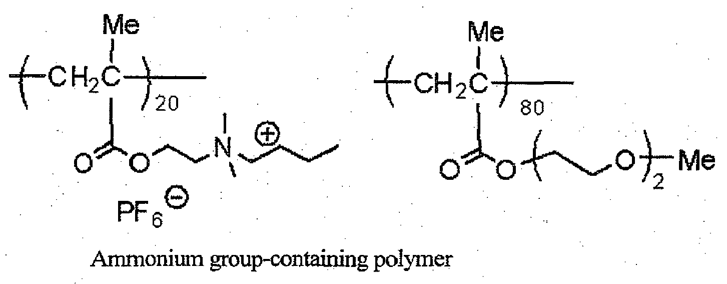

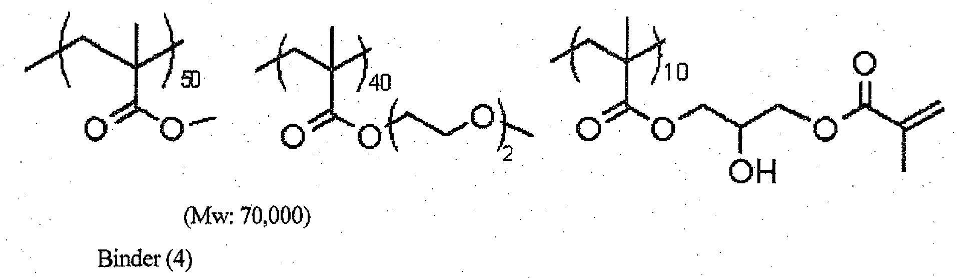

### <Preparation of Microgel (1)>

An oil phase component was prepared by dissolving 10 g of adduct of trimethylol propane and xylene diisocyanate (TAKENATE D-110N, produced by Mitsui Chemicals, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of a 4% by weight aqueous solution of polyvinyl alcohol (PVA-205, produced by Kuraray Co., Ltd.) was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare Microgel (1). The average particle size of the microgel was measured by a light scattering method and found to be 0.2 µm.

### (4) Formation of Protective layer

Coating solution (4) for protective layer having the composition shown below was coated on the image-recording layer described above by a bar and dried in an oven at 120°C for 60 seconds to form a protective layer having a dry coating amount of 0.15 g/m², thereby preparing Lithographic printing plate precursors (12) to (72), respectively.

**<Coating solution (4) for protective layer>**

| | |
|---|---|
| Dispersion of inorganic stratiform compound (1) shown below | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1 % by weight solution of surfactant (EMALEX 710, produced by Nihon Emulsion Co., Ltd.) | 0.86 g |
| Ion-exchanged water | 6.0 g |

### <Preparation of Dispersion of inorganic stratiform compound (1)>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 µm to prepare Dispersion of inorganic stratiform compound (1). The aspect ratio of the inorganic particle thus-dispersed was 100 or more.

### II. Evaluation of Lithographic printing plate precursor

### <On-press development property>

The lithographic printing plate precursor thus-obtained was exposed by LUXEL PLATESETTER T-6000III equipped with an infrared semiconductor laser produced by FUJIFILM Corp. under the conditions of a rotational number of an external drum of 1,000 rpm, laser output of 70% and resolution of 2,400 dpi. The exposed image contained a solid image and a 50% halftone dot chart of a 20 µm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and VALUES-G (N) Black Ink (produced by Dainippon Ink & Chemicals, Inc.), the dampening water and ink were supplied according to the standard automatic printing start method of LITHRONE 26 to conduct printing on 100 sheets of TOKUBISHI ART paper (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property. The results obtained are shown in Table 16.

### <Printing durability>

After performing the evaluation for the on-press development property described above, the printing was continued. As the increase in a number of printing papers, the image-recording layer was gradually abraded to cause decrease in the ink density on a printed material. A number of printed materials wherein a value obtained by measuring a halftone dot area rate of the 50% halftone dot of FM screen on the printed material using a Gretag densitometer decreased by 5% from the value measured on the 100th printed material of the printing was determined to evaluate the printing durability. The results obtained are shown in Table 16.

### <Stain resistance>

After performing the evaluation for the on-press development property described above, the printing was continued. On the 500th sheet of the printed material, ink satin generated in the non-image area was visually observed to evaluate the stain resistance on a 1 to 10 bases, 1 being a case where due to adhesion of ink the non-image area was almost stained and 10 being a case where the non-image area did not stained at all. In case this evaluation point is less than 9, it cannot be practically used as a lithographic printing plate.

**TABLE 16**

| | Lithographic Printing Plate Precursor | Star Polymer | Printing Durability (sheets) | Development Property (sheets) | Stain Resistance |
|---|---|---|---|---|---|
| Example 9 | (12) | P-1 | 4.70 x 10⁴ | 8 | 10 |
| Example 10 | (13) | P-2 | 4.66 x 10⁴ | 8 | 10 |
| Example 11 | (14) | P-3 | 4.79 x 10⁴ | 9 | 10 |
| Example 12 | (15) | P-4 | 4.76 x 10⁴ | 9 | 10 |
| Example 13 | (16) | P-5 | 5.00 x 10⁴ | 8 | 10 |
| Example 14 | (17) | P-6 | 4.94 x 10⁴ | 8 | 10 |
| Example 15 | (18) | P-7 | 4.67 x 10⁴ | 8 | 10 |
| Example 16 | (19) | P-8 | 4.61 x 10⁴ | 8 | 10 |
| Example 17 | (20) | P-9 | 4.69 x 10⁴ | 9 | 10 |
| Example 18 | (21) | P-10 | 4.71 X 10⁴ | 8 | 10 |
| Example 19 | (22) | P-11 | 4.77 x 10⁴ | 10 | 10 |
| Example 20 | (23) | P-12 | 4.75 x 10⁴ | 9 | 10 |
| Example 21 | (24) | P-13 | 4.74 x 10⁴ | 10 | 10 |
| Example 22 | (25) | P-14 | 4.93 x 10⁴ | 9 | 10 |
| Example 23 | (26) | P-15 | 4.97 x 10⁴ | 8 | 10 |
| Example 24 | (27) | P-16 | 4.84 x 10⁴ | 10 | 10 |
| Example 25 | (28) | P-17 | 4.89 x 10⁴ | 8 | 10 |
| Example 26 | (29) | P-18 | 4.91 x 10⁴ | 8 | 10 |
| Example 27 | (30) | P-19 | 4.82 x 10⁴ | 9 | 10 |
| Example 28 | (31) | P-20 | 4.81 x 10⁴ | 10 | 10 |
| Example 29 | (32) | P-21 | 4.80 x 10⁴ | 8 | 10 |
| Example 30 | (33) | P-22 | 4.86 x 10⁴ | 10 | 10 |
| Example 31 | (34) | P-23 | 4.87 x 10⁴ | 8 | 10 |
| Example 32 | (35) | P-24 | 4.83 x 10⁴ | 8 | 10 |
| Example 33 | (36) | P-25 | 4.85 x 10⁴ | 9 | 10 |
| Example 34 | (37) | P-26 | 4.99 x 10⁴ | 9 | 10 |
| Example 35 | (38) | P-27 | 4.95 x 10⁴ | 10 | 10 |
| Example 36 | (39) | P-28 | 4.98 x 10⁴ | 8 | 10 |
| Example 37 | (40) | P-29 | 4.63 x 10⁴ | 8 | 10 |
| Example 38 | (41) | P-30 | 4.77 x 10⁴ | 10 | 10 |
| Example 39 | (42) | P-31 | 4.96 x 10⁴ | 8 | 10 |
| Example 40 | (43) | P-32 | 4.92 x 10⁴ | 9 | 10 |
| Example 41 | (44) | P-33 | 4.88 x 10⁴ | 8 | 10 |
| Example 42 | (45) | P-34 | 4.90 x 10⁴ | 10 | 10 |
| Example 43 | (46) | P-35 | 4.25 x 10⁴ | 11 | 10 |
| Example 44 | (47) | P-36 | 4.30 x 10⁴ | 11 | 10 |
| Example 45 | (48) | P-37 | 4.40 x 10⁴ | 12 | 10 |
| Example 46 | (49) | P-38 | 4.35 x 10⁴ | 11 | 10 |
| Example 47 | (50) | P-39 | 4.60 x 10⁴ | 12 | 10 |
| Example 48 | (51) | P-40 | 4.47 x 10⁴ | 11 | 10 |
| Example 49 | (52) | P-41 | 4.57 x 10⁴ | 13 | 10 |
| Example 50 | (53) | P-42 | 4.42 x 10⁴ | 13 | 10 |
| Example 51 | (54) | P-43 | 4.53 x 10⁴ | 12 | 10 |
| Example 52 | (55) | P-44 | 4.50 x 10⁴ | 13 | 10 |
| Example 53 | (56) | P-45 | 4.48 x 10⁴ | 12 | 10 |
| Example 54 | (57) | P-46 | 4.41 x 10⁴ | 13 | 10 |
| Example 55 | (58) | P-47 | 4.54 x 10⁴ | 12 | 10 |
| Example 56 | (59) | P-48 | 4.4 x 10⁴ | 12 | 10 |
| Example 57 | (60) | P-49 | 4.59 x 10⁴ | 13 | 10 |
| Example 58 | (61) | P-50 | 4.46 x 10⁴ | 11 | 10 |
| Example 59 | (62) | P-51 | 4.15 x 10⁴ | 13 | 10 |
| Example 60 | (63) | P-52 | 4.21 x 10⁴ | 13 | 10 |
| Example 61 | (64) | P-53 | 4.23 x 10⁴ | 13 | 10 |
| Example 62 | (65) | P-54 | 4.18 x 10⁴ | 13 | 10 |
| Example 63 | (66) | P-55 | 4.24 x 10⁴ | 14 | 10 |
| Example 64 | (67) | P-56 | 4.15 x 10⁴ | 13 | 10 |
| Example 65 | (68) | P-57 | 4.22 x 10⁴ | 14 | 10 |
| Example 66 | (69) | P-58 | 4.00 x 10⁴ | 15 | 10 |
| Example 67 | (70) | P-59 | 4.07 x 10⁴ | 14 | 10 |
| Example 68 | (71) | P-60 | 4.05 x 10⁴ | 15 | 10 |
| Comparative | (72) | Comparative | 3.0 x 10⁴ | 20 | 8 |
| Example 4 | | Polymer C-1 | | | |

### Example 69 and Comparative Example 5

### 1. Preparation of Lithographic printing plate precursors (73) and (74)

Coating solution (5) for image-recording layer shown below was applied to an aluminum substrate subjected to brush graining, anodizing with phosphoric acid and hydrophilizing treatment by immersing in an aqueous 1% by weight solution of the star polymer shown in Table 17 at 75°C for one minute using a wire wound rod and dried in a Ranar conveyor oven set at 90°C for about 90 seconds. The dry coating amount of the image-recording layer obtained was 1.5 g/m².

**<Coating solution (5) for image-recording layer>**

| | |
|---|---|
| Urethane acrylate | 2.48 g |
| Copolymer 1 | 13.53 g |
| Copolymer 2 | 3.97 g |
| Infrared absorbing dye (2) having structure shown below | 0.13 g |
| Polymerization initiator (IRGACURE 250, produced by Ciba Specialty Chemicals, Inc.) | 0.42 g |
| Mercapto-3-triazole | 0.18 g |
| BYK 336 (produced by BYK-Chemie GmbH) | 0.60 g |
| KLUCEL M (produced by Hercules Chemical Co., Inc.) | 3.31 g |
| n-Propanol | 61.97 g |
| Ion-exchanged water | 13.41 g |

The compounds in the coating solution for image-recording layer above are shown below.
* Urethane acrylate: 80% by weight 2-butanone solution of urethane acrylate obtained by a reaction of DESMODUR N100 with hydroxyethyl acrylate and pentaerythritol triacrylate
* Copolymer 1: A mixture of 54 g of n-propanol and 16 g of deionized water was set in a 250-ml flask and heated to 70°C while purging with continuous nitrogen gas flow and stirring with a mechanical stirrer. A mixture of 54 g of n-propanol, 16 g of deionized water, 10 g of PEGMA, 4.5 g of styrene, 40.5 g of acrylonitrile and 0.32 g of VAZO-64 was prepared in a separate beaker and then added dropwise to the 250-ml flask over a period of 30 minutes. After 2.5 hours, 0.16 g of VAZO-64 was added to the reaction mixture. The polymerization reaction was further continued for 2 hours. The polymer solution thus-obtained contained 21% by weight (solid content) of Copolymer 1.

* Copolymer 2: In 1-liter four-necked flask was set 384.1 g of 2-butanone and 8.5 g of PEGMA under nitrogen atmosphere, followed by heating to 80°C. A pre-mixture of 38.0 g of allyl methacrylate and 0.3 g of VAZO-64 was added thereto at 80°C over a period of 90 minutes. After the completion of the addition, 0.13 g of VAZO-64 was further added to the reaction mixture. Then, 0.13 g of VAZO-64 was further added twice. The polymer conversion rate based on nonvolatile component percent was more than 98%.
* PEGMA: Poly(ethylene glycol) methyl ether methacrylate as an aqueous 50% by weight solution, Mn ~2080, available from Sigma-Aldrich Corp. (St. Louis, Missouri)
* VAZO-64: 2,2'-Azobisisobutyronitrile, available from E. I. du Pont de Nemours and Co. (Wilmington, Delaware)
* Infrared absorbing dye (2): structure shown below 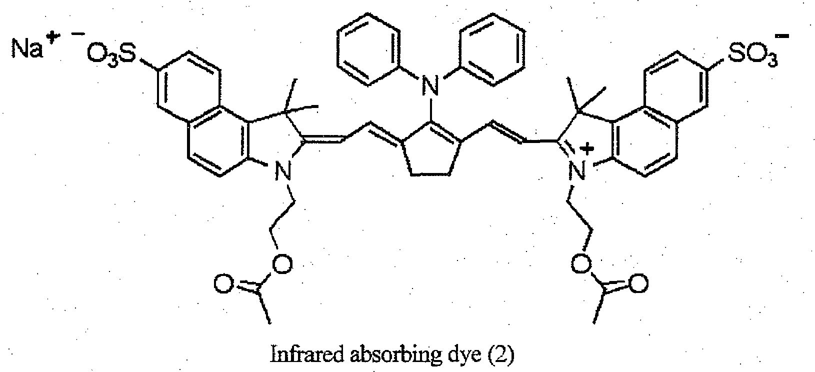
* IRGACURE 250: 75% by weight propylene carbonate solution of (4-methylphenyl)[4-(2-methylpropyl)phenyl]iodonium hexafluorophosphate, available from Ciba Specialty Chemicals (Tarrytown, New York)
* BYK 336: 25% by weight xylene/methoxyropyl acetate solution of modified dimethylpolysiloxane copolymer, available from Byk-Chemie USA Inc. (Wallingford, Connecticut)
* KLUCEL M: 2% by weight aqueous solution of hydroxypropyl cellulose (viscosity: 5,000 mPa·s) available from Hercules Inc., Aqualon Division (Wilmington, Delaware)

Coating solution (5) for protective layer having the composition shown below was coated on the image-recording layer described above by a bar and dried in an oven at 120°C for 60 seconds to form a protective layer having a dry coating amount of 0.35 g/m², thereby preparing Lithographic printing plate precursors (73) and (74), respectively.

**<Coating solution (5) for protective layer>**

| | |
|---|---|
| Dispersion of inorganic stratiform compound (1) shown above | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.58 g |
| Aqueous 1% by weight solution of surfactant (EMALEX 710, produced by Nihon Emulsion Co., Ltd.) | 0.86 g |
| Ion-exchanged water | 6.0 g |

### II. Evaluation of Lithographic printing plate precursor

With the lithographic printing plate precursor thus-obtained, the on-press development property, printing durability and stain resistance were evaluated in the manner shown below. The results obtained are shown in Table 17.

### <On-press development property>

The lithographic printing plate precursor was subjected to exposure by TRENDSETTER 3244VX, produced by Creo Co., equipped with a water-cooled 40 W infrared semiconductor laser under the conditions of output of 9W, a rotational number of an external drum of 210 rpm and resolution of 2,400 dpi. The exposed lithographic printing plate precursor was mounted without undergoing development processing on a plate cylinder of a printing machine (SOR-M, produced by Heidelberg). Using dampening water (a solution prepared by diluting CDS803 (produced by Tokyo Printing Ink Mfg. Co., Ltd.) 50 times with tap water) and TRANS-G (N) Black Ink (produced by Dainippon Ink & Chemicals, Inc.), after supplying the dampening water and ink printing was initiated at a printing speed of 6,000 sheets per hour.

A number of the printing papers required until the on-press development of the unexposed area of the image-recording layer on the printing machine was completed to reach a state where the ink was not transferred to the printing paper was measured to evaluate the on-press development property.

### <Printing durability>

After ink reception on the image-recording layer in the image area, the image-recording layer was gradually abraded. With the progress of abrasion of the image-recording layer, the ink receptivity degraded to initiate decrease of ink density on printing paper. A number of printed materials obtained until the ink density (reflection density) decreased by 0.1 from that at the initiation of printing was determined to evaluate the printing durability.

### <Stain resistance>

After ink reception on the image-recording layer in the image area, the printing was continued. On the 500th sheet of the printed material, ink satin generated in the non-image area was visually observed to evaluate the stain resistance on a 1 to 10 bases, 1 being a case where due to adhesion of ink the non-image area was almost stained and 10 being a case where the non-image area did not stained at all. In case this evaluation point is less than 9, it cannot be practically used as a lithographic printing plate.

**TABLE 17**

| | Lithographic Printing Plate Precursor | Star Polymer | Printing Durability (sheets) | Development Property (sheets) | Stain Resistance |
|---|---|---|---|---|---|
| Example 69 | (73) | P-63 | 4.70 x 10⁴ | 10 | 10 |
| Comparative Example 5 | (74) | Comparative Polymer C-4 | 3.00 x 10⁴ | 21 | 7 |

Comparative polymer C-4: Polyacrylic acid (Mw: 5,000)

## Claims

1. A negative lithographic printing plate precursor comprising a support and an image-recording layer, wherein a layer containing a star polymer is provided between the support and the image-recording layer.

2. The negative lithographic printing plate precursor as claimed in Claim 1, wherein the layer containing a star polymer is an undercoat layer.

3. The negative lithographic printing plate precursor as claimed in Claim 1, wherein the layer containing a star polymer is a layer formed by hydrophilizing treatment of a surface of the support.

4. The negative lithographic printing plate precursor as claimed in any one of Claims 1 to 3, wherein the image-recording layer contains a polymerization initiator and a polymerizable compound.

5. The negative lithographic printing plate precursor as claimed in any one of Claims 1 to 4, wherein the star polymer is a polymer in which from 3 to 10 polymer chains are branched from a central skeleton.

6. The negative lithographic printing plate precursor as claimed in Claim 5, wherein the star polymer is a polymer in which from 3 to 10 polymer chains are branched from a central skeleton via sulfide bonds respectively.

7. The negative lithographic printing plate precursor as claimed in Claim 6, wherein the star polymer is a polymer in which from 3 to 10 polymer chains are branched from a central skeleton via sulfide bonds respectively and which is obtained by polymerization of an ethylenically unsaturated monomer in the presence of a multifunctional thiol.

8. The negative lithographic printing plate precursor as claimed in any one of Claims 1 to 7, wherein the star polymer has a hydrophilic group in a polymer chain thereof.

9. The negative lithographic printing plate precursor as claimed in any one of Claims 1 to 8, wherein the star polymer has a group adsorbing to a surface of the support in a polymer chain thereof.

10. The negative lithographic printing plate precursor as claimed in Claim 8 or 9, wherein the star polymer has a crosslinkable group in the polymer chain thereof.

11. The negative lithographic printing plate precursor as claimed in any one of Claims 1 to 10, which further comprises a protective layer so that the support, the image-recording layer and the protective layer are provided in this order.

12. The negative lithographic printing plate precursor as claimed in any one of Claims 1 to 11, which is capable of printing, after image exposure with laser, by supplying at least one of printing ink and dampening water on a printing machine to remove an unexposed area of the image-recording layer.

13. The negative lithographic printing plate precursor as claimed in any one of Claims 1 to 11, which is capable of removing, after image exposure with laser, an unexposed area of the image-recording layer with a developer having pH from 2 to 14.

14. The negative lithographic printing plate precursor as claimed in Claim 11, which is capable of removing, after image exposure with laser, the protective layer and an unexposed area of the image-recording layer with one bath of a developer having pH from 2 to 14.

15. A plate making method of a negative lithographic printing plate precursor comprising exposing imagewise the negative lithographic printing plate precursor as claimed in Claim 12 with laser, and supplying at least one of printing ink and dampening water to the exposed negative lithographic printing plate precursor on a printing machine to remove an unexposed area of the image-recording layer.

16. A plate making method of a negative lithographic printing plate precursor comprising exposing imagewise the negative lithographic printing plate precursor as claimed in Claim 13 with laser, and removing an unexposed area of the image-recording layer with a developer having pH from 2 to 14.

17. A plate making method of a negative lithographic printing plate precursor comprising exposing imagewise the negative lithographic printing plate precursor as claimed in Claim 14 with laser, and removing the protective layer and an unexposed area of the image-recording layer with one bath of a developer having pH from 2 to 14.

## Patentansprüche

1. Negativer Lithografiedruckplattenvorläufer, umfassend einen Träger und eine Bildaufzeichnungsschicht, worin eine Schicht, die ein Sternpolymer enthält, zwischen dem Träger und der Bildaufzeichnungsschicht vorgesehen ist.

2. Negativer Lithografiedruckplattenvorläufer gemäß Anspruch 1, worin die Schicht, die ein Sternpolymer enthält, eine Unterzugsschicht ist.

3. Negativer Lithografiedruckplattenvorläufer gemäß Anspruch 1, worin die Schicht, die ein Sternpolymer enthält, eine Schicht ist, die durch eine Hydrophilisierungsbehandlung einer Oberfläche des Trägers gebildet ist.

4. Negativer Lithografiedruckplattenvorläufer gemäß irgendeinem der Ansprüche 1 bis 3, worin die Bildaufzeichnungsschicht einen Polymerisationsinitiator und eine polymerisierbare Verbindung umfasst.

5. Negativer Lithografiedruckplattenvorläufer gemäß irgendeinem der Ansprüche 1 bis 4, worin das Sternpolymer ein Polymer ist, worin von 3 bis 10 Polymerketten von einem Zentralgerüst abzweigen.

6. Negativer Lithografiedruckplattenvorläufer gemäß Anspruch 5, worin das Sternpolymer ein Polymer ist, worin 3 bis 10 Polymerketten von einem Zentralgerüst über jeweilige Sulfidbindungen abzweigen.

7. Negativer Lithografiedruckplattenvorläufer gemäß Anspruch 6, worin das Sternpolymer ein Polymer ist, worin von 3 bis 10 Polymerketten von einem Zentralgerüst über jeweilige Sulfidbrücken abzweigen, und welches erhalten ist durch Polymerisation eines ethylenisch ungesättigten Monomers in der Gegenwart eines multifunktionellen Thiols.

8. Negativer Lithografiedruckplattenvorläufer gemäß irgendeinem der Ansprüche 1 bis 7, worin das Sternpolymer eine hydrophile Gruppe in einer Polymerkette hiervon aufweist.

9. Negativer Lithografiedruckplattenvorläufer gemäß irgendeinem der Ansprüche 1 bis 8, worin das Sternpolymer in einer Polymerkette hiervon eine Gruppe aufweist, die an eine Oberfläche des Trägers adsorbiert.

10. Negativer Lithografiedruckplattenvorläufer gemäß Anspruch 8 oder 9, worin das Sternpolymer eine vernetzbare Gruppe in dessen Polymerkette aufweist.

11. Negativer Lithografiedruckplattenvorläufer gemäß irgendeinem der Ansprüche 1 bis 10, der ferner eine Schutzschicht umfasst, so dass der Träger, die Bildaufzeichnungsschicht und die Schutzschicht in dieser Reihenfolge vorgesehen sind.

12. Negativer Lithografiedruckplattenvorläufer gemäß irgendeinem der Ansprüche 1 bis 11, der nach der Bildbelichtung mit Laser durch Zuführen von zumindest einem von Drucktinte und Anfeuchtwasser auf einer Druckmaschine, um einen nicht-belichteten Bereich der Bildaufzeichnungsschicht zu entfernen, zum Drucken befähigt ist.

13. Negativer Lithografiedruckplattenvorläufer gemäß irgendeinem der Ansprüche 1 bis 11, bei dem nach der Bildbelichtung mit Laser ein nicht-belichteter Bereich der Bildaufzeichnungsschicht mit einem Entwickler mit einem pH-Wert von 2 bis 14 entfernt werden kann.

14. Negativer Lithografiedruckplattenvorläufer gemäß Anspruch 11, bei dem nach der Bildbelichtung mit Laser die Schutzschicht und ein nicht-belichteter Bereich der Bildaufzeichnungsschicht mit einem Bad eines Entwicklers mit einem pH-Wert von 2 bis 14 entfernt werden können.

15. Plattenherstellungsverfahren für einen negativen Lithografiedruckplattenvorläufer, umfassend das bildweise Belichten des negativen Lithografiedruckplattenvorläufers gemäß Anspruch 12 mit Laser und Zuführen von zumindest einem von Drucktinte und Anfeuchtwasser zu dem belichteten negativen Lithografiedruckplattenvorläufer auf einer Druckmaschine, um einen nicht-belichteten Bereich der Bildaufzeichnungsschicht zu entfernen.

16. Plattenherstellungsverfahren für einen negativen Lithografiedruckplattenvorläufer, umfassend das bildweise Belichten des negativen Lithografiedruckplattenvorläufers gemäß Anspruch 13 mit Laser und Entfernen eines nicht-belichteten Bereich der Bildaufzeichnungsschicht mit einem Entwickler mit einem pH-Wert von 2 bis 14.

17. Plattenherstellungsverfahren für einen negativen Lithografiedruckplattenvorläufer, umfassend das bildweise Belichten des negativen Lithografiedruckplattenvorläufers gemäß Anspruch 14 mit Laser und Entfernen der Schutzschicht und eines nicht-belichteten Bereich der Bildaufzeichnungsschicht mit einem Bad eines Entwicklers mit einem pH-Wert von 2 bis 14.

## Revendications

1. Précurseur de plaque d'impression lithographique négative comprenant un support et une couche d'enregistrement d'image, où une couche contenant un polymère en étoile est prévue entre le support et la couche d'enregistrement d'image.

2. Précurseur de plaque d'impression lithographique négative tel que revendiqué dans la revendication 1, dans lequel la couche contenant un polymère en étoile est une sous-couche.

3. Précurseur de plaque d'impression lithographique négative tel que revendiqué dans la revendication 1, dans lequel la couche contenant un polymère en étoile est une couche formée par traitement d'hydrophilisation d'une surface du support.

4. Précurseur de plaque d'impression lithographique négative tel que revendiqué dans l'une quelconque des revendications 1 à 3, dans lequel la couche d'enregistrement d'image contient un initiateur de polymérisation et un composé polymérisable.

5. Précurseur de plaque d'impression lithographique négative tel que revendiqué dans l'une quelconque des revendications 1 à 4, dans lequel le polymère en étoile est un polymère dans lequel 3 à 10 chaînes polymères sont ramifiées à partir d'un squelette central.

6. Précurseur de plaque d'impression lithographique négative tel que revendiqué dans la revendication 5, dans lequel le polymère en étoile est un polymère dans lequel 3 à 10 chaînes polymères sont ramifiées à partir d'un squelette central par des liaisons sulfures respectivement.

7. Précurseur de plaque d'impression lithographique négative tel que revendiqué dans la revendication 6, dans lequel le polymère en étoile est un polymère dans lequel 3 à 10 chaînes polymères sont ramifiées à partir d'un squelette central par des liaisons sulfures respectivement et qui est obtenu par polymérisation d'un monomère à insaturation éthylénique en présence d'un thiol multifonctionnel.

8. Précurseur de plaque d'impression lithographique négative tel que revendiqué dans l'une quelconque des revendications 1 à 7, dans lequel le polymère en étoile a un groupe hydrophile dans une chaîne polymère de celui-ci.

9. Précurseur de plaque d'impression lithographique négative tel que revendiqué dans l'une quelconque des revendications 1 à 8, dans lequel le polymère en étoile a un groupe qui s'adsorbe à une surface du support dans une chaîne polymère de celui-ci.

10. Précurseur de plaque d'impression lithographique négative tel que revendiqué dans la revendication 8 ou 9, dans lequel le polymère en étoile a un groupe réticulable dans la chaîne polymère de celui-ci.

11. Précurseur de plaque d'impression lithographique négative tel que revendiqué dans l'une quelconque des revendications 1 à 10, qui comprend en outre une couche de protection de sorte que le support, la couche d'enregistrement d'image et la couche de protection soient prévues dans cet ordre.

12. Précurseur de plaque d'impression lithographique négative tel que revendiqué dans l'une quelconque des revendications 1 à 11, qui est capable d'imprimer, après une exposition d'image au laser, en fournissant au moins l'une parmi une encre d'impression et une eau de mouillage sur une machine d'impression pour retirer une zone non exposée de la couche d'enregistrement d'image.

13. Précurseur de plaque d'impression lithographique négative tel que revendiqué dans l'une quelconque des revendications 1 à 11, qui est capable de retirer, après l'exposition d'image au laser, une zone non exposée de la couche d'enregistrement d'image avec un révélateur ayant un pH allant de 2 à 14.

14. Précurseur de plaque d'impression lithographique négative tel que revendiqué dans la revendication 11, qui est capable de retirer, après l'exposition d'image au laser, la couche de protection et une zone non exposée de la couche d'enregistrement d'image avec un bain d'un révélateur ayant un pH allant de 2 à 14.

15. Procédé de fabrication de plaque d'un précurseur de plaque d'impression lithographique négative comprenant l'exposition en mode image du précurseur de plaque d'impression lithographique négative tel que revendiqué dans la revendication 12 au laser, et la fourniture d'au moins l'une parmi une encre d'impression et une eau de mouillage au précurseur de plaque d'impression lithographique négative exposé sur une machine d'impression pour retirer une zone non exposée de la couche d'enregistrement d'image.

16. Procédé de fabrication de plaque d'un précurseur de plaque d'impression lithographique négative comprenant l'exposition en mode image du précurseur de plaque d'impression lithographique négative tel que revendiqué dans la revendication 13 au laser et le retrait d'une zone non exposée de la couche d'enregistrement d'image avec un révélateur ayant un pH allant de 2 à 14.

17. Procédé de fabrication de plaque d'un précurseur de plaque d'impression lithographique négative comprenant l'exposition en mode image du précurseur de plaque d'impression lithographique négative tel que revendiqué dans la revendication 14 au laser et le retrait de la couche de protection et d'une zone non exposée de la couche d'enregistrement d'image avec un bain d'un révélateur ayant un pH allant de 2 à 14.
